# EUROPEAN PATENT SPECIFICATION

(11) **EP 1 275 676 B1**
(45) Date of publication and mention of the grant of the patent: **07.05.2008**
(21) Application number: 01919897.7
(22) Date of filing: 12.04.2001
(51) Int. Cl.: C08G 61/06, C08G 61/08, G03F 7/039

(54) **HYDROGENATED RING-OPENING METATHESIS COPOLYMER AND PROCESS FOR PRODUCING THE SAME**
HYDROGENIERTES, DURCH RINGÖFFNUNG ERHLATENES METATHESEPOLYMER UND VERFAHREN ZUR HERSTELLUNG
COPOLYMERE DE METATHESE A OUVERTURE DE CYCLE HYDROGENE ET PROCEDE DE PRODUCTION DE CE DERNIER

(30) Priority: 13.04.2000 JP 2000111646
(43) Date of publication of application: 15.01.2003
(73) Proprietor: Mitsui Chemicals, Inc., Tokyo (JP)
(72) Inventor: YAMAMOTO, Yoshihiro, c/o Mitsui Chemicals, Inc., Sodegaura-shi, Chiba 299-0265 (JP); SUNAGA, Tadahiro, c/o Mitsui Chemicals, Inc., Sodegaura-shi, Chiba 299-0265 (JP); HAMADA, Tetsuya, c/o Mitsui Chemicals, Inc., Sodegaura-shi, Chiba 299-0265 (JP); IKEDA, Keiichi, c/o Mitsui Chemicals, Inc., Sodegaura-shi, Chiba 299-0265 (JP); SHIBAHARA, Ritsuko, c/o Mitsui Chemicals, Inc., Sodegaura-shi, Chiba 299-0265 (JP); IO, Hirofumi, c/o Mitsui Chemicals, Inc., Sodegaura-shi, Chiba 299-0265 (JP); OCHIAI, Takashi, c/o Mitsui Chemicals, Inc., Sodegaura-shi, Chiba 299-0265 (JP)
(74) Representative: Strehl Schübel-Hopf & Partner
(86) International application number: PCT/JP2001/003139
(87) International publication number: WO 2001/079324

(56) References cited:
- DE-A- 19 900 977
- JP-A- 11 171 982
- JP-A- 11 327 144
- US-A- 4 028 482
- PATENT ABSTRACTS OF JAPAN vol. 1999, no. 10, 31 August 1999 (1999-08-31) & JP 11 130844 A (MITSUI CHEM INC), 18 May 1999 (1999-05-18)
- WATKINS N ET AL: "RING OPENING METATHESIS POLYMERIZATION OF CYCLIC ALKENES CONTAININGHETEROATOMS" 1 April 1994 (1994-04-01), MACROMOLECULAR CHEMISTRY AND PHYSICS, WILEY VCH, WEINHEIM, DE, PAGE(S) 1147-1164 , XP000439864 ISSN: 1022-1352 * page 1150 *

## Description

### TECHNICAL FIELD

The present invention relates to a novel hydrogenated ring-opening metathesis polymer and, more particularly, to a hydrogenated ring-opening metathesis polymer which is superior in heat resistance, pyrolysis resistance and light transmission properties and which is suited for use as a photoresist polymer for microlithography by ultraviolet and far ultraviolet lights (including excimer laser) in the production of semiconductor devices, and a method of producing the hydrogenated polymer.

### BACKGROUND ART

With the recent increase of integration level in integrated circuits on semiconductor devices, a large-scale integrated circuits (LSI) and very-large-scale integrated circuits (VLSI) have been put to practical use, and additionally, a minimum lithographic pattern in the integrated circuit would be reaching in submicron features, in future, it tends to be more microlithographic. In the formation of the microlithographic pattern, there is essentially required to use a lithographic technique coating a surface of a substrate with a resist material to form a thin film, selectively exposing the resulting resist film to light thereby to form a latent image of a desired pattern, developing the latent image to form a resist pattern, performing dry etching using this resist pattern as a mask, and then removing the resist to obtain a desired pattern.

As an exposure light source used in this lithographic technique, for example, ultraviolet lights of g-lines (wavelength: 436 nm) and i-lines (wavelength: 365 nm) are used. With the progress of the fine lithographic pattern, it has become popular to use an exposure light having a shorter wavelength such as far ultraviolet lights, vacuum ultraviolet lights, electron beam (EB), X-lights as the light source. As the light source, excimer laser (e.g. KrF laser having a wavelength of 248 nm, ArF laser having a wavelength of 193 nm, etc.) has attracted special interest recently and it is expected that the excimer laser is effective for formation of the fine lithographic pattern.

As a polymer or copolymer used as a resist material for formation of a sub-micron pattern using exposure light having a shorter wavelength within a vacuum ultraviolet region, for example, there have been suggested various polymers and copolymers, such as polymer or copolymer of an acrylic or α-substituted acrylic ester having an adamantane skeleton and an acid cleavable protecting group at an ester portion (see Japanese Patent Kokai Publication No. 39665/1992), polymer or copolymer of an acrylic or α-substituted acrylic ester having a norbornane skeleton and an acid cleavable protecting group at an ester portion (see Japanese Patent Kokai Publication No. 257281/1993), polymer or copolymer of cyclohexylmaleimide (see Japanese Patent Kokai Publication No. 257285/1993), polymer compound containing a cellulose skeleton in a principal chain, said principal chain being cleaved by an acid (see Japanese Patent Kokai Publication No. 342212/1994), polyvinyl alcohol or its derivative (see Japanese Patent Kokai Publication No. 333850/1995), and the like.

However, there have still not been obtained polymers and copolymers, which satisfy all of various properties required to be used as the polymer for the resist material, such as dry etching resistance, transparency to far ultraviolet lights, solubility in resist solvent, wettability by developer, adhesion to substrate such as silicon, solubility in releasant and the like, and a further development thereof is required.

On the other hand, cyclic polymers in photoresist compositions comprising a polymer compound having an aliphatic cyclic hydrocarbon as a main chain and containing pendant acid cleavable groups (WO97/33198, Japanese Patent Kokai Publication Nos. 230595/1997, 244247/1997 and 254139/1998) is superior in dry etching resistance and also superior in transparency to far ultraviolet lights. However, it had a problem that the solubility in resist solvent at high concentration, wettability by developer and adhesion to silicon substrate are inferior.

DE 199 00 977 discloses ring-opened polymers prepared by reacting a pericyclic olefin containing a lactone ring through ring-opening metathesis polymerization.

### DISCLOSURE OF THE INVENTION

An object of the present invention is to provide a hydrogenated ring-opening metathesis polymer which satisfies all of the above various properties required to be used as a base polymer for the resist material, more particularly, all of various properties required to be used as a base polymer for the resist material as a positive photoresist composition which is excellent in light transparency and the like, and has high sensitivity, high resolution and high affinity by an alkali developer, and provides an excellent pattern when it is used for microlithography by ultraviolet and far ultraviolet lights (including excimer laser) in the production of semiconductor devices, and which also has a narrow molecular weight distribution, and to provide a method of producing the hydrogenated polymer.

To solve the problems, the present inventors have studied intensively about a possibility of using a hydrogenated ring-opening metathesis polymer obtained from a cyclic olefin monomer or monomers as a base polymer for resist material having excellent optical characteristics, electrical characteristics, high rigidity, heat resistance, adhesion to substrate and weathering resistance. As a result, they have found that a novel hydrogenated ring-opening metathesis polymer having a specific structural unit, that is a structural unit comprising an alicyclic compound as a principle chain and contains an oxygen atom in a part of the cyclic structure, satisfies various performances as the resist material, thus completing the present invention.

Namely, the present invention provides a hydrogenated ring-opening metathesis polymer which comprises a structural unit [A] represented by the following general formula [1]: 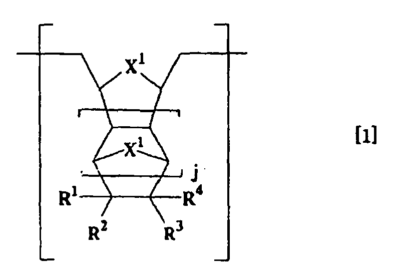 (wherein at least one of R¹ to R⁴ is a functional group having a tertiary ester group of a cyclic alkyl represented by the following general formula [2]: 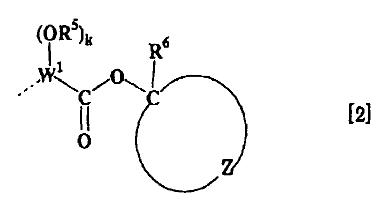 (wherein the dotted line is a bond, R⁵ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; R⁶ is a linear, branched or cyclic alkyl group having 1 to 10 carbon atoms; W¹ is a single bond or a (k+2)-valent hydrocarbon group having 1 to 10 carbon atoms; Z is a divalent hydrocarbon group having 2 to 15 carbon atoms and forms a single ring or a cross-linked ring together with the bonded carbon atoms; k is 0 or 1; and k is 0 in case W¹ is a single bond);
and the others of R¹ to R⁴ are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms; X¹ is -O- or -CR⁷₂- (R⁷ represents a hydrogen atom or a linear or branched alkyl group having 1 to 10 carbon atoms) and may be the same or different each other; and j is 0 or an integer of 1 to 3);
and at least one member selected from a structural unit [B] represented by the following general formula [3]: 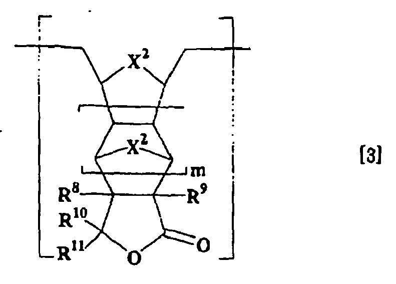 (wherein, R⁸ to R¹¹ are independently a hydrogen atom or a linear, branched or cyclic alkyl group having 1 to 10 carbon atoms; X² is -O- or -CR¹²₂- (R¹² represents a hydrogen atom or a linear or branched alkyl group having 1 to 10 carbon atoms) and may be the same or different each other; and m is 0 or an integer of 1 to 3),
and a structural unit [C] represented by the following general formula [4]: 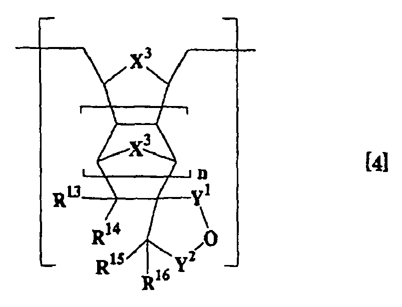 (wherein, R¹³ to R¹⁶ are independently a hydrogen atom or a linear, branched or cyclic alkyl group having 1 to 10 carbon atoms; X³ is -O- or -CR¹⁷₂- (R¹⁷ represents a hydrogen atom or a linear or branched alkyl group having 1 to 10 carbon atoms) and may be the same or different each other; one of Y¹ and Y² is -(C=O)-, and the other of Y¹ and Y² is -CR¹⁸₂- (R¹⁸ represents a hydrogen atom or a linear or branched alkyl group having 1 to 10 carbon atoms); and n is 0 or an integer of 1 to 3);
wherein at least one of X¹ in the structural unit [A] represented by the general formula [1], X² in the structural unit [B] represented by the general formula [3] and X³ in the structural unit [C] represented by the general formula [4] is -O-; and
wherein a constituent molar ratio of [A]/([B] and [C]) is from 20/80 to 99/1 and a ratio of a weight-average molecular weight Mw to a number average molecular weight Mn, that is Mw/Mn is from 1.0 to 2.0.

Further, the present invention provides a method of producing the hydrogenated ring-opening metathesis polymer of claim 1, which comprises
using a cyclic olefin monomer represented by the following general formula [9]: 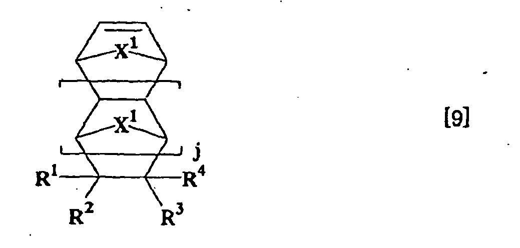 (wherein R¹ to R⁴, X¹ and j are as defined above),
and using at least one member selected from a cyclic olefin monomer represented by the following general formula [10]: 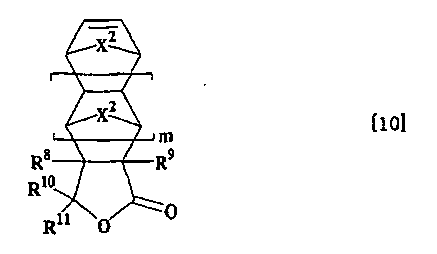 (wherein R⁸ to R¹¹, X² and m are as defined above),
and a cyclic olefin monomer represented by the following general formula [11]: 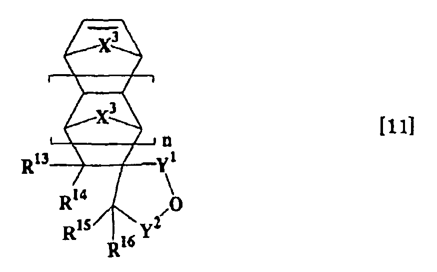 (wherein R¹³ to R¹⁶, X³ , Y¹, Y² and n are as defined above),
wherein at least one of X¹ in the general formula [9], X² in the general formula [10] and X³ in the general formula [11] is -O-; and
polymerizing these monomers by using a ring-opening metathesis catalyst, and hydrogenating the polymer in the presence of a hydrogenation catalyst, wherein the charging molar ratio of the cyclic olefin monomer represented by the general formula [9] to the cyclic olefin monomer represented by the general formula [10] and the cyclic olefin monomer represented by the formula [11] is from 20/80 to 99/1.

### BRIEF DESCRIPTION OF DRAWING

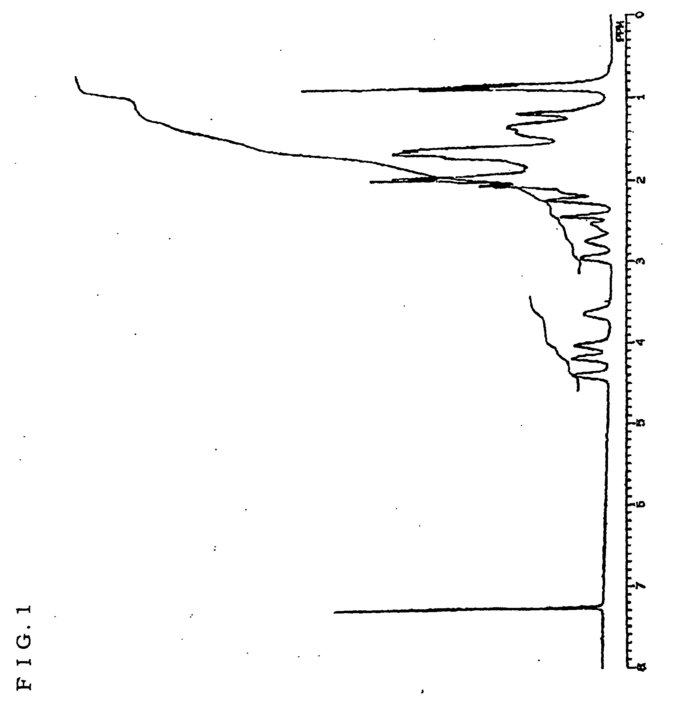

Fig. 1 shows a ¹H-NMR spectrum (270 MHz, solvent is deuterated chloroform) of a hydrogenated ring-opening metathesis polymer obtained in Example 1.

### BEST MODES FOR CARRYING OUT THE INVENTION

In the general formula [1] in the present invention, at least one of R¹ to R⁴ is a functional group having a tertiary ester group of a cyclic alkyl represented by the following general formula [2]: 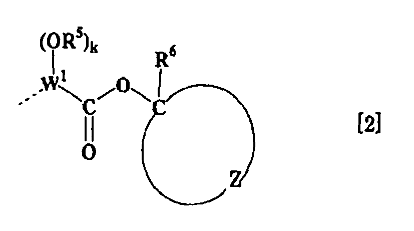 (wherein the dotted line is a bond, R⁵ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; R⁶ is a linear, branched or cyclic alkyl group having 1 to 10 carbon atoms; W¹ is a single bond or a (k+2)-valent hydrocarbon group having 1 to 10 carbon atoms; Z is a divalent hydrocarbon group having 2 to 15 carbon atoms and forms a single ring or a cross-linked ring together with the bonded carbon atoms; k is 0 or 1; and k is 0 in case W¹ is a single bond.

Regarding R⁵, examples of the linear, branched or cyclic alkyl group having 1 to 10 carbon atoms include methyl, ethyl, propyl, isopropyl, n-butyl, isobutyl, tert-butyl, cyclopentyl, cyclohexyl, 1-ethylcyclopentyl or 1-ethylcyclohexyl; examples of the linear, branched or cyclic alkoxyalkyl group having 2 to 10 carbon atoms include methoxymethyl, 1-ethoxyethyl, 1-tert-butoxyethyl, 1-cyclohexyloxyethyl, 1-ethoxypropyl, 1-ethoxy-1-methylethyl, tetrahydrofuran-2-yl or tetrahydropyran-2-yl; and examples of the linear, branched or cyclic acyl group having 1 to 10 carbon atoms include formyl, acetyl, pivaloyl or cyclohexylcarbonyl. Among these R⁵, a linear or branched alkyl group having 1 to 6 carbon atoms, a linear, branched or cyclic alkoxyalkyl group having 2 to 7 carbon atoms and a linear or branched acyl group having 2 to 7 carbon atoms are preferable. Particularly, a hydrogen atom, methyl, ethyl, methoxymethyl, 1-ethoxyethyl, tetrahydrofuran-2-yl and acetyl are preferable.

Regarding R⁶, examples of the linear, branched or cyclic alkyl group having 1 to 10 carbon atoms include methyl, ethyl, propyl, isopropyl, n-butyl, isobutyl, tert-butyl, cyclopentyl, cyclohexyl, cyclooctyl, norbornyl, 1-methylcyclopentyl, 1-ethylcyclopentyl, 1-methylcyclohexyl, 1-ethylcyclohexyl, 1-methylnorbornyl or 1-ethylnorbornyl. Among them, methyl, ethyl, propyl, isopropyl, n-butyl, isobutyl, tert-butyl, cyclopentyl, cyclohexyl, norbornyl, 1-ethylcyclopentyl and 1-ethylcyclohexyl are preferable.

Regarding W¹, the (k+2)-valent hydrocarbon group having 1 to 10 carbon atoms is a linear, branched or cyclic divalent hydrocarbon group having 1 to 10 carbon atoms, and examples thereof include methylene, dimethylmethylene, ethylidene, propylidene, butylidene, ethylene, 1-methylethylene, 2-methylethylene, 1-ethylethylene, 2-ethylethylene, 1,1-dimethylethylene, 1,2-dimethylethylene, 2,2-dimethylethylene, 1-ethyl-2-methylethylene, trimethylene, 1-methyltrimethylene, 2-methyltrimethylene, 3-methyltrimethylene, tetramethylene, pentamethylene, 1,1-cyclopentylene, 1,2-cyclopentylene, 1,3-cyclopentylene, 1,1-cyclohexylene, 1,2-cyclohexylene or 1,3-cyclohexylene, 1,4-cyclohexylene. Among them, methylene, ethylidene, ethylene, 1-methylethylene, 2-methylethylene, trimethylene and 2-methyltrimethylene are preferable. The above examples include hydrocarbon groups obtained by removing a hydrogen atom at any portion of the hydrocarbon groups listed above to form a bond. The most preferable one of W¹ is a single bond.

Z represents a divalent hydrocarbon group having 2 to 15 carbon atoms, and forms a single ring or a cross-linked ring together with the bonded carbon atoms. For example, 1-alkylcycloalkyl groups represented by the following general formula [13]: 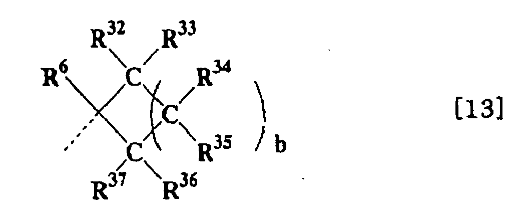 (wherein the dotted line is a bond; R⁶ is as define above; R³² to R³⁷ are independently a hydrogen atom, or a linear, branched or cyclic alkyl group having 1 to 10 carbon atoms; b is 0 or an integer of 1 to 6; and when b is 2 to 6, a plurality of R³⁴ and R³⁵ may be the same or different, respectively);
2-alkylnorbornyl groups represented by the following general formula [14]: 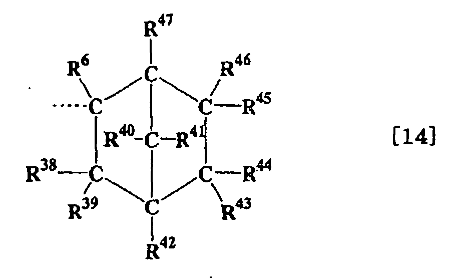 (wherein the dotted line is a bond; R⁶ is as define above; R³⁸ to R⁴⁷ are independently a hydrogen atom, or a linear, branched or cyclic alkyl group having 1 to 10 carbon atoms);
and 2-alkyl-2-adamantyl groups such as 2-methyl-2-adamantyl and 2-ethyl-2-adamantyl are listed. Specific examples of the general formula [13] include 1-methylcyclopropyl, 1-methylcyclobutyl, 1-ethylcyclobutyl, 1-methylcyclopentyl, 1-ethylcyclopentyl, 1-n-propylcyclopentyl, 1-iso-propylcyclopentyl, 1-tert-butylcyclopentyl, 1-cyclopentylcyclopentyl, 1-cyclohexylcyclopentyl, 1-norbornylcyclopentyl, 1-methylcyclohexyl, 1-ethylcyclohexyl, 1-methylcycloheptyl, 1-ethylcycloheptyl, 1-methylcyclooctyl or 1-methylcyclononyl. Among them, 1-alkylcyclopentyls represented by the chemical formula [15]: 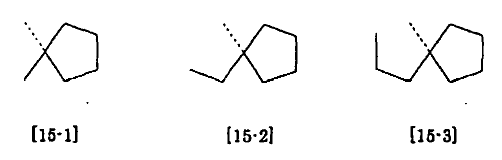 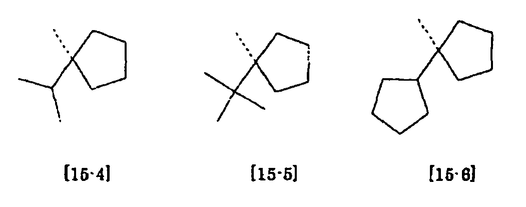 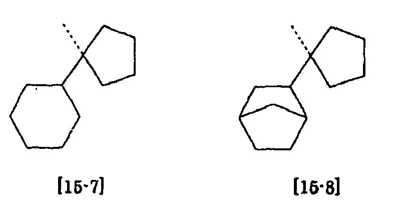 such as 1-methylcyclopentyl, 1-ethylcyclopentyl, 1-n-propylcyclopentyl, 1-iso-propylcyclopentyl, 1-tert-butylcyclopentyl, 1-cyclopentylcyclopentyl, 1-cyclohexylcyclopentyl and 1-norbornylcyclopentyl are preferable. 1-methylcyclopentyl [15-1] and 1-ethylcyclopentyl [15-2] are more preferable. As the specific example of the general formula [14], 2-alkylnorbornyl groups represented by the chemical formula [16]: 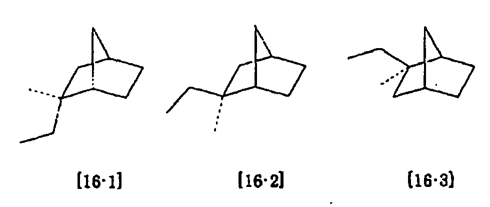 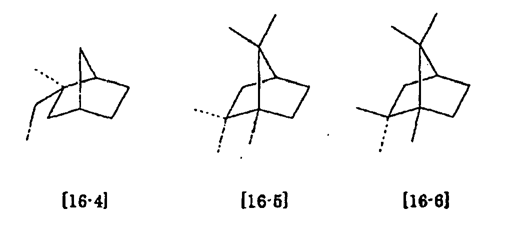 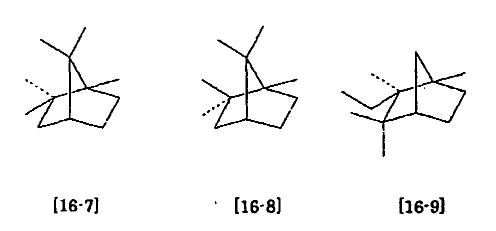 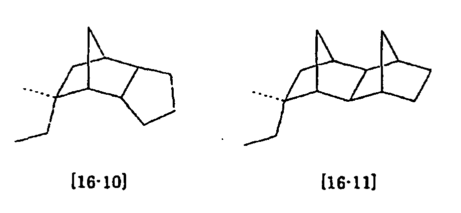 are listed. Among them, the groups [16-1], [16-2], [16-3] and [16-4] are preferable.

Regarding the other groups of R¹ to R⁴, a hydrogen atom, a linear, branched or cyclic alkyl group having 1 to 20 carbon atoms such as methyl, ethyl, propyl, isopropyl, n-butyl, tert-butyl, cyclohexyl or menthyl; a halogen such as a chlorine atom, bromine atom, iodine atom or fluorine atom; a linear, branched or cyclic halogenated alkyl group having 1 to 20 carbon atoms such as fluoromethyl, chloromethyl, bromomethyl, difluoromethyl, dichloromethyl, dibromomethyl, trifluoromethyl, trichloromethyl or tribromomethyl; a linear, branched or cyclic alkoxy group having 1 to 12 carbon atoms such as methoxy, ethoxy, isopropoxy, n-butoxy or tert-butoxy, menthoxy; a linear, branched or cyclic alkoxyalkyl group having 2 to 20 carbon atoms such as methoxymethyl, methoxyethyl, tert-butoxymethyl, tert-butoxyethyl, methoxymenthol, or alkoxy saccharides such as methylglucose; linear, branched or cyclic alkylcarbonyloxy group having 2 to 20 carbon atoms such as acetoxy; an arylcarbonyloxy group having 6 to 20 carbon atoms such as naphthoyloxy; an alkylsulfonyloxy group having 1 to 20 carbon atoms such as mesyloxy; an arylsulfonyloxy group having 6 to 20 carbon atoms such as tosyloxy; a linear, branched or cyclic alkoxycarbonyl group having 2 to 20 carbon atoms such as methoxycarbonyl, ethoxycarbonyl, n-propoxycarbonyl, isopropoxycarbonyl, n-butoxycarbonyl, tert-butoxycarbonyl or cyclohexyloxycarbonyl; a linear, branched or cyclic alkoxycarbonylalkyl group having 3 to 20 carbon atoms such as methoxycarbonylmethyl, 2-(methoxycarbonyl)ethyl, 1-(methoxycarbonyl)ethyl, ethoxycarbonylmethyl, 2-(ethoxycarbonyl)ethyl, n-propoxycarbonylmethyl, isopropoxycarbonylmethyl, n-butoxycarbonylmethyl, tert-butoxycarbonylmethyl or cyclohexyloxycarbonylmethyl; are each independently listed as specific examples thereof. Among them, a hydrogen atom, a linear, branched or cyclic alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkoxycarbonyl group having 2 to 20 carbon atoms and a linear, branched or cyclic alkoxycarbonylalkyl group having 3 to 20 carbon atoms are preferable, and a hydrogen atom, a linear or branched alkyl group having 1 to 10 carbon atoms, a linear or branched alkoxycarbonyl group having 2 to 10 carbon atoms and a linear or branched alkoxycarbonylalkyl group having 3 to 10 carbon are more preferable.

X¹ is -O- or -CR⁷₂- (R⁷ represents a hydrogen atom or a linear or branched alkyl group having 1 to 10 carbon atoms), and when j is 1 to 3, X¹ may be the same or different. Specific examples of R⁷ include a hydrogen atom, and a linear or branched alkyl group having 1 to 10 carbon atoms such as methyl, ethyl, n-propyl, isopropyl, n-butyl or tert-butyl. X¹ represents preferably -O- or -CH₂-, and more preferably, all of X¹ are either -O- or -CH₂-. j is preferably 0 or 1.

Namely, as the specific examples of the general formula [1], structural units [A] of the following chemical formula [17]: 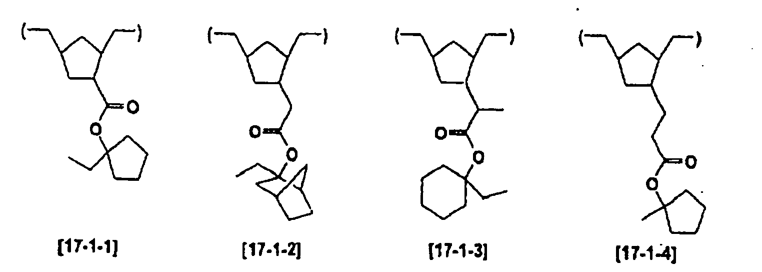 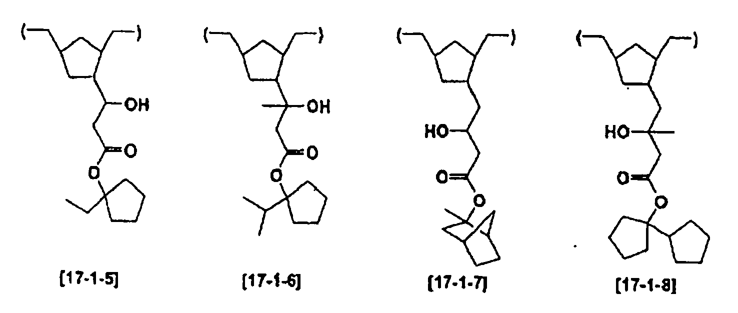 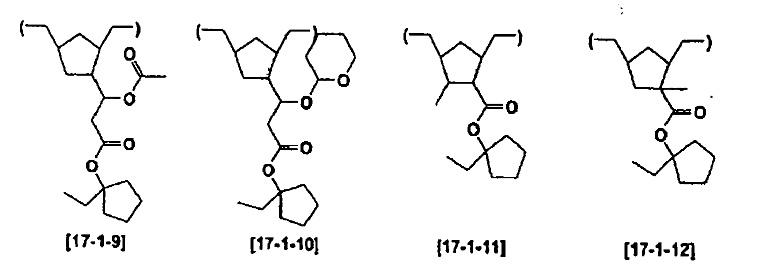 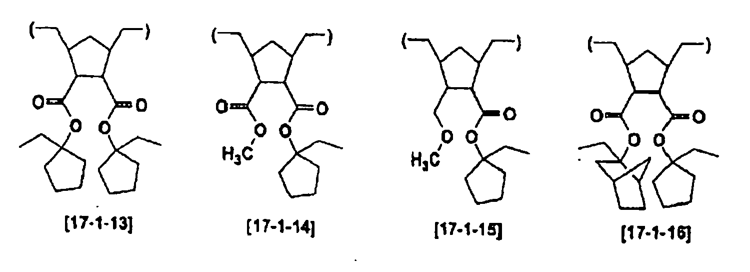 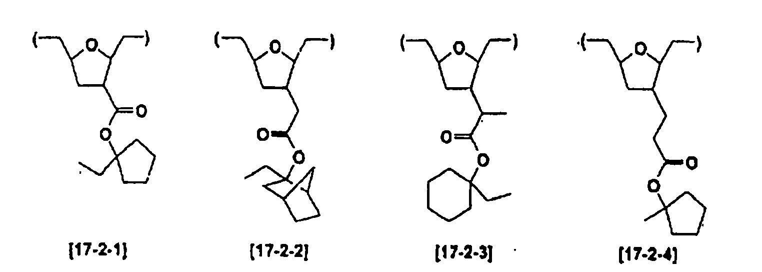 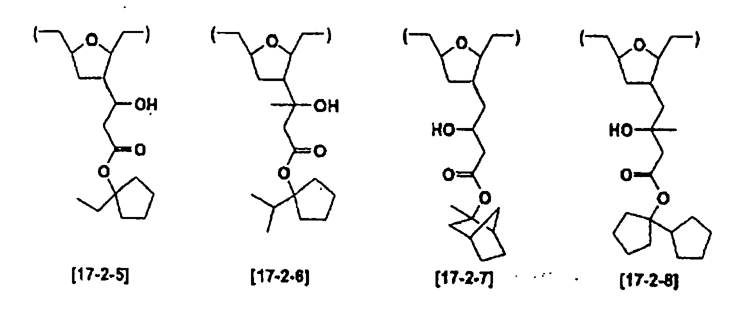 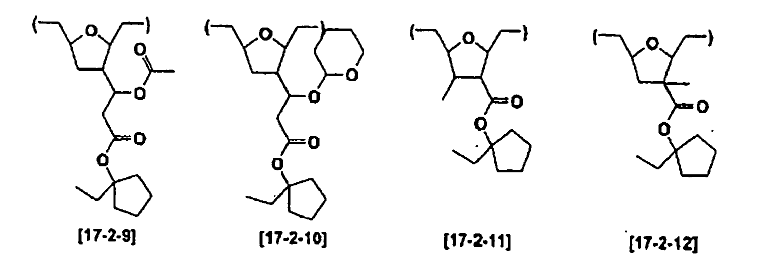 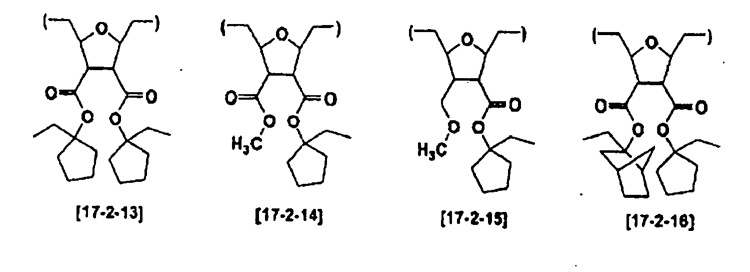 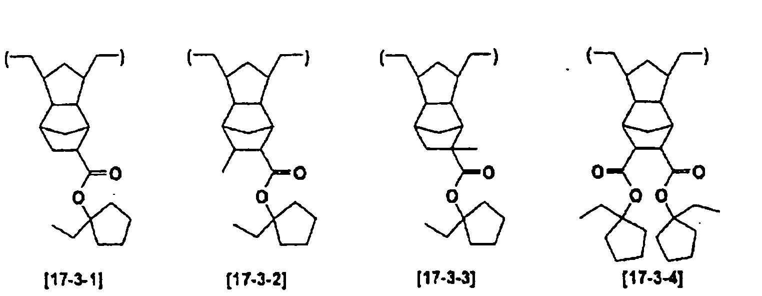 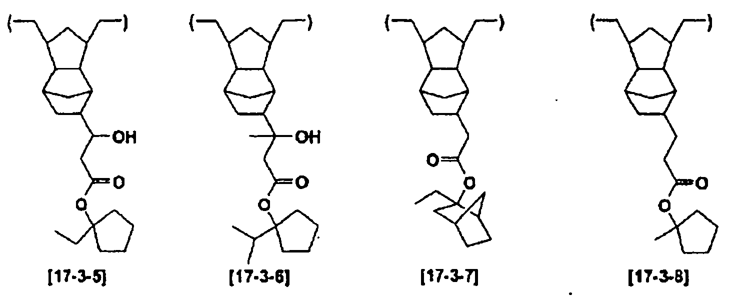 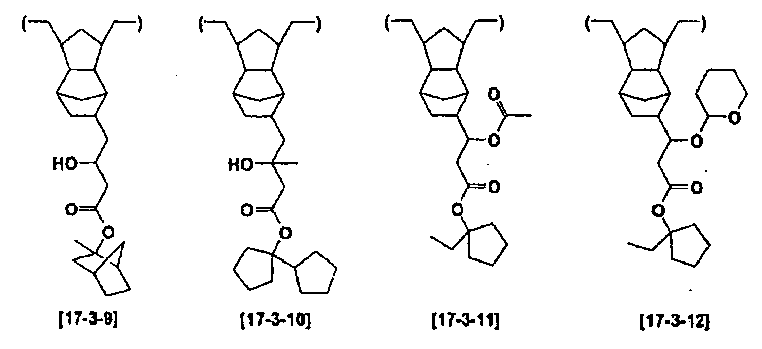 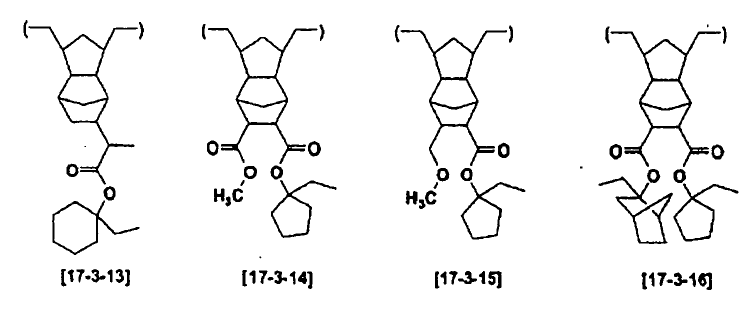 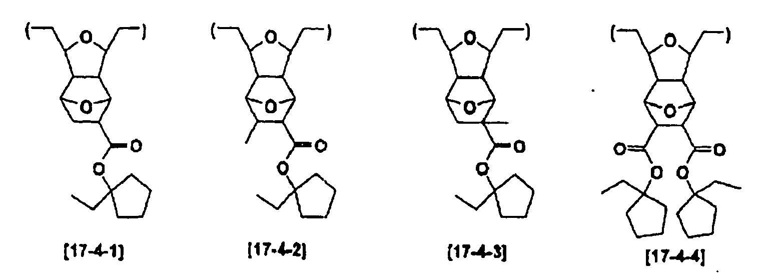 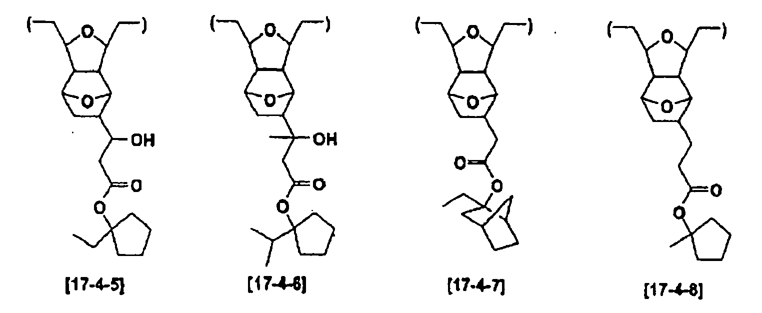 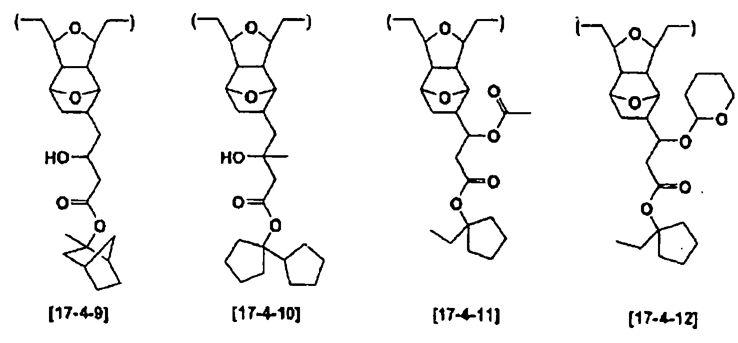 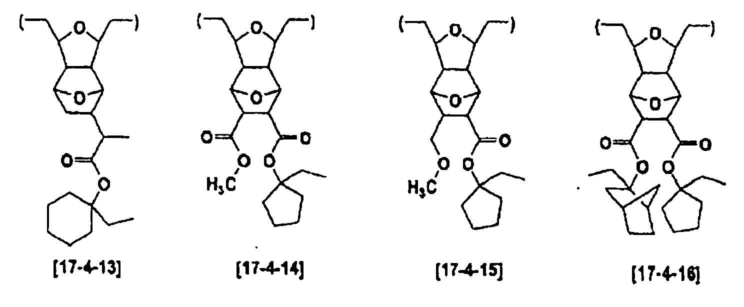 are listed.

In the general formula [3], specific examples of R⁸ to R¹¹ each independently include a hydrogen atom, and a linear, branched or cyclic alkyl group having 1 to 10 carbon atoms such as methyl, ethyl, n-propyl, isopropyl, n-butyl, tert-butyl, cyclohexyl or menthyl. X² is -O- or -CR¹²₂- (R¹² represents a hydrogen atom or a linear or branched alkyl group having 1 to 10 carbon atoms), and when m is 1 to 3, X² may be the same or different. Specific examples of R¹² include a hydrogen atom, and a linear or branched alkyl group having 1 to 10 carbon atoms such as methyl, ethyl, n-propyl, isopropyl, n-butyl or tert-butyl. X² represents preferably -O- or -CH₂-, and more preferably, all of X² are either -O- or -CH₂-. m is preferably 0 or 1.

Namely, as the specific examples of the general formula [3], structural units [B] of the following chemical formula [18]: 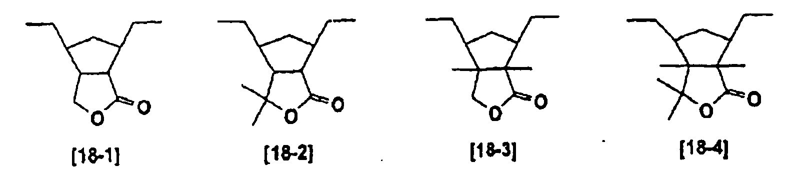 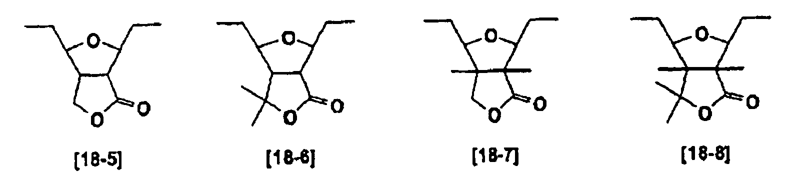 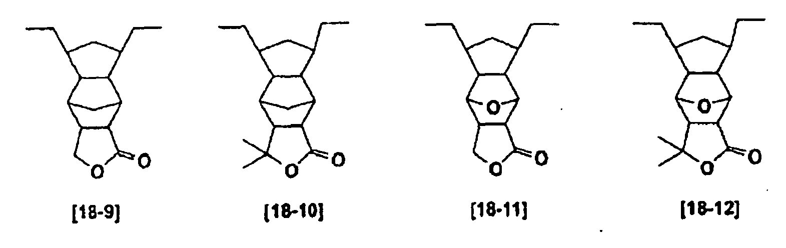 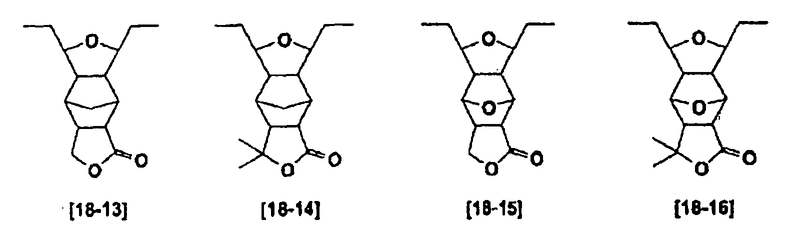 are listed.

In the general formula [4], specific examples of R¹³ to R¹⁶ each independently include a hydrogen atom, and a linear, branched or cyclic alkyl group having 1 to 10 carbon atoms such as methyl, ethyl, n-propyl, isopropyl, n-butyl, tert-butyl, cyclohexyl or menthyl. X³ represents -O- or -CR¹⁷₂- (R¹⁷ represents a hydrogen atom or a linear or branched alkyl group having 1 to 10 carbon atoms), and when m is 1 to 3, X³ may be the same or different. Specific examples of R¹⁷ include a hydrogen atom, and a linear or branched alkyl group having 1 to 10 carbon atoms such as methyl, ethyl, n-propyl, isopropyl, n-butyl or tert-butyl. X³ represents preferably -O- or - CH₂-, and more preferably, all of X³ are either -O- or - CH₂-. One of Y¹ and Y² represents -(C=O)- and the other of Y¹ and Y² represents -CR¹⁸₂- (R¹⁸ represents a hydrogen atom or a linear or branched alkyl group having 1 to 10 carbon atoms). Specific examples of R¹⁸ include a hydrogen atom, and a linear or branched alkyl group having 1 to 10 carbon atoms such as methyl, ethyl, n-propyl, isopropyl, n-butyl or tert-butyl. Preferably, one of Y¹ and Y² represents -(C=O)- and the other of Y¹ and Y² represents - CH₂-. n represents preferably 0 or 1.

Namely, as the specific examples of the general formula [4], structural units [C] represented by the following chemical formula [19]: 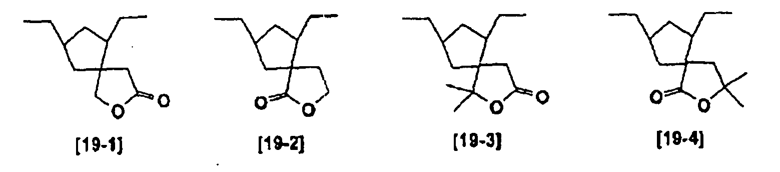 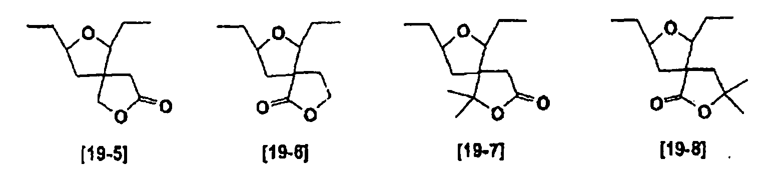 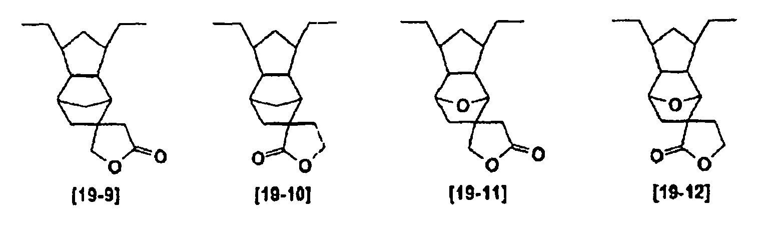 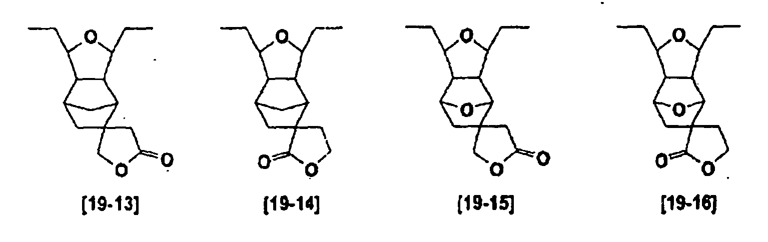 are listed.

The hydrogenated ring-opening metathesis polymer of the present invention is a hydrogenated ring-opening metathesis polymer in which at least one of X¹ in the structural unit [A] represented by the general formula [1], X² in the structural unit [B] represented by the general formula [3] and X³ in the structural unit [C] represented by the general formula [4] represents -O-. The presence of an oxygen atom in the alicyclic compound as main chain effects to improve adhesion to substrate such as a silicon substrate and wet tension in development by an alkali aqueous solution, and further improve solubility to polar organic solvents such as ketones, alcohols and the like used in a process of coating a resist onto a silicon wafer, and also improve affinity to water and developing property by a releasing agent (or developer) such as an alkali aqueous solution after exposure. Preferably, a hydrogenated ring-opening metathesis polymer in which at least one of X¹ in the structural unit [A] represented by the general formula [1], X² in the structural unit [B] represented by the general formula [3] and X³ in the structural unit [C] represented by the general formula [4] is -O-, and the others are -CH₂- is used. The molar amount of -O- unit based on the total molar amounts of X¹, X² and X³ units is from 0.01 to 0.99, preferably from 0.02 to 0.95, more preferably from 0.05 to 0.80, most preferably from 0.10 to 0.70.

In the present invention, the molar ratio of the structural unit [A] represented by the general formula [1] to the structural unit [B] represented by the general formula [3] and/or the structural unit [C] represented by the general formula [4], that is [A]/([B] and [C]) is from 20/80 to 99/1. It is essential that at least the structural unit [B] and/or [C] is present at certain amount. Here, the structural unit [A] contains a tertiary ester group of a cyclic alkyl represented by the general formula [2], namely, a group which is decomposed with the action of an acid generated from a sensitizer in exposure to produce a carboxylic acid, and it is necessary for making a resist pattern by developing with an alkali aqueous solution after exposure. Further, the structural unit [B] and/or [C] is necessary for manifesting adhesion with a treating substrate such as a silicon substrate. When the molar ratio [A]/([B] and [C]) is less than 20/80, development may be insufficient. When over 99/1, adhesion to a treating substrate is not manifested. More preferably, the molar ratio [A]/([B] and [C]) is from 20/80 to 95/5, particularly preferably from 25/75 to 90/10, most preferably from 30/70 to 85/15. The molar ratio of these structural units within this range is suitable for preparing a resist composition. And it is extremely important for a resist material which is dissolved in a polar solvent such as 2-heptanone together with a sensitizer having high polarity, and which is coated on a treating substrate such as a silicon substrate. Namely, the hydrogenated ring-opening metathesis polymer effects to improve solubility or dissolution speed in a polar solvent when a resist composition is prepared, and it results in forming a uniform and smooth coating film.

In the hydrogenated ring-opening metathesis polymer of the present invention, at least one of the structural units [B] and [C] is necessary. It can be a ternary copolymer constituted of the structural units [B] and [C] in addition to the structural unit [A], however, a binary copolymer comprising only one of the structural units [B] and [C] is preferable.

In the hydrogenated ring-opening metathesis polymer of the present invention, the ratio of the weight-average molecular weight Mw to the number-average molecular weight Mn (Mw/Mn) is restricted within a narrow molecular weight distribution from 1.0 to 2.0. The molecular weight distribution significantly effects the resolution when used as a resist material, and a higher resolution pattern can be obtained when the molecular weight distribution is narrower. The molecular weight distribution is preferably from 1.0 to 1.8, more preferably from 1.0 to 1.6. The hydrogenated ring-opening metathesis polymer of the present invention usually has a number-average molecular weight Mn from 500 to 200,000, preferably from 1,000 to 100,000, more preferably from 3,000 to 50,000. The number-average molecular weight and the weight-average molecular weight described in the instant specification were measured by gel permeation chromatography (GPC) as polystyrene standard.

Further, these hydrogenated ring-opening metathesis polymers may be composed of each one structural unit of [A], [B] and/or [C], or two or more structural units of any of or all of [A], [B] and/or [C]. There are exemplified hydrogenated ring-opening metathesis polymers in which the structural unit [A] is composed of structural units [A-1] and [A-2] of the following general formulae [1-1] and [1-2], respectively, 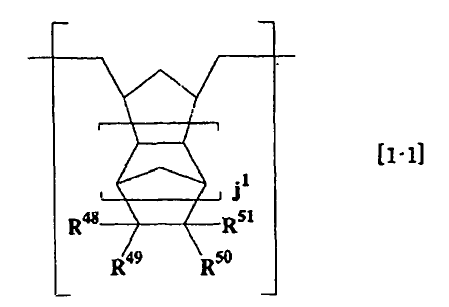 (wherein at least one of R⁴⁸ to R⁵¹ is a functional group having a tertiary ester group of a cyclic alkyl represented by the general formula [2], and the others of R⁴⁸ to R⁵¹ are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms, and j¹ is 0 or an integer of 1 to 3) 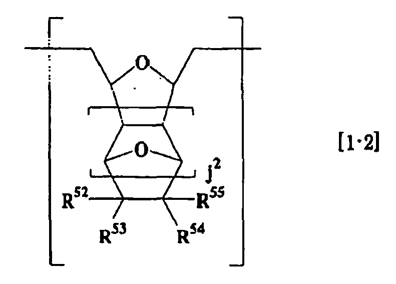 (wherein at least one of R⁵² to R⁵⁵ is a functional group having a tertiary ester group of a cyclic alkyl represented by the general formula [2], and the others of R⁵² to R⁵⁵ are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms, and j² is 0 or an integer of 1 to 3),
the structural unit [B] is composed of structural units [B-1] and [B-2] represented by the following general formulae [3-1] and [3-2], respectively, 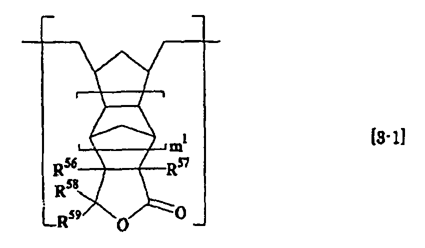 (wherein R⁵⁶ to R⁵⁹ are independently a hydrogen atom or a linear, branched or cyclic alkyl group having 1 to 10 carbon atoms, and m² is 0 or an integer of 1 to 3) 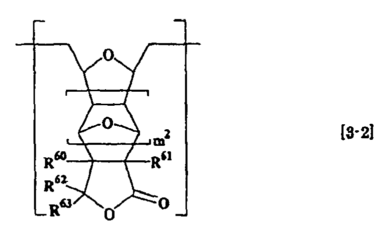 (wherein R⁶⁰ to R⁶³ are independently a hydrogen atom or a linear, branched or cyclic alkyl group having 1 to 10 carbon atoms, and m² is 0 or an integer of 1 to 3),
and/or, the structural unit [C] is composed of structural units [C-1] and [C-2] represented by the following general formulae [4-1] and [4-2], respectively, 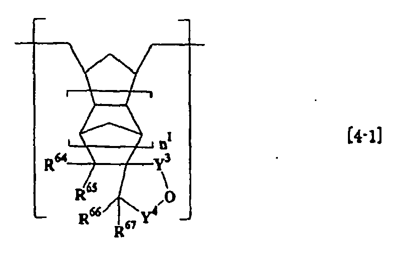 (wherein R⁶⁴ to R⁶⁷ are independently a hydrogen atom or a linear, branched or cyclic alkyl group having 1 to 10 carbon atoms, one of Y³ and Y⁴ is -(C=O)- and the other of Y³ and Y⁴ is -CH₂-, and n¹ is 0 or an integer of 1 to 3) 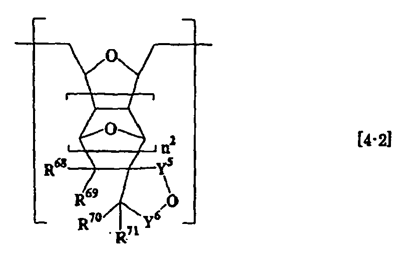 (wherein R⁶⁸ to R⁷¹ are independently a hydrogen atom or a linear, branched or cyclic alkyl group having 1 to 10 carbon atoms, one of Y⁵ and Y⁶ is -(C=O)- and the other of Y⁵ and Y⁶ is -CH₂-, and n² is 0 or an integer of 1 to 3).

It is preferable that the hydrogenated ring-opening metathesis copolymer of the present invention has a structural unit [D] represented by the following general formula [5] as a further structural unit in addition to the structural units [A] and [B] and/or [C], for further improving adhesion to a substrate and affinity to a developer. 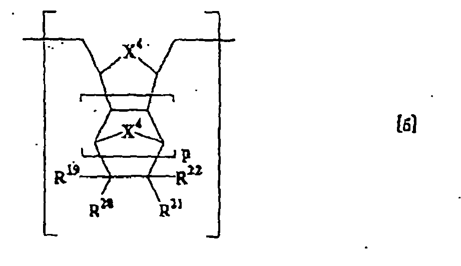 (wherein at least one of R¹⁹ to R²² is a functional group having a carboxyl group represented by the following general formula [6]: 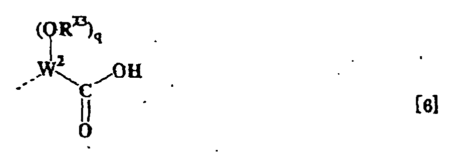 (wherein the dotted line is a bond; R²³is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; W² is a single bond or a (q+2)-valent hydrocarbon group having 1 to 10 carbon atoms; and q is 0 or 1),
and the others of R¹⁹ to R²² are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms; a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms; X⁴ is -O- or -CR²⁴₂- (R²⁴ represents a hydrogen atom or a linear or branched alkyl group having 1 to 10 carbon atoms) and may be the same or different each other; p is 0 or an integer of 1 to 3).

In the general formula [5] in the present invention, at least one of R¹⁹ to R²² is a functional group having a carboxyl group represented by the general formula [6] (wherein the dotted line is a bond; R²³ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; W² is a single bond or a (q+2)-valent hydrocarbon group having 1 to 10 carbon atoms; q is 0 or 1; and q is 0 when W² is a single bond.

Regarding R²³, examples of the linear, branched or cyclic alkyl group having 1 to 10 carbon atoms include methyl, ethyl, propyl, isopropyl, n-butyl, isobutyl, tert-butyl, cyclopentyl, cyclohexyl, 1-ethylcyclopenty or 1-ethylcyclohexyl; examples of the linear, branched or cyclic alkoxyalkyl group having 2 to 10 carbon atoms include methoxymethyl, 1-ethoxyethyl, 1-tert-butoxyethyl, 1-cyclohexyloxyethyl, 1-ethoxypropyl, 1-ethoxy-1-methyl-ethyl, tetrahydrofuran-2-yl or tetrahydropyran-2-yl; and examples of the linear, branched or cyclic acyl group having 1 to 10 carbon atoms include formyl, acetyl, pivaloyl or cyclohexylcarbonyl. Among these groups R²³, a linear or branched alkyl group having 1 to 6 carbon atoms, a linear, branched or cyclic alkoxyalkyl group having 2 to 7 carbon atoms and a linear or branched acyl group having 2 to 7 carbon atoms are preferable, and particularly, a hydrogen atom, methyl, ethyl, methoxymethyl, 1-ethoxyethyl, tetrahydrofuran-2-yl and acetyl are preferable.

Regarding W², the (q+2)-valent hydrocarbon group having 1 to 10 carbon atoms is a linear, branched or cyclic divalent hydrocarbon group having 1 to 10 carbon atoms, and examples thereof include methylene, dimethylmethylene, ethylidene, propylidene, butylidene, ethylene, 1-methylethylene, 2-methylethylene, 1-ethylethylene, 2-ethylethylene, 1,1-dimethylethylene, 1,2-dimethylethylene, 2,2-dimethylethylene, 1-ethyl-2-methylethylene, trimethylene, 1-methyltrimethylene, 2-methyltrimethylene, 3-methyltrimethylene, tetramethylene, pentamethylene, 1,1-cyclopentylene, 1,2-cyclopentylene, 1,3-cyclopentylene, 1,1-cyclohexylene, 1,2-cyclohexylene, 1,3-cyclohexylene or 1,4-cyclohexylene. Among them, methylene, ethylidene, ethylene, 1-methylethylene, 2-methylethylene, trimethylene and 2-methyltrimethylene are preferable. The above examples include hydrocarbon groups obtained by removing a hydrogen atom at any portion of hydrocarbon groups listed above to form a bond. The most preferable one of W² is a single bond.

Regarding the other groups of R¹⁹ to R²², independently, a hydrogen atom, a linear, branched or cyclic alkyl group having 1 to 20 carbon atoms such as methyl, ethyl, propyl, isopropyl, n-butyl, tert-butyl, cyclohexyl or menthyl; a halogen such as a chlorine atom, bromine atom, iodine atom or fluorine atom; linear, branched or cyclic halogenated alkyl group having 1 to 20 carbon atoms such as fluoromethyl, chloromethyl, bromomethyl, difluoromethyl, dichloromethyl, dibromomethyl, trifluoromethyl, trichloromethyl or tribromomethyl; a linear, branched or cyclic alkoxy group having 1 to 12 carbon atoms such as methoxy, ethoxy, isopropoxy, n-butoxy, tert-butoxy or menthoxy; a linear, branched or cyclic alkoxyalkyl group having 2 to 20 carbon atoms such as methoxymethyl, methoxyethyl, tert-butoxymethyl, tert-butoxyethyl, methoxymenthol, or alkoxy saccharides such as methylglucose; a linear, branched or cyclic alkylcarbonyloxy group having 2 to 20 carbon atoms such as acetoxy; an arylcarbonyloxy group having 6 to 20 carbon atoms such as naphthoyloxy; an alkylsulfonyloxy group having 1 to 20 carbon atoms such as mesyloxy; an arylsulfonyloxy group having 6 to 20 carbon atoms such as tosyloxy; a linear, branched or cyclic alkoxycarbonyl group having 2 to 20 carbon atoms such as methoxycarbonyl, ethoxycarbonyl, n-propoxycarbonyl, isopropoxycarbonyl, n-butoxycarbonyl, tert-butoxycarbonyl or cyclohexyloxycarbonyl; a linear, branched or cyclic alkoxycarbonylalkyl group having 3 to 20 carbon atoms such as methoxycarbonylmethyl, 2-(methoxycarbonyl)ethyl, 1-(methoxycarbonyl)ethyl, ethoxycarbonylmethyl, 2-(ethoxycarbonyl)-ethyl, n-propoxycarbonylmethyl, isopropoxycarbonylmethyl, n-butoxycarbonylmethyl, tert-butoxycarbonylmethyl or cyclohexyloxycarbonylmethyl; are each independently listed as specific examples thereof. Among them, a hydrogen atom, a linear, branched or cyclic alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkoxycarbonyl group having 2 to 20 carbon atoms and a linear, branched or cyclic alkoxycarbonylalkyl group having 3 to 20 carbon atoms are preferable; and a hydrogen atom, a linear or branched alkyl group having 1 to 10 carbon atoms, a linear or branched alkoxycarbonyl group having 2 to 10 carbon atoms and a linear or branched alkoxycarbonylalkyl group having 3 to 10 carbon are more preferable.

X⁴ is -O- or -CR²⁴₂- (R²⁴ represents a hydrogen atom or a linear or branched alkyl group having 1 to 10 carbon atoms), and when p is 1 to 3, X⁴ may be the same or different. Specific examples of R²⁴ include a hydrogen atom, and a linear or branched alkyl group having 1 to 10 carbon atoms such as methyl, ethyl, n-propyl, isopropyl, n-butyl or tert-butyl. X⁴ represents preferably -O- or - CH₂-, and more preferably, all of X⁴ are either -O- or - CH₂-. p is preferably 0 or 1.

Namely, as the specific examples of the general formula [5], structural units [D] represented by the following chemical formula [20]: 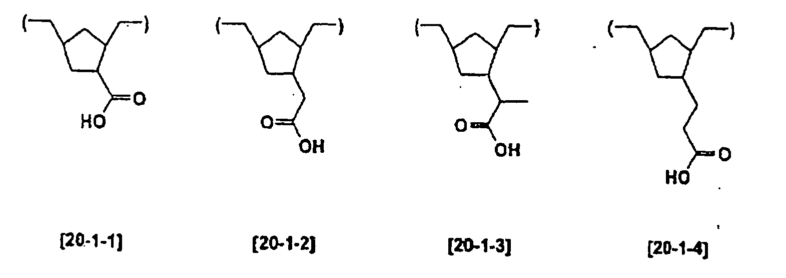 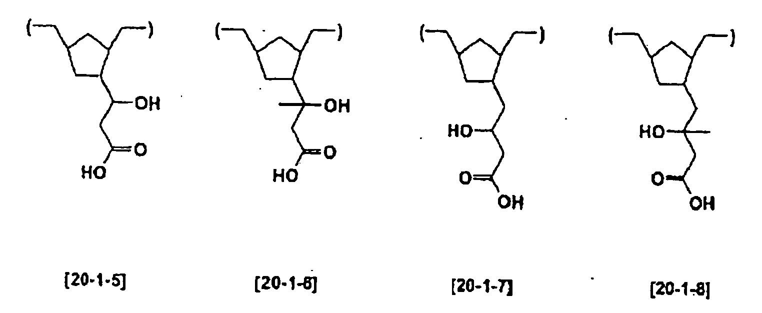 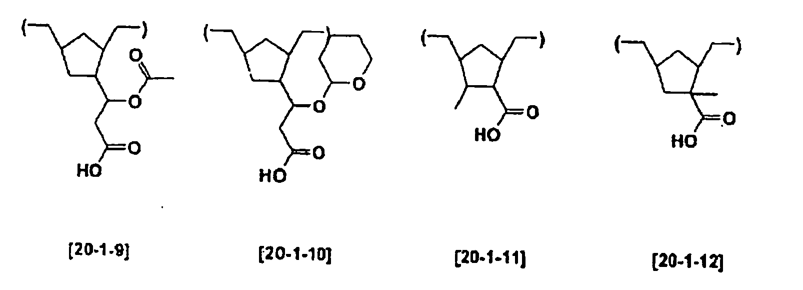 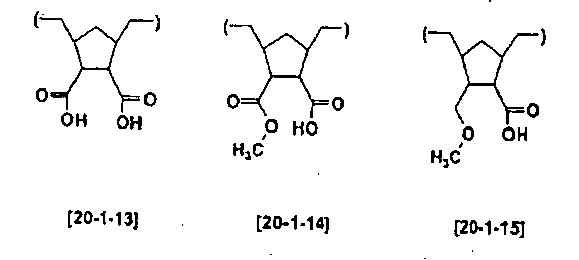 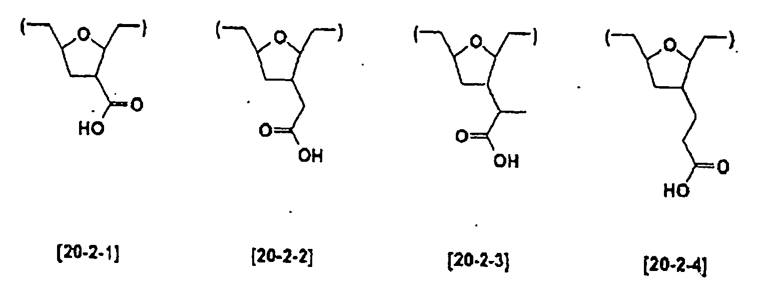 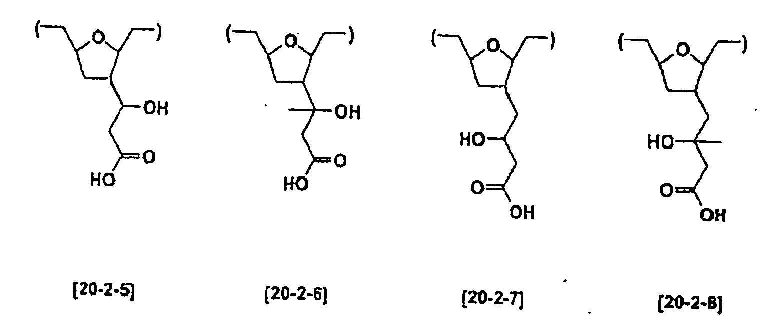 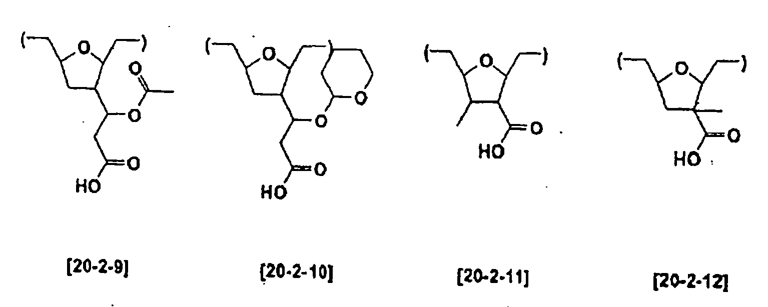 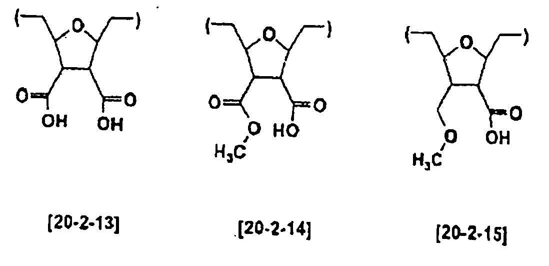 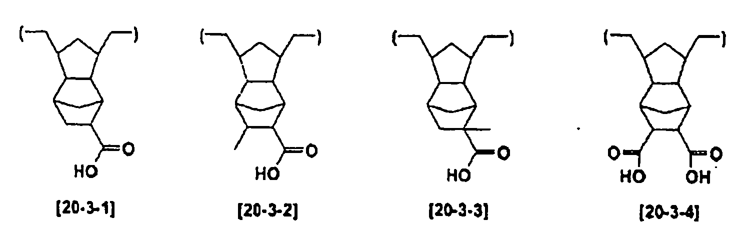 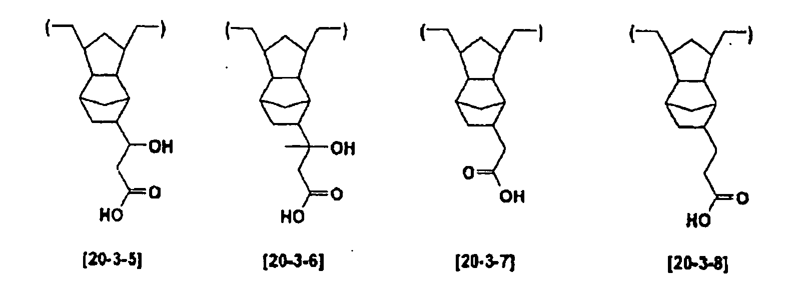 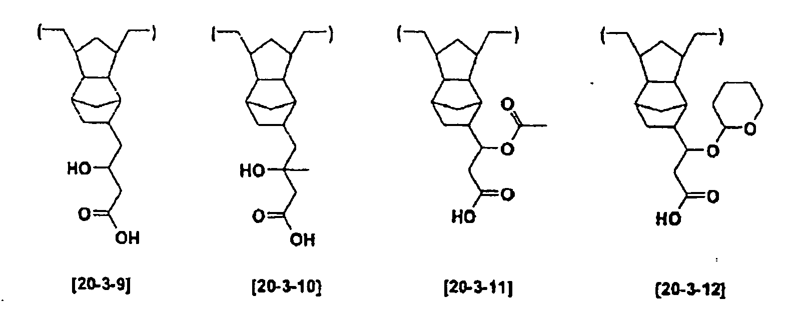 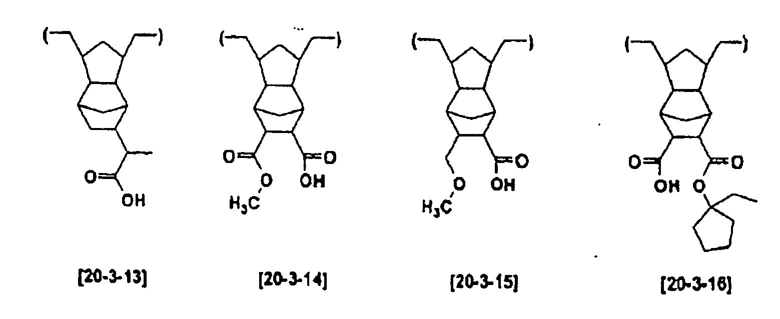 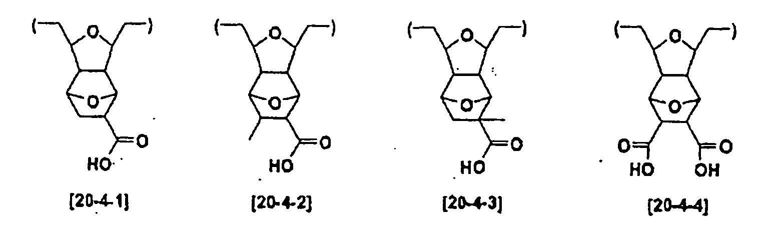 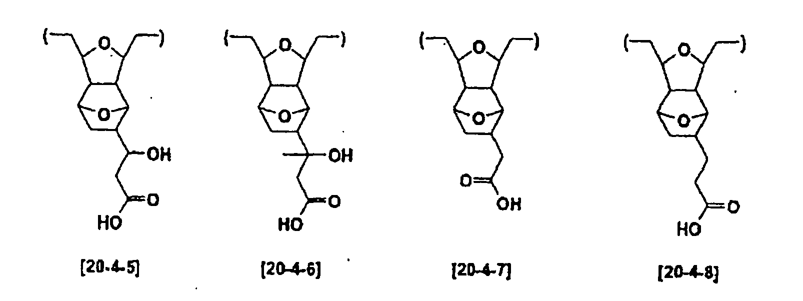 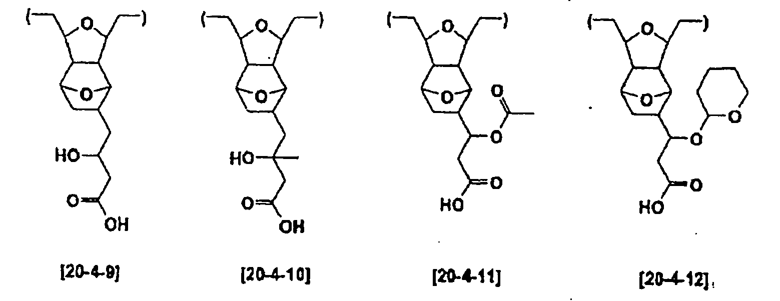 are listed.

In preferable embodiments of the present invention, the molar ratio of the structural unit [A] represented by the general formula [1], the structural unit [B] represented by the general formula [3] and the structural unit [C] represented by the general formula [4] to the structural unit [D] represented by the general formula [5], that is ([A]+[B]+[C])/[D] is from 100/0 to 20/80, and it is preferable that the structural unit [D] is present in certain amount in addition to the structural units [A], [B] and [C]. Here, the structural unit [D] enhances extremely adhesion to a treating substrate such as a silicon substrate, and further improve affinity to a developer. The molar ratio ([A]+[B]+[C])/[D] is preferably from 98/2 to 50/50, more preferably from 97/3 to 60/40, most preferably from 95/5 to 70/30.

The hydrogenated ring-opening metathesis copolymer of the present invention may comprise a structural unit [E] represented by the general formula [7] as a further structural unit in addition to the structural units [A] and [B] and/or [B], preferably further in addition to unit [D]

In the general formula [7], at least one of R²⁵ to R²⁸ is a functional group having a carboxylate group of the general formula [8] (wherein the dotted line is a bond; R²⁹ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; R³⁰ is a linear or branched alkyl group having 1 to 10 carbon atoms, a linear, or branched or cyclic alkoxyalkyl group having 2 to 10 carbon atoms, or a linear, branched or cyclic halogenated alkyl group having 1 to 20 carbon atoms; W³ is a single bond or a (s+2)-valent hydrocarbon group having 1 to 10 carbon atoms; s represents 0 or 1; and s is 0 in case W³ is a single bond.

Regarding R²⁹, examples of the linear, branched or cyclic alkyl group having 1 to 10 carbon atoms include methyl, ethyl, propyl, isopropyl, n-butyl, isobutyl, tert-butyl, cyclopentyl, cyclohexyl, 1-ethylcyclopentyl or 1-ethylcyclohexyl; examples of the linear, branched or cyclic alkoxyalkyl group having 2 to 10 carbon atoms include methoxymethyl, 1-ethoxyethyl, 1-tert-butoxyethyl, 1-cyclohexyloxyethyl, 1-ethoxypropyl, 1-ethoxy-1-methyl-ethyl, tetrahydrofuran-2-yl or tetrahydropyran-2-yl; and examples of the linear, branched or cyclic acyl group having 1 to 10 carbon atoms include formyl, acetyl, pivaloyl or cyclohexylcarbonyl. Among these groups R²⁹, a linear or branched alkyl group having 1 to 6 carbon atoms, a linear, branched or cyclic alkoxyalkyl group having 2 to 7 carbon atoms and a linear or branched acyl group having 2 to 7 carbon atoms are preferable, and particularly, a hydrogen atom, methyl, ethyl, methoxymethyl, 1-ethoxyethyl, tetrahydrofuran-2-yl and acetyl are preferable.

Regarding R³⁰, examples of the linear, branched or cyclic alkyl group having 1 to 10 carbon atoms include methyl, ethyl, propyl, isopropyl, n-butyl, isobutyl or tert-butyl; examples of the linear, branched or cyclic alkoxyalkyl group having 2 to 10 carbon atoms include methoxymethyl, 1-ethoxyethyl, 1-tert-butoxyethyl, 1-cyclohexyloxyethyl, 1-ethoxypropyl, 1-ethoxy-1-methylethyl,tetrahydrofuran-2-yl or tetrahydropyran-2-yl; and examples of the linear, branched or cyclic halogenated alkyl group having 1 to 20 carbon atoms include fluoromethyl, chloromethyl, bromomethyl, difluoromethyl, dichloromethyl, dibromomethyl, trifluoromethyl, trichloromethyl or tribromomethyl. Among these groups R³⁰, a linear or branched alkyl group having 1 to 10 carbon atoms are preferable, and particularly, methyl, ethyl, propyl, isopropyl, n-butyl, isobutyl and tert-butyl are preferable.

Regarding W³, the (s+2)-valent hydrocarbon group having 1 to 10 carbon atoms is a linear, branched or cyclic divalent hydrocarbon group having 1 to 10 carbon atoms, and examples thereof include methylene, dimethylmethylene, ethylidene, propylidene, butylidene, ethylene, 1-methylethylene, 2-methylethylene, 1-ethylethylene, 2-ethylethylene, 1,1-dimethylethylene, 1,2-dimethylethylene, 2,2-dimethylethylene, 1-ethyl-2-methylethylene, trimethylene, 1-methyltrimethylene, 2-methyltrimethylene, 3-methyltrimethylene, tetramethylene, pentamethylene, 1,1-cyclopentylene, 1,2-cyclopentylene, 1,3-cyclopentylene, 1,1-cyclohexylene, 1,2-cyclohexylene, 1,3-cyclohexylene or 1,4-cyclohexylene. Among them, methylene, ethylidene, ethylene, 1-methylethylene, 2-methylethylene, trimethylene and 2-methyltrimethylene are preferable. The above examples include hydrocarbon groups obtained by removing a hydrogen atom at any portion of hydrocarbon groups listed above to form a bond. The most preferable one of W³ is a single bond.

Regarding the other groups of R²⁵ to R²⁸, a hydrogen atom, a linear, branched or cyclic alkyl group having 1 to 20 carbon atoms such as methyl, ethyl, propyl, isopropyl, n-butyl, tert-butyl, cyclohexyl or menthyl; a halogen such as a chlorine atom, bromine atom, iodine atom or fluorine atom; a linear, branched or cyclic halogenated alkyl group having 1 to 20 carbon atoms such as fluoromethyl, chloromethyl, bromomethyl, difluoromethyl, dichloromethyl, dibromomethyl, trifluoromethyl, trichloromethyl or tribromomethyl; a linear, branched or cyclic alkoxy group having 1 to 12 carbon atoms such as methoxy, ethoxy, isopropoxy, n-butoxy, tert-butoxy or menthoxy; a linear, branched or cyclic alkoxyalkyl group having 2 to 20 carbon atoms such as methoxymethyl, methoxyethyl, tert-butoxymethyl, tert-butoxy-ethyl, menthoxymenthol, or alkoxy saccharides such as methylglucose; a linear, branched or cyclic alkylcarbonyloxy group having 2 to 20 carbon atoms such as acetoxy; an arylcarbonyloxy group having 6 to 20 carbon atoms such as naphthoyloxy; alkylsulfonyloxy group having 1 to 20 carbon atoms such as mesyloxy; an arylsulfonyloxy group having 6 to 20 carbon atoms such as tosyloxy; a linear, branched or cyclic alkoxycarbonyl group having 2 to 20 carbon atoms such as methoxycarbonyl, ethoxycarbonyl, n-propoxycarbonyl, isopropoxycarbonyl, n-butoxycarbonyl, tert-butoxycarbonyl or cyclohexyloxycarbonyl; a linear, branched or cyclic alkoxycarbonylalkyl group having 3 to 20 carbon atoms such as methoxycarbonylmethyl, 2-(methoxycarbonyl)ethyl, 1-(methoxycarbonyl)ethyl, ethoxycarbonylmethyl, 2-(ethoxycarbonyl)ethyl, n-propoxycarbonylmethyl, isopropoxycarbonylmethyl, n-butoxycarbonylmethyl, tert-butoxycarbonylmethyl or cyclohexyloxycarbonylmethyl; are each independently listed as specific examples thereof. Among them, a hydrogen atom, a linear, branched or cyclic alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkoxycarbonyl group having 2 to 20 carbon atoms and a linear, branched or cyclic alkoxycarbonylalkyl group having 3 to 20 carbon atoms are preferable; and a hydrogen atom, a linear or branched alkyl group having 1 to 10 carbon atoms, a linear or branched alkoxycarbonyl group having 2 to 10 carbon atoms and a linear or branched alkoxycarbonylalkyl group having 3 to 10 carbon are more preferable.

X⁵ is -O- or -CR³¹₂- (R³¹ represents a hydrogen atom or a linear or branched alkyl group having 1 to 10 carbon atoms), and when r is 1 to 3, X⁵ may be the same or different. Specific examples of R³¹ include a hydrogen atom, and a linear or branched alkyl group having 1 to 10 carbon atoms such as methyl, ethyl, n-propyl, isopropyl, n-butyl or tert-butyl. X⁵ represents preferably -O- or - CH₂-, and more preferably, all of X⁵ are either -O- or-CH₂-. r is preferably 0 or 1.

Namely, as the specific examples of the general formula [7], structural units [E] represented by the following chemical formula [21]: 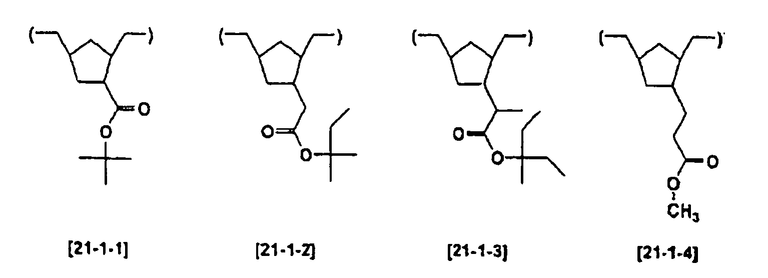 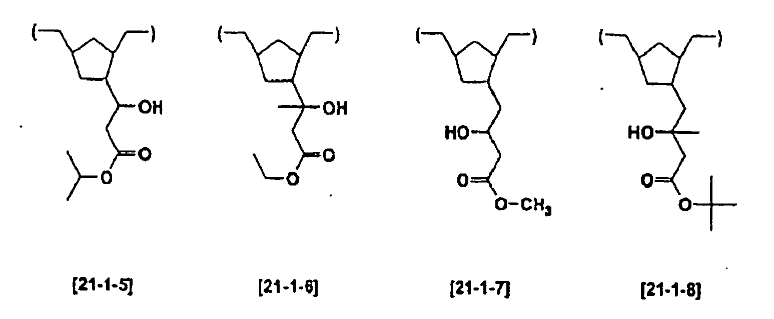 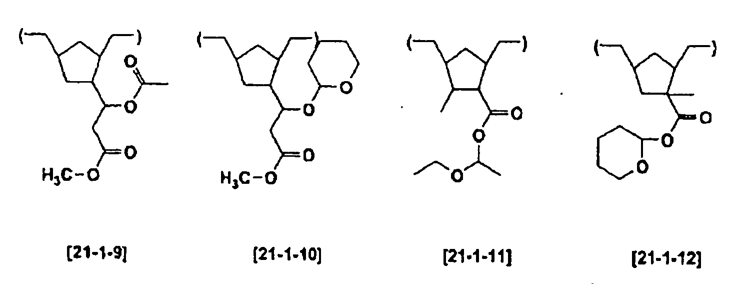 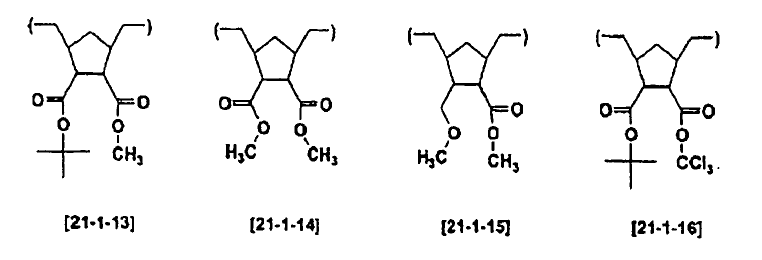 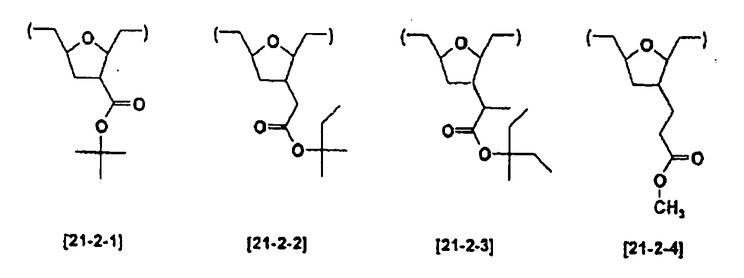 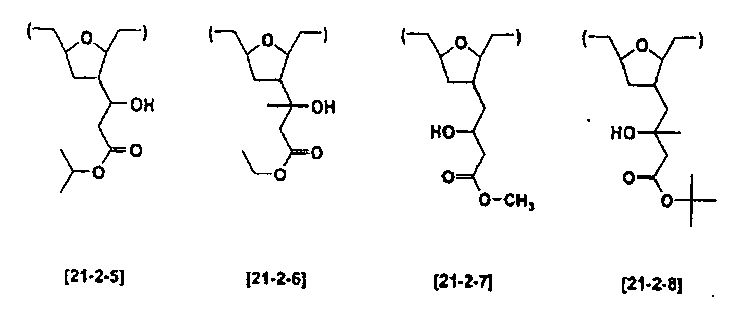 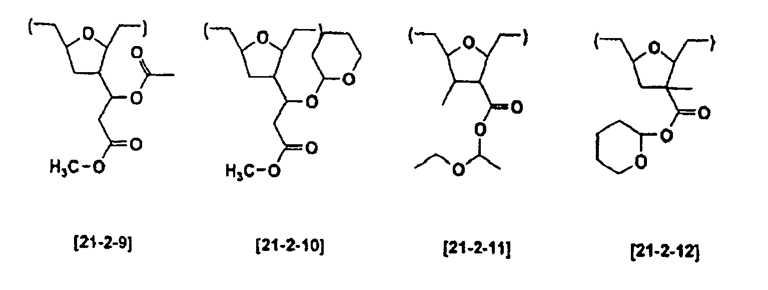 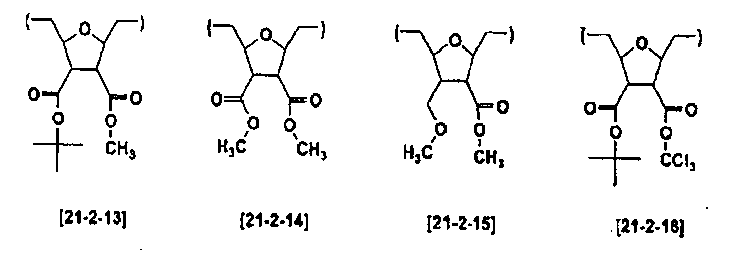 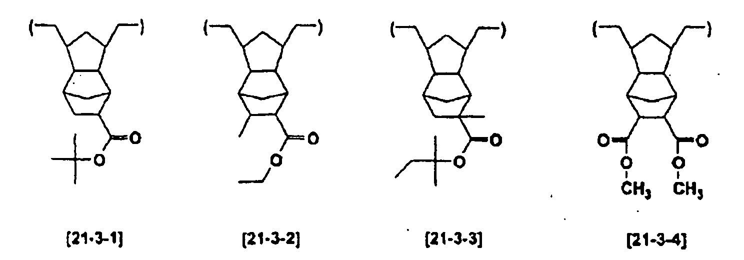 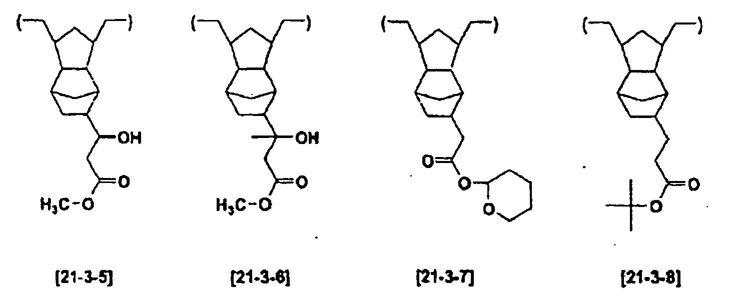 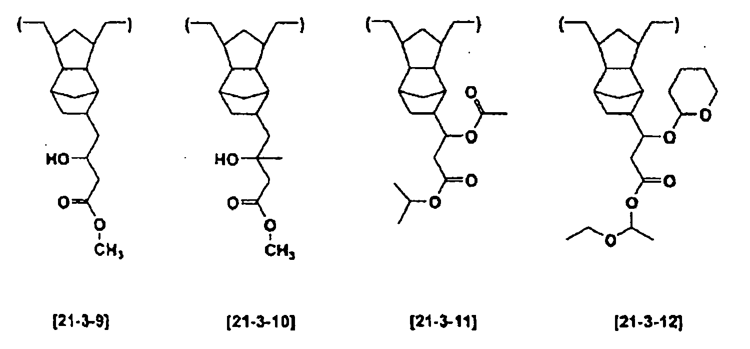 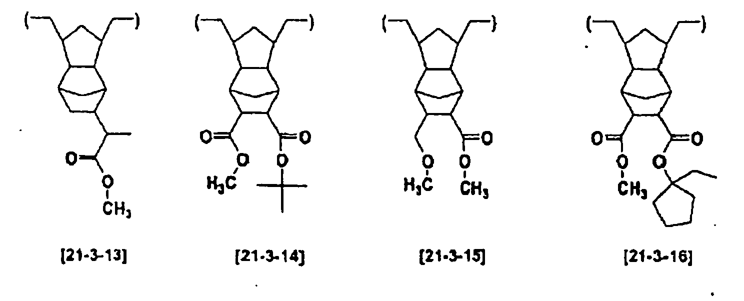 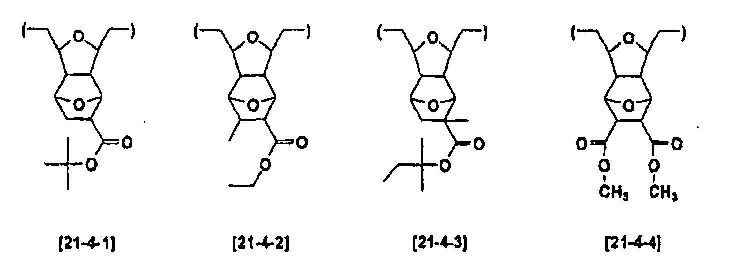 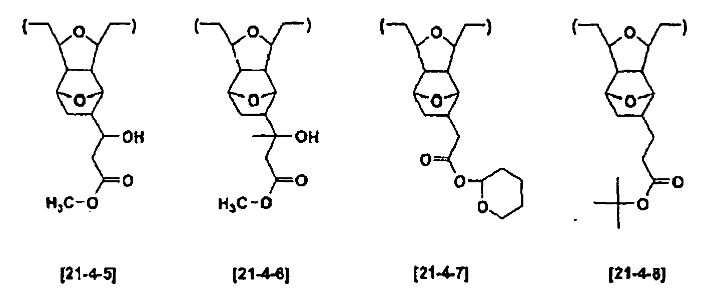 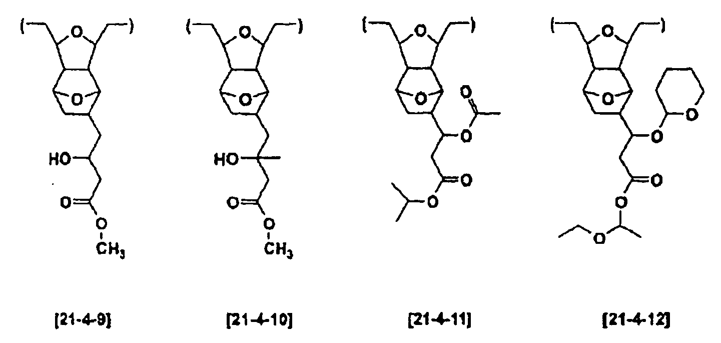 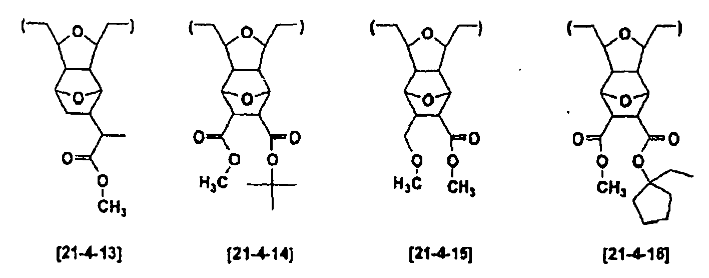 are listed.

The hydrogenated ring-opening metathesis copolymer of the present invention may further comprise a structural unit [F] represented by the following general formula [22] as a structural unit in addition to the structural units [A] and [B] and/or [C], preferably in addition to the structural unit [D], and further in addition to the structural unit [E] in some cases: 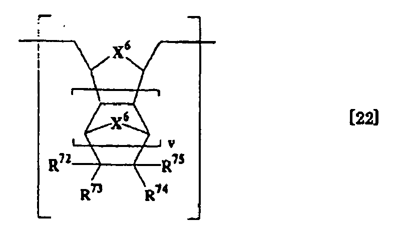 (wherein R⁷² to R⁷⁵ are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a hydroxy group, a linear, branched or cyclic hydroxyalkyl group having 2 to 20 carbon atoms, a cyano group, a linear, branched or cyclic cyanoalkyl group having 2 to 20 carbon atoms, a linear, branched or cyclic alkylcarbonyloxy group having 2 to 20 carbon atoms, a linear, branched or cyclic alkylcarbonyloxyalkyl group having 3 to 20 carbon atoms, an arylcarbonyloxy group having 6 to 20 carbon atoms, a linear, branched or cyclic alkylsulfonyloxy group having 1 to 20 carbon atoms, a linear, branched or cyclic alkylsulfonyloxyalkyl group having 2 to 20 carbon atoms, or an arylsulfonyloxy group having 6 to 20 carbon atoms; and X⁶ is -O- or -CR²⁴₂-(R²⁴ represents a hydrogen atom or a linear or branched alkyl group having 1 to 10 carbon atoms) and may be the same or different each other; v is 0 or an integer of 1 to 3).

The hydrogenated ring-opening metathesis copolymer of the present invention is obtained by polymerizing cyclic olefin monomers corresponding respectively to the structural unit [A] represented by the general formula [1], the structural unit [B] represented by the general formula [3] and/or the structural unit [C] represented by the general formula [4], and if necessary the structural unit [E] represented by the general formula [7], and further if necessary the structural unit [F] represented by the general formula [22] by using a ring-opening metathesis catalyst, and hydrogenating the resulted polymer in the presence of a hydrogenation catalyst.

The cyclic olefin monomer corresponding to the structural unit [A] represented by the general formula [1] is a cyclic olefin monomer having a structure represented by the general formula [9], the cyclic olefin monomer corresponding to the structural unit [B] represented by the general formula [3] is a cyclic olefin monomer having a structure represented by the general formula [10], the cyclic olefin monomer corresponding to the structural unit [C] represented by the general formula [4] is a cyclic olefin monomer having a structure represented by the general formula [11], the cyclic olefin monomer corresponding to the structural unit [E] represented by the general formula [7] is a cyclic olefin monomer having a structure represented by the general formula [12], and the cyclic olefin monomer corresponding to the structural unit [F] represented by the general formula [22] is a cyclic olefin monomer having a structure represented by the following general formula [23]: 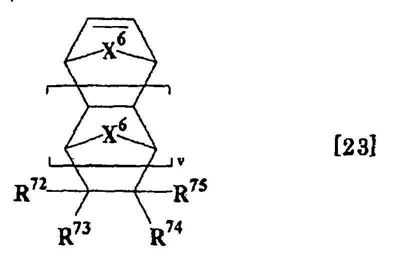 (wherein R⁷² to R⁷⁵, X⁶ and v are as defined above).

Specific examples of R⁵⁵ to R⁷⁵ in these formulae are substituents described previously as the respective corresponding substituents, and the same substituents including also preferable examples are listed.

Namely, the hydrogenated ring-opening metathesis copolymer of the present invention is obtained by polymerizing at least a cyclic olefin monomer represented by the general formula [9], a cyclic olefin monomer represented by the general formula [10] and/or a cyclic olefin monomer represented by the general formula [11], and if necessary a cyclic olefin monomer represented by the general formula [12], and further if necessary a cyclic olefin monomer represented by the general formula [23]; and a cyclic olefin monomer in which at least one of X¹ in the general formula [9], X² in the general formula [10] and X³ in the general formula [11] is -O-, by using a ring-opening metathesis catalyst, and hydrogenating the resulted polymer in the presence of a hydrogenation catalyst. The charging molar ratio of a cyclic olefin monomer represented by the general formula [9] to a cyclic olefin monomer represented by the general formula [10] and a cyclic olefin monomer represented by the general formula [11] is from 20/80 to 99/1, more preferably from 20/80 to 95/5, particularly preferably from 25/75 to 90/10, most preferably from 30/70 to 85/15. When a cyclic olefin monomer represented by the general formula [12] is used, it is used usually in an amount of 50 mol% or less, preferably 30 mol% or less, further preferably 20 mol% or less based on the total molar amount of olefin monomers used. When a cyclic olefin monomer represented by the general formula [23] is used, it is used usually in an amount of 50 mol% or less, preferably 30 mol% or less, further preferably 20 mol% or less based on the total molar amount of olefin monomers used.

It is preferable that at least one of X¹ in a cyclic olefin monomer represented by the general formula [9], X² in a cyclic olefin monomer represented by the general formula [10] and X³ in a cyclic olefin monomer represented by the general formula [11] is -O-, and the others are -CH₂-, and the molar amount of a -O- unit based on the total molar amount of X¹, X² and X³ units is from 0.01 to 0.99, preferably from 0.02 to 0.95, more preferably from 0.05 to 0.80, most preferably from 0.10 to 0.70. Also in case that the cyclic olefin monomers represented by the general formula [12] and/or general formula [23] are used, the molar amount of a -O- unit based on the total molar amount of X¹, X², X³,X⁵ and X⁶ units is from 0.01 to 0.99, preferably from 0.02 to 0.95, more preferably from 0.05 to 0.80, most preferably from 0.10 to 0.70.

The hydrogenated ring-opening metathesis copolymer of the present invention is obtained by polymerizing the above-mentioned olefin monomers by using a ring-opening metathesis catalyst, preferably a living ring-opening metathesis catalyst, more preferably in the presence of a chain transfer agent such as an olefin, diene and the like, in a solvent or without using a solvent, then, hydrogenating the resulted polymer using a hydrogenation catalyst in a solvent under pressure of hydrogen.

The polymerization catalyst used in the present invention may be any catalyst capable of conducting ring-opening metathesis polymerization, and specific examples of the living ring-opening metathesis catalyst include tungsten-based alkylidene catalysts such as W(N-2,6-Prⁱ₂C₆H₃)-(CHBu^{t})(OBu^{t})₂, W(N-2,6-Prⁱ₂C₆H₃)(CHBu^{t})(OCMe₂CF₃)₂, W(N-2,6-Prⁱ₂C₆H₃)(CHBu^{t})(OCMe(CF₃)₂)₂, W(N-2,6-Prⁱ₂C₆H₃) (CHCMe₂Ph)(OBu^{t})₂, W(N-2,6-Prⁱ₂C₆H₃)(CHCMe₂Ph)(OCMe₂CF₃)₂ or W(N-2,6-Prⁱ₂C₆H₃)(CHCMe₂Ph)(OCMe₂(CF₃)₂)₂ (wherein Prⁱ represents an iso-propyl group, But represents a tert-butyl group, Me represents a methyl group, and Ph represents a phenyl group); tungsten-based alkylidene catalysts such as W(N-2,6-Me₂C₆H₃)(CHCHCMePh) (OBu^{t})₂(PMe₃), W(N-2,6-Me₂C₆H₃)(CHCHCMe₂)(OBu^{t})₂(PMe₃), W(N-2,6-Me₂C₆H₃) (CHCHCPh₂)(OBu^{t})₂(PMe₃), W(N-2,6-Me₂C₆H₃)(CHCHCMePh) (OCMe₂-(CF₃))₂(PMe₃), W(N-2,6-Me₂C₆H₃)(CHCHCMe₂)(OCMe₂(CF₃))₂(PMe₃), W(N-2,6-Me₂C₆H₃)(CHCHCPh₂)(OCMe₂(CF₃))₂(PMe₃); W(N-2,6-Me₂C₆H₃)(CHCHCMe₂)(OCMe(CF₃)₂)₂(PMe₃), W(N-2,6-Me₂C₆H₃)(CHCHCPh₂)-(OCMe(CF₃)₂)₂(PMe₃), W(N-2,6-Prⁱ₂C₆H₃)(CHCHCMePh)(OCMe₂-(CF₃))₂(PMe₃), W(N-2,6-prⁱ₂C₆H₃)(CHCHCMePh)(OCMe(CF₃)₂)₂(PMe₃) or W(N-2,6-Prⁱ₂C₆H₃)(CHCHCMePh) (OPh)₂(PMe₃) (whererin Prⁱ represents an iso-propyl group, Bu^{t} represents a tert-butyl group, Me represents a methyl group, and Ph represents a phenyl group); molybdenum-based alkylidene catalysts such as Mo(N-2,6-Prⁱ₂C₆H₃)(CHBu^{t})-(OBu^{t})₂, Mo(N-2,6-Prⁱ₂C₆H₃)(CHBu^{t})(OCMe₂CF₃)₂, Mo(N-2,6-Prⁱ₂C₆H₃)(CHBu^{t})(OCMe(CF₃)₂)₂, Mo(N-2,6-Prⁱ₂C₆H₃) (CHCMe₂Ph)(OBu^{t})₂, Mo(N-2,6-Prⁱ₂C₆H₃)(CHCMe₂Ph)(OCMe₂CF₃)₂ or Mo(N-2,6-Prⁱ₂C₆H₃)(CHCMe₂Ph)(OCMe₂(CF₃)₂)₂ (wherein Prⁱ represents an iso-propyl group, Bu^{t} represents a tert-butyl group, Me represents a methyl group, and Ph represents a phenyl group); rhenium-based alkylidene catalysts such as Re(CBu^{t})(CHBu^{t})(O-2,6-Prⁱ₂C₆H₃)₂, Re(CBu^{t})(CHBu^{t})(O-2-Bu^{t}₂C₆H₄)₂, Re(CBu^{t})(CHBu^{t})(OCMe₂CF₃)₂, Re(CBu^{t})(CHBu^{t})(OCMe(CF₃)₂)₂ or Re(CBu^{t})(CHBu^{t})(O-2,6-Me₂C₆H₃)₂ (wherein Bu^{t} represents a tert-butyl group); tantalum-based alkylidene catalysts such as Ta[C(Me)C(Me)CHCMe₃](O-2,6-Prⁱ₂C₆H₃)₃Py or Ta[C(Ph)C(Ph) CHCME₃](O-2,6-Prⁱ₂C₆H₃)₃Py (wherein Me represents a methyl group, Ph represents a phenyl group, and Py represents a pyridine group); ruthenium-based alkylidene catalysts such as Ru(CHCHCPh₂)(PPh₃)₂Cl₂ or Ru(CHCHCPh₂) (P(C₆H₁₁)₃)₂Cl₂ (wherein Ph represents a phenyl group); and titanacyclobutane catalyst. The above-mentioned ring-opening metathesis catalysts may be used alone or in admixture of two or more.

In addition to the above catalysts, there can also be used living ring-opening metathesis catalysts composed of a combination of an organic transition metal complex and Lewis acid as a cocatalyst, for example, ring-opening metathesis catalysts composed of a complex of a transition metal such as molybdenum, and tungsten with halogen, and a cocatalyst such as organoaluminum compound, organotin compound or organometallic compound of lithium, sodium, magnesium, zinc, cadmium, boron and the like.

As the specific examples of the organic transition metal halogen complex, there are listed catalysts composed of a combination of tungsten-based halogen complexes such as W(N-2,6-Prⁱ₂C₆H₃)(thf)(OBu^{t})Cl₂, W(N-2,6-Prⁱ₂C₆H₃)(thf)-(OCMe₂CF₃)Cl₂, W(N-2,6-Prⁱ₂C₆H₃)(thf)(OCMe(CF₃)₂)Cl₂, W(N-2,6-Prⁱ₂C₆H₃)(thf)(OBu^{t})Cl₂, W(N-2,6-Prⁱ₂C₆H₃)(thf)(OCMe₂-CF₃)Cl₂ or W(N-2,6-Prⁱ₂C₆H₃)(thf) (OCMe₂(CF₃)₂)Cl₂ (wherein Prⁱ represents an iso-propyl group, But represents a tert-butyl group, Me represents a methyl group, Ph represents a phenyl group, thf represents tetrahydrofuran) with organometallic compounds described below, and catalysts composed of a combination of molybdenum-based halogen complexes such as Mo(N-2,6-Prⁱ₂C₆H₃)(thf)(OBu^{t})Cl₂, Mo (N-2,6-Prⁱ₂C₆H₃)(thf)(OCMe₂CF₃)Cl₂, Mo(N-2,6-Prⁱ₂C₆H₃)(thf)(OCMe(CF₃)₂)Cl₂, Mo(N-2,6-Prⁱ₂C₆H₃)(thf)(OBu^{t})Cl₂, Mo(N-2,6-Prⁱ₂C₆H₃)(thf)(OCMe₂CF₃)Cl₂ or Mo(N-2,6-Prⁱ₂C₆H₃)(thf)(OCMe(CF₃)₂)Cl₂ (wherein Prⁱ represents an iso-propyl group, But represents a tert-butyl group, Me represents a methyl group, Ph represents a phenyl group, thf represents tetrahydrofuran) with organometallic compounds described below.

Specific examples of the organometallic compound as a cocatalyst include organoaluminum compounds such as trimethylaluminum, triethylaluminum, triisobutylaluminum, trihexylaluminum, trioctylaluminum, triphenylaluminum, tribenzylaluminum, diethylaluminum monochloride, di-n-butylaluminum, diethylaluminum monobromide, diethylaluminum monoiodide, diethylaluminum monohydride, ethylaluminum sesquichloride or ethylaluminum dichloride; organotin compounds such as tetramethyltin, diethyldimethyltin, tetraethyltin, dibutyldiethyltin, tetrabutyltin, tetraoctyltin, trioctyltin fluoride, trioctyltin chloride, trioctyltin bromide, trioctyltin iodide, dibutyltin difluoride, dibutyltin dichloride, dibutyltin dibromide, dibutyltin diiodide, butyltin trifluoride, butyltin trichloride, butyltin tribromide or butyltin triiodide; organolithium compounds such as n-butyllithium; organosodium compounds such as n-pentylsodium; organomagnesium compounds such as methylmagnesium iodide, ethylmagnesium bromide, methylmagnesium bromide, n-propylmagnesium bromide, t-butylmagnesium chloride or allylmagnesium chloride; organozinc compounds such as diethylzinc; organocadmium compounds such as diethylcadmium; organoboron compounds such as trimethylboron, triethylboron or tri-n-butylboron.

In the living ring-opening metathesis polymerization of the present invention, a molar ratio of the cyclic olefin monomer to the ring-opening metathesis catalyst is from 2 to 10000, preferably from 10 to 5000, in the case of the transition metal alkylidene catalyst of tungsten, molybdenum, rhenium, tantalum or ruthenium, or a titanacyclobutane catalyst. In the case of the ring-opening metathesis catalyst composed of the organic transition metal halogen complex and organometallic compound, the molar ratio of the cyclic olefin monomer to the organic transition metal halogen complex is from 2 to 10000, preferably from 10 to 5000, and the molar ratio of the organometallic compound as a cocatalyst to the organic transition metal halogen complex is from 0.1 to 10, preferably from 1 to 5.

When polymerization is conducted by using a ring-opening metathesis catalyst in the present invention, it is preferable to effect polymerization in the presence of a chain transfer agent such as an olefin and diene in order to enhance the catalytic efficiency. The examples of the olefin used as a chain transfer agent include α-olefins such as ethylene, propylene, butene, pentene, hexene or octene; and silicon-containing olefins such as vinyltrimethylsilane, allyltrimethylsilane, allyltriethylsilane or allyltriisopropylsilane. The examples of the diene include non-conjugated dienes such as 1,4-pentadiene, 1,5-hexadiene or 1,6-heptadiene. Furthermore, these olefins or dienes may be used alone or in combination of two or more.

The amount of the olefin or diene used in combination in the present invention is within a range from 0.001 to 1000-fold mol, preferably from 0.01 to 100-fold mol based on the cyclic olefin monomers. Further, the amount of the olefin or diene is within a range from 0.1 to 1000 equivalents, preferably from 1 to 500 equivalents, based on 1 equivalent of the alkylidene in the transition metal alkylidene complex.

The ring-opening metathesis polymerization in the present invention may be conducted in the presence or absence of a solvent. The solvent to be particularly used includes, for example, ethers such as tetrahydrofuran, diethyl ether, dibutyl ether, dimethoxyethane or dioxane; aromatic hydrocarbons such as benzene, toluene, xylene or ethylbenzene; aliphatic hydrocarbons such as pentane, hexane or heptane; alicyclic hydrocarbons such as cyclopentane, cyclohexane, methylcyclohexane, dimethylcyclohexane or decalin; and halogenated hydrocarbons such as methylene dichloride, dichloroethane, dichloroethylene, tetrachloroethane, chlorobenzene or trichlorobenzene. Two or more kinds of them may also be used in combination.

The concentration of the ring-opening metathesis polymerization in the present invention is not fixed and it depends on the reactivity of the cyclic olefin monomer, the solubility into a polymerization solvent and the like. Usually, the concentration of the cyclic olefin monomer in a solvent is from 0.001 to 500 mol/L, preferably from 0.01 to 100 mol/L, more preferably from 0.05 to 50 mol/L. The reaction temperature also depends on the kind and amount of the cyclic olefin monomer, the ring-opening metathesis catalyst and the like. Usually, it is from -30 to 150°C, preferably from 0 to 120°C, more preferably from 15 to 100°C. The reaction time is usually from 1 minute to 10 hours, preferably from 5 minutes to 8 hours, more preferably from 10 minutes to 6 hours.

After the polymerization reaction, the reaction can be terminated by using a deactivator such as aldehydes (e.g. butylaldehyde), ketones (e.g. acetone) and alcohols (e.g. methanol) to obtain a ring-opening metathesis polymer solution.

In the present invention, regarding the polymer obtained by the ring-opening metathesis polymerization, a polymer having a desired molecular weight can be obtained by controlling the molar ratio between the monomer and catalyst because the ring-opening metathesis polymerization is a living polymerization reaction. It is also possible to obtain a polymer having a desired molecular weight by controlling the molar ratio between the monomer, the chain transfer agent and the catalyst while the living polymerization is maintained by conducting the living ring-opening metathesis polymerization in the presence of an olefin or diene as a chain transfer agent. The number-average molecular weight Mn of the polymer obtained by the living polymerization is from 500 to 200,000, preferably from 1,000 to 100,000, particularly from 3,000 to 50,000 as polystyrene standard. In addition, a ratio of the weight-average molecular weight Mw to the number-average molecular weight Mn, that is Mw/Mn varies slightly depending on the properties of the monomer and chain transfer agent, but it is controlled within a narrow molecular weight distribution of from 1.0 to 2.0. The range of the molecular weight distribution does not vary even after the ring-opening metathesis copolymer has been hydrogenated in the presence of the hydrogenation catalyst. The range is preferably from 1.0 to 1.8, more preferably from 1.0 to 1.6. The molecular weight in this range and the narrow molecular weight distribution are extremely important for forming a homogeneous and smooth coating film in a step of dissolving a resist material in a solvent and coating the solution onto a silicon wafer by a spin coater. Therefore, it is very important to conduct living polymerization as polymerization for determining the molecular weight and molecular weight distribution as the resist material so that the polymer, produced by hydrogenating an olefin as a main chain portion of the polymer, exhibits a function of the resist material wherein the solubility in a polar solvent, adhesion to the silicon wafer surface and coatability to the surface are enhanced.

As described above, a ring-opening metathesis polymer having an olefinically unsaturated bond in the main chain portion is obtained by polymerizing a cyclic olefin monomer of the present invention using a ring-opening metathesis catalyst. In the present invention, it is necessary to hydrogenate the olefin in the main chain portion of the ring-opening metathesis polymer in order to shift down the ultraviolet (UV) maximum absorption range, especially in order to enhance the UV transmittance in the wavelength region of an ArF excimer laser, i.e., at 193 nm as large as possible. In this hydrogenation reaction, a known hydrogenation catalyst can be used.

Specific examples of the heterogeneous hydrogenation catalyst include supporter type metal catalysts obtained by supporting a metal such as palladium, platinum, nickel, rhodium or ruthenium on a carrier such as carbon, silica, alumina, titania, magnesia, diatomaceous earth or synthetic zeolite. The homogeneous catalyst includes, for example, known hydrogenated catalysts such as nickel naphthenate/triethylaluminum, nickel acetylacetonate/triisobutylaluminum, cobalt octenoate/n-butyllithium, titanocene dichloride/diethylaluminum chloride, rhodium acetate, dichlorobis(triphenylphosphine)palladium, chlorotris(triphenylphosphine)rhodium or dihydridetetrakis(triphenylphosphine)ruthenium. Furthermore, the hydrogenation can also be conducted in the presence of hydrogen by using a hydrogenation catalyst composed of an organometal complex represented by the following general formula [24]:

MH w Q x T y U z [24]

(wherein M represents ruthenium, rhodium, osmium, iridium, palladium, platinum or nickel; H represents a hydrogen atom; Q represents a halogen atom, T represents CO, NO, toluene, acetonitrile or tetrahydrofuran; U represents an organophosphorus compound PR'¹R'²R'³ (P represents phosphorus, R'¹, R'² and R'³ are same or different and respectively represent a linear, branched or cyclic alkyl, alkenyl, aryl, alkoxy or allyloxy); w represents an integer of 0 or 1; x represents an integer of 1 to 3; y represents an integer of 0 or 1; and z represents an integer of 2 to 4) and an amine compound as a homogeneous catalyst.

In the general formula [24], Q represents a halogen atom and includes, for example, chlorine atom, fluorine atom, bromine atom and iodine atom. Furthermore, T represents CO, NO, toluene, acetonitrile or tetrahydrofuran. U represents an organophosphorus compound and includes, for example, trimethylphosphine, triethylphosphine, triisopropylphosphine, tri-n-propylphosphine, tri-t-butylphosphine, triisobutylphosphine, tri-n-butylphosphine, tricyclohexylphosphine, triphenylphosphine, methyldiphenylphosphine, dimethylphenylphoshpine, tri-o-tolylphosphine, tri-m-tolyl-phosphine, tri-p-tolylphosphine, diethylphenylphosphine, dichloro(ethyl)phosphine, dichloro(phenyl)-phosphine, chlorodiphenylphosphine, trimethylphosphite, triisopropyl-phosphite and triphenylphosphite.

Specific examples of the organometal complex represented by the general formula [24] include dichlorobis(triphenylphosphine)nickel, dichlorobis(triphenylphosphine)palladium, dichlorobis(triphenylphosphine) platinum, chlorotris(triphenylphosphine)rhodium, dichlorotris(triphenylphosphine)osmium, dichlorohydridebis(triphenylphosphine)iridium, dichlorotris(triphenylphosphine)-ruthenium, dichlorotetrakis(triphenylphosphine)ruthenium, trichloronitrosylbis(triphenylphosphine)ruthenium, dichlorobis(acetonitrile)bis(triphenylphosphine)ruthenium, dichlorobis(tetrahydrofuran)bis(triphenylphosphine)-ruthenium, chlorohydride(toluene)tris(triphenylphosphine)-ruthenium, chlorohydridecarbonyltris(triphenylphosphine)-ruthenium, chlorohydridecarbonyltris(diethylphenylphosphine)ruthenium, chlorohydridenitrosyltris(triphenylphosphine)ruthenium, dichlorotris(trimethylphosphine)-ruthenium, dichlorotris(triethyl-phosphine)ruthenium, dichlorotris(tricyclohexyl-phosphine)ruthenium, dichlorotris(triphenyl-phosphine)ruthenium, dichlorotris-(trimethyldiphenyl-phosphine)ruthenium, dichlorotris-(tridimethylphenyl-phosphine)ruthenium, dichlorotris(tri-o-tolylphosphine)ruthenium, dichlorotris(dichloroethylphosphine)ruthenium, dichlorotris(dichlorophenylphosphine)ruthenium, dichlorotris(trimethylphosphite)ruthenium or dichlorotris(triphenyl-phoshpite)ruthenium.

Specific examples of the amine compound include primary amine compounds such as methylamine, ethylamine, aniline, ethylenediamine or 1,3-diaminocyclobutane; secondary amine compounds such as dimethylamine, methylisopropylamine or N-methylaniline; and tertiary amine compounds such as trimethylamine, triethylamine, triphenylamine, N,N-dimethylaniline, pyridine or γ-picoline. Among them, the tertiary amine compound is preferably used. When using triethylamine, the hydrogenation rate is remarkably improved.

Two or more kinds of these organometal complexes and amine compounds can be used in combination in any proportion.

When using a known hydrogenation catalyst for hydrogenating the ring-opening metathesis polymer in the present invention, the amount of the known hydrogenation catalyst is from 5 to 50000 ppm, preferably from 100 to 1000 ppm, based on a ring-opening metathesis polymer. When using a hydrogenation catalyst composed of the organometal complex and the amine compound, the amount of the organometal complex is from 5 to 50000 ppm, preferably from 10 to 10000 ppm, particularly preferably from 50 to 1000 ppm based on a ring-opening metathesis polymer. Further, the amount of the amine compound is from 0.1 to 1000 equivalents, preferably from 0.5 to 500 equivalents, particularly preferably from 1 to 100 equivalents based on the organometal complex.

As the hydrogenation catalyst composed of the organometal complex and the amine compound, those prepared by previously contacting the organometal complex with the amine compound. The organometal complex and the amine compound may be separately added to the reaction system, directly, without previous contacting the organometal complex with the amine compound.

The solvent used in hydrogenating of the ring-opening metathesis polymer may be any one ordinary used in a hydrogenation reaction. A solvent which is capable to dissolve the ring-opening metathesis polymer and the hydrogenated polymer, and which is not hydrogenated itself, is referable. Examples of the solvent include ethers such as tetrahydrofuran, diethyl ether, dibutyl ether or dimethoxyethane; aromatic hydrocarbons such as benzene, toluene, xylene or ethylbenzene; aliphatic hydrocarbons such as pentane, hexane or heptane; alicyclic hydrocarbons such as cyclopentane, cyclohexane, methylcyclohexane, dimethylcyclohexane or decalin; halogenated hydrocarbons such as methylene dichloride, dichloroethane, dichloroethylene, tetrachloroethane, chlorobenzene or trichlorobenzene. Two or more kinds of them may be used in combination.

The concentration of the ring-opening metathesis polymer of the present invention in a hydrogenation reaction depends on the kinds of the ring-opening metathesis polymer, hydrogenation catalyst and solvent. Usually, the concentration of the ring-opening metathesis polymer in a solvent is from 0.01 g to 10 kg/L, preferably from 0.1 g to 5 kg/L, further preferably from 0.5 g to 1 kg/L.

The hydrogenation reaction of the ring-opening metathesis polymer is usually conducted under a hydrogen pressure within a range from a normal pressure to 30 MPa, preferably from 0.5 to 20 MPa, particularly preferably from 2 to 15 Mpa. The reaction temperature is usually from 0 to 300°C, preferably from room temperature to 250°C, particularly preferably from 50 to 200°C. The reaction time is usually from 1 minute to 50 hours, preferably from 10 minutes to 20 hours, further preferably from 30 minutes to 10 hours.

The production of the hydrogenated ring-opening metathesis polymer in the present invention can be conducted by isolating the ring-opening metathesis polymer from the ring-opening metathesis polymer solution and dissolving it again in a solvent. It is also possible to employ a method of conducting the hydrogenation reaction by adding the hydrogenation catalyst composed of the above organometal complex and the amine compound without isolating the ring-opening metathesis polymer.

After the completion of the ring-opening metathesis polymerization or hydrogenation reaction, the ring-opening metathesis catalyst or hydrogenation catalyst remained in the polymer solution can be removed by a known method. The method includes, for example, filtration, adsorption method due to adsorption agent, a method of adding an organic acid such as lactic acid, a poor solvent and water to a solution of a good solvent and extracting and removing the catalyst with maintaining this system at a normal or fixed temperature, and a method of contacting a solution of a good solvent or a polymer slurry with a basic compound and an acidic compound and washing to remove the catalyst.

The method of recovering a hydrogenated polymer from the hydrogenated ring-opening metathesis polymer solution is not particularly limited, and a known method can be used. The method includes, for example, a method of discharging a reaction solution in a poor solvent under stirring to solidify a hydrogenated polymer and recovering the hydrogenated polymer by filtration, centrifugation or decantation, steam-stripping method of bubbling steam in a reaction solution to precipitate a hydrogenated polymer, and method of directly removing a solvent form a reaction solution by heating.

Using the hydrogenation method in the present invention, the hydrogenation rates of not less than 90% can be easily attained and the rate can be increased to not less than 95%, further to not less than 99%. The hydrogenated ring-opening metathesis polymer thus obtained is not easily oxidized, to obtain a variable hydrogenated ring-opening metathesis polymer.

The above-mentioned methods can produce the hydrogenated ring-opening metathesis polymer which comprises a structural unit [A] represented by the general formula [1], comprises at least a structural unit [B] represented by the general formula [3] and/or a structural unit [C] represented by the general formula [4], and constituted of if necessary a structural unit [E] represented by the general formula [7], further if necessary a structural unit [F] represented by the general formula [22]; and in which at least one of X¹ in the structural unit [A] represented by the general formula [1], X² in the structural unit [B] represented by the general formula [3] and X³ in the structural unit [C] represented by the general formula [4] is -O-; the constituting molar ratio of [A]/([B] and [C]) is from 20/80 to 99/1, and the ratio of the weight-average molecular weight Mw to the number-average molecular weight Mn, that is Mw/Mn is from 1.0 to 2.0.

In the present invention, a hydrogenated ring-opening metathesis polymer which comprises a structural unit [A] represented by the general formula [1] and, a structural unit [B] represented by the general formula [3] and/or a structural unit [C] represented by the general formula [4], a structural unit [D] represented by the general formula [5], and if necessary a structural unit [E] represented by the general formula [7], further if necessary a structural unit [F] represented by the general formula [22], and in which at least one of X¹ in the structural unit [A] represented by the general formula [1], X² in the structural unit [B] represented by the general formula [3] and X³ in the structural unit [C] represented by the general formula [4] is -O-; the constituting molar ratio of [A]/([B] and [C]) is from 20/80 to 99/1; and the ratio of the weight-average molecular weight Mw to the number-average molecular weight Mn, that is Mw/Mn is from 1.0 to 2.0 can be produced by decomposing, in the hydrogenated ring-opening metathesis polymer obtained as described above, at least part of the tertiary ester group of cyclic alkyl in the general formula [2] and/or the ester group in the general formula [8] to convert it into a carboxylic acid.

As the method of decomposing at least part of the tertiary ester group of cyclic alkyl in the general formula [2] and/or the ester group in the general formula [8] to convert it into a carboxylic acid, a method using hydrolysis and/or a method using acidolysis can be usually used. As the method using hydrolysis, any of acidic hydrolysis conducted in the presence of an acidic catalyst such as sulfuric acid, hydrochloric acid, nitric acid, toluenesulfonic acid, trifluoroacetic acid, acetic acid and the like, alkaline hydrolysis conducted in the presence of an alkaline catalyst such as sodium hydroxide, potassium hydroxide or barium hydroxide, and neutral hydrolysis using e.g. sodium acetate or lithium iodide instead of the acidic or alkaline catalyst can be used. The method using hydrolysis essentially requires the presence of water in the system. The amount of water used is not less than the molar amount equivalent to that of an ester group to be converted into a carboxylic acid, and preferably 5-fold mol or more, further preferably 10-fold mol or more, most preferably 20-fold mol or more. In the method using acidolysis, acids such as sulfuric acid, hydrochloric acid, nitric acid, toluenesulfonic acid, trifluoroacetic acid or acetic acid can be used. In the method using acidolysis, water may be present in the system, but the presence of water is not essential. The amount of an acid catalyst, alkaline catalyst and neutral hydrolysis catalyst used in the method using hydrolysis and an acid used in the method using acidolysis is usually 50 mol or less, preferably from 0.00001 to 30 mol, further preferably from 0.001 to 10 mol based on 1 mol of an ester group to be converted into a carboxylic acid.

The hydrolysis reaction and acidolysis reaction in the method of the present invention may use an aqueous solvent or an organic solvent, and particularly, examples of the organic solvent used include alcohols such as methanol or ethanol, ketones such as acetone, ethers such as tetrahydrofuran, diethyl ether, dibutyl ether, dimethoxyethane or dioxane, aromatic hydrocarbons such as benzene, toluene, xylene or ethylbenzene, aliphatic hydrocarbons such as pentane, hexane, heptane or cyclohexane, carboxylic acids such as acetic acid, nitro compounds such as nitromethane, pyridines such as pyridine or lutidine, formamides such as dimethylformamide, and they may be mixed with water or alcohols, or only the organic solvent may be used. Further, two or more among them may be mixed and used. The reaction temperature is usually from 0 to 300°C, preferably from room temperature to 250°C, more preferably from room temperature to 200°C. The reaction time is usually from 1 minute to 100 hours, preferably from 5 minutes to 30 hours, more preferably from 10 minutes to 20 hours.

Embodiments of the hydrolysis reaction and acidolysis reaction in the method of the present invention are not particularly restricted, and any embodiment is permissible providing the hydrolysis reaction and acidolysis reaction can be carried out effectively, and any embodiments under an inert gas atmosphere such as nitrogen, under an air atmosphere, or at reduced pressure, normal pressure, increased pressure, or by batchwise, semi-batchwise or continuous mode may be admitted.

Further, after the hydrolysis reaction or acidolysis reaction, neutralization treatment may be effected appropriately with an alkali or acid. The method of recovering a polymer from a solution or slurry of the hydrogenated ring-opening metathesis polymer, after the hydrolysis reaction or acidolysis reaction, is not particularly restricted, and a known method can be used. In the case of the solution, the method includes, for example, a method of discharging a reaction solution in a poor solvent under stirring to precipitate to precipitate e a hydrogenated polymer and recovering by filtration, centrifugation or decantation process, a steam stripping method of bubbling steam in a reaction solution to precipitate a polymer, and a method of directly removing a solvent from the reaction solution by heating. In the case of the slurry, the method includes, for example, a method of recovering as it is by filtration, centrifugation or decantation process.

The above-mentioned methods can produce a hydrogenated ring-opening metathesis polymer which comprises a structural unit [A] represented by the general formula [1], comprises a structural unit [B] represented by the general formula [3] and/or a structural unit [C] represented by the general formula [4], a structural unit [D] represented by the general formula [5], and if necessary a structural unit [E] represented by the general formula [7], further if necessary a structural unit [F] represented by the general formula [22], and in which at least one of X¹ in the structural unit [A] represented by the general formula [1], X² in the structural unit [B] represented by the general formula [3] and X³ in the structural unit [C] represented by the general formula [4] is -O-, the constituting molar ratio of [A]/([B] and [C]) is from 20/80 to 99/1, and the ratio of the weight-average molecular weight Mw to the number-average molecular weight Mn, that is Mw/Mn is from 1.0 to 2.0.

Further, in the present invention, a hydrogenated ring-opening metathesis polymer which comprises a structural unit [A] represented by the general formula [1] and, comprises a structural unit [B] represented by the general formula [3] and/or a structural unit [C] represented by the general formula [4], if necessary a structural unit [D] represented by the general formula [5], further if necessary a structural unit [E] represented by the general formula [7], furthermore if necessary a structural unit [F] represented by the general formula [22], and in which at least one of X¹ in the structural unit [A] represented by the general formula [1], X² in the structural unit [B] represented by the general formula [3] and X³ in the structural unit [C] represented by the general formula [4] is -O-, the constituting molar ratio of [A]/([B] and [C]) is from 20/80 to 99/1, and the ratio of the weight-average molecular weight Mw to the number-average molecular weight Mn, that is Mw/Mn is from 1.0 to 2.0 can be produced by converting a carboxylic acid functional group of a hydrogenated ring-opening metatathesis polymer having a carboxylic acid functional group obtained as described above, into an ester.

As the method of converting a carboxylic acid functional group into an ester, conventional methods can be applied. For example, esterification by a dehydrocondensation reaction with alcohols, esterification by using an ortho-alkylating agent, esterification by addition of olefins in the presence of an acid, esterification by a condensation reaction with a halide using an organic basic compound or alkoxyalkyl esterification by addition of alkyl vinyl ethers are listed. The method further includes method of converting a carboxylic acid into an acid halide by using thionyl chloride and then esterifying the acid halide by contacting with alcohol or method of esterifying a metal salt of the carboxylic acid.

As alcohols used in the esterification by a dehydrocondensation reaction with alcohols, any alcohols usually used in esterification can be used, and aliphatic alcohols such as, for example, methanol, ethanol, 1-propanol, 2-propanol, 1-butanol, 2-butanol, tert-butanol, 1-pentanol, tert-amylalcohol, 3-methyl-3-pentanol, 3-ethyl-3-pentanol, cyclopentanol, cyclopentanemethanol, 1-methylcyclopentanol, 1-ethylcyclopentanol, cyclohexanol, cyclohexylmethanol, dicyclohexylmethanol, tricyclohexylmethanol, 1-methylcyclohexanol, norborneol, 1-adamantanol, 2-adamantanol, 2-methyl-2-adamantanol or 1-adamantanemethanol are preferable. The amount of these alcohols is usually 100 mol or less, preferably from 1 to 50 mol, further preferably from 2 to 30 mol based on 1 mol of a carboxylic acid to be converted into an ester. The esterification by a dehydrocondensation reaction with alcohols is usually conducted in the presence of an acid, and examples of such an acid include hydrogen halides such as a hydrogen chloride gas, mineral acids such as sulfuric acid, phosphoric acid, hydrochloric acid or hydrobromic acid, solid acids such as heteropolyacid, Nafion^{R}, organic acids such as p-toluenesulfonic acid, trifluoroacetic acid, propionic acid, malonic acid, oxalic acid, chlorosulfonic acid · pyridine salt, trifluoroacetic acid · pyridine salt, sulfuric acid pyridine salt or p-toluenesulfonic acid · pyridine salt, Lewis acids such as boron-trifluoride etherate. The amount of these acids is usually 10 mol or less, preferably from 0.00001 to 2 mol, further preferably from 0.001 to 0.5 based on 1 mole of a carboxylic acid to be converted into an ester. Further, there can also be used methods using an acidic ion exchange resin, for example, a method of effecting solvent-reflux using a Soxhlet extraction apparatus containing a charged drying agent such as, for example, anhydrous magnesium sulfate or molecular sieve, for example, a method of allowing a dehydrating agent such as DCC and the like to co-exist, a method using an extremely surplus amount of alcohol, and other methods.

As the alkylating agent used in the esterification by an ortho-alkylating agent, any alkylating agents usually used in esterification of a carboxylic acid can be used, and for example, diazoalkanes such as diazomethane, or, trialkyl orthocarboxylates such as, for example, triethyl orthoformate or trimethyl orthoacetate, are preferable. The amount of these alkylating agents is usually 50 mol or less, preferably from 1 to 30 mol, further preferably from 2 to 20 mol based on 1 mol of a carboxylic acid to be converted into an ester.

As the olefins used in the esterification by addition of olefins in the presence of an acid, any olefins usually used in esterification can be used, and for example, aliphatic alkenes such as, for example, 2-methylpropene, 2-methyl-1-butene, 2-ethyl-1-butene, 2-methyl-2-butene, 3-methyl-2-pentene, 1-methyl-1-cyclopentene, 1-methyl-1-cyclohexene, methylenecyclopentane, methylenecyclohexane or ethylidenecyclohexane are preferable. The amount of these olefins is usually 100 mol or less, preferably from 1 to 50 mol, further preferably from 2 to 30 mol based on 1 mol of a carboxylic acid to be converted into an ester. The esterification by addition of olefins is conducted in the presence of an acid, and examples of such an acid include hydrogen halides such as a hydrogen chloride gas, mineral acids such as sulfuric acid, phosphoric acid, hydrochloric acid or hydrobromic acid, solid acids such as heteropolyacid or Nafion^{R}, organic acids such as p-toluenesulfonic acid, trifluoroacetic acid, propionic acid, malonic acid, oxalic acid, chlorosulfonic acid·pyridine salt, trifluoroacetic acid · pyridine salt, sulfuric acid · pyridine salt or p-toluenesulfonic acid · pyridine salt, Lewis acids such as boron-trifluoride etherate. The amount of these acids is usually 10 mol or less, preferably from 0.00001 to 2 mol, further preferably from 0.001 to 0.5 based on 1 mole of a carboxylic acid to be converted into an ester.

As the alkyl vinyl ethers used in the alkoxyalkylesterification by addition of alkyl vinyl ethers, alkoxy-substituted, non-substituted or cyclic alkyl vinyl ethers such as, for example, methyl vinyl ether, ethyl vinyl ether, n-propyl vinyl ether, isopropyl vinyl ether, n-butyl vinyl ether, sec-butyl vinyl ether, tert-butyl vinyl ether, isooctyl vinyl ether, decyl vinyl ether, dodecyl vinyl ether, cyclohexyl vinyl ether, 2-ethylhexyl vinyl ether, tert-pentyl vinyl ether, octadecyl vinyl ether, cesyl vinyl ether, 2-methoxyethyl vinyl ether, vinyl-2-(2-ethoxyethoxy) ethyl ether, ethylene glycol butyl vinyl ether, tert-amyl vinyl ether, 2,3-dihydrofuran, 3,4-dihydro-2H-pyrane, or 1,4-dioxene are preferable. Further, among them ethyl vinyl ether, n-propyl vinyl ether, isopropyl vinyl ether, n-butyl vinyl ether, 2,3-dihydrofuran, 3,4-dihydro-2H-pyrane are more preferable. The amount of these alkyl vinyl ethers is usually 50 mol or less, preferably from 1 to 30 mol, further preferably from 2 to 20 mol based on 1 mol of a carboxylic acid to be converted into an ester.

The alkoxyalkylesterification by addition of alkyl vinyl ethers is conducted usually in the presence of an acid, and examples of such an acid include hydrogen halides such as a hydrogen chloride gas, mineral acids such as sulfuric acid, phosphoric acid, hydrochloric acid or hydrobromic acid, solid acids such as heteropolyacid or Nafion^{R}, organic acids such as p-toluenesulfonic acid, trifluoroacetic acid, propionic acid, malonic acid, oxalic acid, chlorosulfonic acid · pyridine salt, trifluoroacetic acid · pyridine salt, sulfuric acid · pyridine salt, p-toluenesulfonic acid · pyridine salt and the like, and among them, a hydrogen chloride gas, hydrochloric acid, trifluoroacetic acid, trifluoroacetic acid·pyridine salt, p-toluenesulfonic acid·pyridine salt and sulfuric acid·pyridine salt are preferably used. These acids can be used alone or in combination of two or more, and simultaneously or sequentially. The amount of these acid catalysts is usually 10 mol or less, preferably from 0.00001 to 2 mol, further preferably from 0.001 to 0.5 based on 1 mole of a carboxylic acid to be converted into an ester.

In the method of converting a carboxylic acid functional group into an ester in the method of the present invention, a solvent is usually used. These solvents differ depending e.g. on the method used and the kind of the intended ester, and any of an aqueous solvent and organic solvents may be used. Particularly, the organic solvent used includes, for example, alcohols such as methanol, ethanol; ketones such as acetone; ethers such as tetrahydrofuran, diethyl ether, dibutyl ether, dimethoxyethane or dioxane; aromatic hydrocarbons such as benzene, toluene, xylene or ethylbenzene; aliphatic hydrocarbons such as pentane, hexane, heptane or cyclohexane; carboxylic acids such as acetic acid; nitro compounds such as nitromethane; pyridines such as pyridine or lutidine; formamides such as dimethylformamide. These organic solvents may be used in combination with water and alcohols, or used alone. Furthermore, two or more kinds of them may also be used. The reaction temperature is usually from 0 to 200°C, preferably from 10 to 150°C, more preferably from a room temperature to 200°C. The reaction time is usually from 1 minute to 100 hours, preferably from 5 minutes to 30 hours, more preferably from 10 minutes to 20 hours.

Embodiments of converting the carboxylic acid functional group into an ester in the method of the present invention are not particularly restricted, and any embodiment is permissible providing converting of the carboxylic acid functional group into an ester can be carried out effectively. Any embodiments under an inert gas atmosphere such as nitrogen and the like, under an air atmosphere, or at reduced pressure, normal pressure, increased pressure, or by batch-wise, semibatch-wise or continuous mode may be admitted.

Further, after conversion of a carboxylic acid functional group into an ester, neutralization treatment may be effected appropriately with an alkali or acid. After conversion of a carboxylic acid functional group into an ester, the method of recovering a polymer from a solution or slurry of the hydrogenated ring-opening metathesis polymer is not particularly restricted, and a known method can be used. In the case of the solution, the method includes, for example, a method of discharging a reaction solution in a poor solvent under stirring to precipitate a hydrogenated polymer and recovering by filtration, centrifugation or decantation process, a steam stripping method of bubbling steam in a reaction solution to precipitate a polymer, and a method of directly removing a solvent from the reaction solution by heating. In the case of the slurry, the method includes, for example, a method of recovering as it is by filtration, centrifugation or decantation process.

The above-mentioned methods can produce a hydrogenated ring-opening metathesis polymer which comprises a structural unit [A] represented by the general formula [1], comprises a structural unit [B] represented by the general formula [3] and/or a structural unit [C] represented by the general formula [4], if necessary a structural unit [D] represented by the general formula [5], further if necessary a structural unit [E] represented by the general formula [7], furthermore if necessary a structural unit [F] represented by the general formula [22]; and in which at least one of X¹ in the structural unit [A] represented by the general formula [1], X² in the structural unit [B] represented by the general formula [3] and X³ in the structural unit [C] represented by the general formula [4] is -O-; and the constituting molar ratio of [A]/([B] and [C]) is from 20/80 to 99/1; and the ratio of the weight-average molecular weight Mw to the number-average molecular weight Mn, that is Mw/Mn is from 1.0 to 2.0.

The hydrogenated ring-opening metathesis polymer of the present invention is useful as a base polymer for a photoresist. For example, it is used as a positive resist composition, together with a photoacid generator and a solvent. The photoacid generator refers to a substance which generates Brφnsted acid or Lewis acid when exposed to an activating radiation ray. Further, into a resist composition, a dissolution inhibitor, surfactant, preservation stabilizer, sensitizer, striation preventing agent and the like can be added. This resist composition can be, for example, applied to the surface of a substrate such as a silicon wafer by a conventional method such as spin coating before removal of a solvent by drying, to form a resist film, and exposure for pattern formation is effected by irradiating a resist film with far ultraviolet ray, KrF excimer laser, ArF excimer laser, electron beam, and if thermal treatment (bake after exposure) is further conducted, further high sensitization can be carried out. Then, the exposed part is washed off by a developer such as an alkali aqueous solution, to obtain a relief pattern. A relief pattern formed by using a hydrogenated ring-opening metathesis polymer of the present invention is extremely excellent in both of resolution and contrast. Further, a substrate can be etched by using a pattern formed as described above as a mask.

In the present invention, the molar ratio of a structural unit [A] represented by the general formula [1] to a structural unit [B] represented by the general formula [2] and/or a structural unit [C] represented by the general formula [4] ([A]/([B] and [C])) is from 20/80 to 99/1. Here, the structural unit [A] contains a tertiary ester group of a cyclic alkyl which is a group decomposed by an acid generated from a sensitizing agent in exposure, and necessary for making a resist pattern by development with an alkali aqueous solution, after exposure, and the structural units [B] and [C] are necessary for manifesting adhesion with a treating substrate such as a silicon substrate. If this molar ratio [A]/([B] and [C]) is less than 20/80, development is insufficient, and if over 99/1, adhesion with a treating substrate is not manifested. The structural unit [D] of the general formula [6] contains a carboxyl group, and can improved adhesion with a treating substrate such as a silicon substrate and can improve solubility into a solvent. Further, if the molar ratio of the structural units [A], [B] and [C] to the structural unit [D] ([A]+[B]+[C])/[D] is from 100/0 to 20/80, wet tension is improved in development with an alkali aqueous solution after exposure, and development irregularity is resolved. This range including these structural units is suitable for preparing a resist composition, and is extremely important for a resist material which is dissolved together with a sensitizing agent having high polarity into a polar solvent such as, for example, 2-heptanone and applied to a treating substrate such as a silicon substrate. Namely, a uniform and smooth coating film can be formed by enhancing the solubility in a polar solvent or the dissolving speed, in preparing a resist composition using a hydrogenated ring-opening metathesis polymer. Further, inclusion of the structural unit [E] in addition to the structural units [A] and [B] and/or [C] indicates inclusion of an ester group having different reactivity from that of an ester group contained in the structural unit [A], and is useful since, consequently, decomposing property in exposure can be freely controlled. In this case, the preferable molar ratio of the structural units ([A]+[B]+[C])/[E] is from 100/0 to 40/60.

Further, particularly a hydrogenated ring-opening metathesis polymer in which at least one of X¹ in the structural unit [A] represented by the general formula [1], X² in the structural unit [B] represented by the general formula [3] and X³ in the structural unit [C] represented by the general formula [4] is -O- and the others are -CH₂- has effects of improving adhesion to a treating substrate such as a silicon substrate, improving wet tension in development with an alkali aqueous solution, and further improving solubility into a polar organic solvent of ketones or alcohols used in a process of applying a resist agent onto a silicon wafer. Further, affinity to water is also improved, and developing property with a releasing agent (or developer) such as an alkali aqueous solution after exposure is also improved.

The following examples illustrate the present invention in detail below, but do not restrict the scope of the invention.

Values of the physical properties of polymers obtained in examples were measured according to the following methods.

Average molecular weight; The resulted cyclic olefin ring-opening metathesis polymer and a hydrogenated material of this polymer were dissolved in tetrahydrofuran, and the molecular weight was calibrated by GPC, using 830-RI and 875-UV manufactured by JASCO Corporation as a detector and Shodex k-805, 804, 803, 802.5 as a column, at room temperature and a flow rate of 1.0 ml/min. and utilizing polystyrene standard.

Hydrogenating rate; A powder of a hydrogenated cyclic olefin ring-opening metathesis polymer was dissolved in deuterated chloroform, and reduction degree of the peak assigned to a carbon-carbon double bond in the main chain at δ=4.0 to 6.5 ppm due to the hydrogenation reaction was calculated by using 270 MHz-¹H NMR.

The proportion of carboxylic acid contained in the polymer; It was measured by neutralization titration using Bromothymol Blue as an indicator.

UV absorption spectrum; A solution was applied onto a quartz glass plate by using a spin coater at a rotation of 3000 rpm to give a film thickness of 1.0 µm, and the UV absorption spectrum was measured by Shimadzu UV-3100.

Adhesion strength to a silicon wafer substrate; A solution was likewise applied onto a substrate by a spin coater, and the resulting polymer film was baked for 10 minutes at 120°C, and scratched to form cross cut according to the test method of JIS D0202, peeling was effected with a adhesive cellophane tape, and peeled states were observed visually.

Criteria: ⊚: peeling of less than 5%, ○: peeling of 5 to 20%, Δ: peeling of 20 to 50%, ×: peeling of 50% or more

### Example 1

In a 300 ml Schlenk flask, 3,6-epoxy-1,2,3,6-tetrahydrophthalide (2.43 g, 16 mmol) and 8-(1'-ethylcyclopentoxy)carbonyltetracyclo[4.4.0.12, 5.17, 10]-3-dodecene (7.21 g, 24 mmol) were dissolved, as cyclic olefin monomers, in tetrahydrofuran (hereinafter, referred to as THF), under a nitrogen atmosphere. To this was added W(N-2,6-Me₂C₆H₃)(CHCHCMe₂)(OC(CF₃)₂Me)₂(PMe₃) (462 mg, 0.57 mmol) as a ring-opening metathesis polymerization catalyst, and the mixture was reacted for 1 hour at room temperature. Then, butylaldehyde (205 mg, 2.85 mmol) was added and the mixture was stirred for 30 minutes to terminate the reaction.

This ring-opening metathesis polymer solution was added into methanol to precipitate a ring-opening metathesis polymer, which was filtrated, washed with methanol, and dried in vacuo, to give 9.46 g of a ring-opening metathesis polymer powder.

Then, in a 200 ml autoclave, 9.0 g of this ring-opening metathesis polymer powder was dissolved in THF (100 ml), and to this was added a previously prepared solution of dichlorotetrakis(triphenylphosphine) ruthenium (27 mg, 0.022 mol) and triethylamine (11.3 mg, 0.108 mmol) in THF (20 ml) as a hydrogenation catalyst, and a hydrogenation reaction was conducted for 5 hours at a hydrogen pressure of 8.1 MPa and a temperature of 165°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 8.0 g of a hydrogenated ring-opening metathesis polymer in the form of a white powder. The hydrogenating rate calculated from ¹H-NMR of the resulted hydrogenated ring-opening metathesis polymer did not manifest a peak assigned to a proton of an olefin in the main chain, and the hydrogenating rate was 100%, and the number-average molecular weight Mn as polystyrene standard measured by GPC was 37,600 and Mw/Mn was 1.10. The composition ratio of the structural units [A]/[B] in the resulted polymer was 60/40. The ¹H-NMR spectrum (270 MHz, solvent: deuterated chloroform) of the hydrogenated ring-opening metathesis polymer obtained in Example 1 is shown in Fig. 1.

### Example 2

Ring-opening metathesis polymerization was conducted in the same manner as in Example 1 except that the cyclic olefin monomers were changed to 6,9-methylene-2-oxaspiro[4,5]7-decen-1-one (1.31 g, 8 mmol), 3,6-epoxy-1,2,3,6-tetrahydrophthalide (1.83 g, 12 mmol) and 8-(1'-ethylcyclopentoxy)carbonyltetracyclo[4.4.0.12, 5.17, 10]-3-dodecene (6.01 g, 20 mmol) in Example 1, to give 9.10 g of a ring-opening metathesis polymer.

Further, 9.0 g of the resulted ring-opening metathesis polymer was subjected to a hydrogenation reaction for 5 hours at a hydrogen pressure of 8.1 MPa and a temperature of 165°C in the same manner as in Example 1, to provide 8.4 g of a hydrogenated ring-opening metathesis polymer in the form of a white powder. The hydrogenating rate calculated from ¹H-NMR of the resulted hydrogenated ring-opening metathesis polymer did not manifest a peak assigned to a proton of an olefin in the main chain, and the hydrogenating rate was 100%, and the number-average molecular weight Mn as polystyrene standard measured by GPC was 35,600 and Mw/Mn was 1.20. The composition ratio of the structural units [A]/[B]/[C] in the resulted polymer was 50/30/20.

### Example 3

Ring-opening metathesis polymerization was conducted in the same manner as in Example 1 except that the ring-opening metathesis polymerization catalyst was changed to Mo(N-2,6-iPr₂C₆H₃)(CHCMe₃)(OC(CF₃)₂Me)₂ (198 mg, 0.286 mmol), to give 9.25 g of a ring-opening metathesis polymer.

Then, in a 200 ml autoclave, 9.0 g of this ring-opening metathesis polymer powder was dissolved in THF (100 ml), and to this was added a previously prepared solution of chlorohydridecarbonyltris(triphenylphosphine) ruthenium (27 mg, 0.022 mol) and triethylamine (11.3 mg, 0.108 mmol) in THF (20 ml) as a hydrogenation catalyst, and a hydrogenation reaction was conducted for 5 hours at a hydrogen pressure of 8.1 MPa and a temperature of 165°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 8.1 g of a hydrogenated ring-opening metathesis polymer in the form of a white powder. The hydrogenating rate calculated from ¹H-NMR of the resulted hydrogenated ring-opening metathesis polymer did not manifest a peak assigned to a proton of an olefin in the main chain, and the hydrogenating rate was 100%, and the number-average molecular weight Mn as polystyrene standard measured by GPC was 75,200 and Mw/Mn was 1.15. The composition ratio of the structural units [A]/[B] in the resulted polymer was 60/40.

### Example 4

Ring-opening metathesis polymerization was conducted in the same manner as in Example 2 except that the ring-opening metathesis polymerization catalyst was changed to Ru(P(C₆H₁₁)₃)₂(CHPh)Cl₂ (470 mg, 0.57 mmol), to give 9.0 g of a ring-opening metathesis polymer.

Further, 9.0 g of the resulted ring-opening metathesis polymer was subjected to a hydrogenation reaction for 5 hours at a hydrogen pressure of 8.1 MPa and a temperature of 165°C in the same manner as in Example 2, to provide 8.6 g of a hydrogenated ring-opening metathesis polymer in the form of a white powder. The hydrogenating rate calculated from ¹H-NMR of the resulted hydrogenated ring-opening metathesis polymer did not manifest a peak assigned to a proton of an olefin in the main chain, and the hydrogenating rate was 100%, and the number-average molecular weight Mn as polystyrene standard measured by GPC was 33,100 and Mw/Mn was 1.37. The composition ratio of the structural units [A]/[B]/[C] in the resulted polymer was 50/30/20.

### Example 5

In a 1000 ml autoclave equipped with a magnetic stirrer, 3,6-epoxy-1,2,3,6-tetrahydrophthalide (17.0 g, 111.7 mmol) and 8-(1'-ethylcyclopentoxy)carbonyltetracyclo[4.4.0.12, 5.17, 10]-3-dodecene (33.57 g, 111.7 mmol) were dissolved, as cyclic olefin monomers, in tetrahydrofuran (550 ml), under a nitrogen atmosphere. To this was added 1,5-hexadiene (1.5 ml, 12.3 mmol) as a chain transfer agent and Mo(N-2,6-iPr₂C₆H₃)(CHCMe₂)(OC(CF₃)₂Me)₂ (786 mg, 1,12 mmol) as a ring-opening metathesis polymerization catalyst, and they were reacted for 2 hours at room temperature. Then, butylaldehyde (404 mg, 5.60 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 42.5 g of a ring-opening metathesis polymer powder.

Then, in a 1000 ml autoclave, 40.0 g of this ring-opening metathesis polymer powder was dissolved in THF (400 ml), and to this was added a previously prepared solution of chlorohydridecarbonyltris(triphenylphosphine) ruthenium (20 mg, 0.02 mol) in THF (20 ml) as a hydrogenation catalyst, and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 38.5 g of a hydrogenated ring-opening metathesis polymer in the form of a white powder. The hydrogenating rate calculated from ¹H-NMR of the resulted hydrogenated ring-opening metathesis polymer did not manifest a peak assigned to a proton of an olefin in the main chain, and the hydrogenating rate was 100%, and the number-average molecular weight Mn as polystyrene standard measured by GPC was 8260 and Mw/Mn was 1.32. The composition ratio of the structural units [A]/[B] in the resulted polymer was 50/50.

### Example 6

In a 1000 ml autoclave equipped with a magnetic stirrer, 3,6-epoxy-1,2,3,6-tetrahydrodimethylphthalide (11.41 g, 75.0 mmol) and 8-(2'-ethyl-2'-norbornyloxy)carbonyltetracyclo[4.4.0.12, 5.17, 10]-3-dodecene (36.73 g, 112.5 mmol) were dissolved, as cyclic olefin monomers, in tetrahydrofuran (500 ml), under a nitrogen atmosphere. To this was added 1,6-heptadiene (3.17 ml, 23.41 mmol) as a chain transfer agent and W(N-2,6-iPr₂C₆H₃)(CHCMe₂)(OC(CF₃)₂Me)₂ (740 mg, 0.935 mmol) as a ring-opening metathesis polymerization catalyst, and they were reacted for 3 hours at room temperature. Then, butylaldehyde (360 mg, 5.00 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 48.9 g of a ring-opening metathesis polymer powder.

Then, into a 500 ml autoclave, 40.0 g of this ring-opening metathesis polymer powder, 5% palladium carbon (5.0 g, 2.35 mmol as palladium) as a hydrogenation catalyst, and THF (300 ml) as a solvent were added, and a hydrogenation reaction was conducted for 24 hours at a hydrogen pressure of 8.0 MPa and a temperature of 120°C, then, the temperature was returned to room temperature, and a hydrogen gas was discharged. After removal of palladium carbon used as a catalyst by filtration, this hydrogenated ring-opening metathesis polymer solution was added into methanol to precipitate a hydrogenated ring-opening metathesis polymer which was separated by filtration and subjected to vacuum drying to provide 39.1 g of a hydrogenated ring-opening metathesis polymer in the form of a white powder. The hydrogenating rate calculated from ¹H-NMR of the resulted hydrogenated ring-opening metathesis polymer was 99%, and the number-average molecular weight Mn as polystyrene standard measured by GPC was 4690 and Mw/Mn was 1.38. The composition ratio of the structural units [A]/[B] in the resulted polymer was 60/40.

### Example 7

In a 1000 ml autoclave equipped with a magnetic stirrer, 3,6-epoxy-1,2,3,6-tetrahydromonomethylphthalide (19.94 g, 120.0 mmol) and 8-(2'-ethyl-2'-adamantyloxy)carbonyltetracyclo[4.4.0.12, 5.17, 10]-3-dodecene (28.20 g, 80.0 mmol) were dissolved, as cyclic olefin monomers, in 600 ml of toluene, under a nitrogen atmosphere. To this was added 1-octene (10.3 ml, 65.0 mmol) as a chain transfer agent and Re(CBu^{t})(CHBu^{t})(OC(CF₃)₂Me)₂ (687.6 mg, 1.00 mmol) as a ring-opening metathesis polymerization catalyst, and they were reacted for 6 hours at 50°C. Then, butylaldehyde (360 mg, 5.00 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 46.3 g of a ring-opening metathesis polymer powder.

Then, into a 1000 ml autoclave, 40.0 g of this ring-opening metathesis polymer powder, dihydridetetrakis(triphenylphosphine) ruthenium (12.0 mg, 0.013 mmol) and triethylamine (4.05 mg, 0.04 mmol) as hydrogenation catalysts, and toluene (600 ml) as a solvent were added, and a hydrogenation reaction was conducted for 24 hours at a hydrogen pressure of 8.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 38.8 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 2880 and Mw/Mn was 1.42. The composition ratio of the structural units [A]/[B] in the resulted polymer was 40/60.

### Example 8

20.0 g of the hydrogenated ring-opening metathesis polymer obtained in Example 5 was added to a solution of 5.0 ml of trifluoroacetic acid in 1000 ml of toluene, in a 2000 ml eggplant form flask, and the mixture was stirred for 3 hours at 70°C, the solvent was removed, then, the resulted mixture was further dissolved in THF and added into methanol to form a precipitate which was filtrated and dried in vacuo to obtain 17.8 g of a hydrogenated ring-opening metathesis polymer partially ester-decomposed in the form of a white powder. The composition ratio of the structural units [A]/[B]/[D] in the resulted polymer was 30/50/20, and the number-average molecular weight Mn measured by GPC was 8150, and Mw/Mn was 1.33.

### Example 9

15.0 g of the hydrogenated ring-opening metathesis polymer obtained in Example 6 was added to a solution of 5.0 ml of trifluoroacetic acid in 1000 ml of benzene, in a 2000 ml eggplant form ask, and the mixture was stirred for 2 hours at 70°C, the solvent was removed, then, the resulted mixture was further dissolved in THF and added into methanol to form a precipitate which was filtrated and dried in vacuo to obtain 13.1 g of a hydrogenated ring-opening metathesis polymer partially ester-decomposed in the form of a white powder. The composition ratio of the structural units [A]/[B]/[D] in the resulted polymer was 40/40/20, and the number-average molecular weight Mn measured by GPC was 4490, and Mw/Mn was 1.35.

### Example 10

15.0 g of the hydrogenated ring-opening metathesis polymer obtained in Example 7 was added to a solution of 10.0 ml of concentrated hydrochloric acid in 1000 ml of THF, in a 2000 ml eggplant form flask, and the mixture was stirred for 6 hours at 60°C, the resulted mixture was added into methanol to form a precipitate which was filtrated and dried in vacuo to obtain 13.0 g of a hydrogenated ring-opening metathesis polymer partially ester-decomposed in the form of a white powder. The composition ratio of the structural units [A]/[B]/[D] in the resulted polymer was 25/60/15, and the number-average molecular weight Mn measured by GPC was 2810, and Mw/Mn was 1.39.

### Example 11

In a 500 ml autoclave equipped with a magnetic stirrer, 3,6-epoxy-1,2,3,6-tetrahydrophthalide (9.89 g, 65.0 mmol), 8-(1'-ethylcyclopentoxy)carbonyltetracyclo[4.4.0.12, 5.17, 10]-3-dodecene (11.72 g, 39.0 mmol) and 8-tert-butoxycarbonyltetracyclo[4.4.0.12, 5.17, 10]-3-decene (6.77 g, 26.0 mmol) were dissolved, as cyclic olefin monomers, in 300 ml of tetrahydrofuran, under a nitrogen atmosphere. To this was added 1,5-hexadiene (0.75 ml, 6.5 mmol) as a chain transfer agent and Mo(N-2,6-iPr₂C₆H₃)(CHCMe₂Ph)(OC(CF₃)₂Me)₂ (536 mg, 0.70 mmol) as a ring-opening metathesis polymerization catalyst, and they were reacted for 2 hours at room temperature. Then, butylaldehyde (250 mg, 3.47 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 26.6 g of a ring-opening metathesis polymer powder.

Then, in a 500 ml autoclave, 20.0 g of this ring-opening metathesis polymer powder was dissolved in THF (300 ml), and to this was added a previously prepared solution of triethylamine (11.74 mg, 0.116 mmol) and dichlorotris(triphenylphosphine)osmium (30.0 mg, 0.029 mmol) in THF (20 ml) as a hydrogenation catalyst, and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 18.8 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 9110 and Mw/Mn was 1.43. The composition ratio of the structural units [A]/[B]/[E] in the resulted polymer was 30/50/20.

### Example 12

In a 500 ml autoclave equipped with a magnetic stirrer, 3,6-epoxy-1,2,3,6-tetrahydrophthalide (9.13 g, 60.0 mmol), 8-(1'-ethylcyclopentoxy)carbonyltetracyclo[4.4.0.12, 5.17, 10]-3-dodecene (14.42 g, 48.0 mmol) and 8-methoxycarbonyltetracyclo[4.4.0.12, 5.17, 10]-3-decene (2.62 g, 12.0 mmol) were dissolved, as cyclic olefin monomers, in 350 ml of toluene, under a nitrogen atmosphere. To this was added 1,5-hexadiene (0.70 ml, 6.0 mmol) as a chain transfer agent and W(N-2,6-Me₂C₆H₃)(CHCHCMe₂)(OC(CF₃)₂Me)₂ (440 mg, 0.60 mmol) as a ring-opening metathesis polymerization catalyst, and they were reacted for 5 hours at room temperature. Then, butylaldehyde (216 mg, 3.0 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 24.7 g of a ring-opening metathesis polymer powder.

Then, in a 500 ml autoclave, 20.0 g of this ring-opening metathesis polymer powder was dissolved in toluene (350 ml), and to this was added a solution of dichlorobis-(triphenylphosphine) palladium (66.0 mg, 0.094 mmol) in toluene (30 ml) as a hydrogenation catalyst, and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 17.9 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 8810 and Mw/Mn was 1.24. The composition ratio of the structural units [A]/[B]/[E] in the resulted polymer was 40/50/10.

### Example 13

9.0 g of the hydrogenated ring-opening metathesis polymer obtained in Example 12 was added to 400 ml of a 5% potassium hydroxide methanol aqueous solution, in a 1000 ml flask, and the mixture was stirred for 3 hours at 80°C, then, the mixture was added into 1000 ml of a 2% hydrochloric acid aqueous solution for neutralization to form a precipitate which was filtrated, washed with water and dried in vacuo to obtain 8.4 g of a hydrogenated ring-opening metathesis polymer partially hydrolyzed in the form of a white powder. The composition ratio of the structural units [A]/[B]/[D] in the resulted polymer was 40/50/10, and the number-average molecular weight Mn measured by GPC was 8730, and Mw/Mn was 1.25.

### Example 14

In a 500 ml autoclave equipped with a magnetic stirrer, 3,6-epoxy-1,2,3,6-tetrahydrophthalide (9.13 g, 60.0 mmol), 8-(1'-ethylcyclopentoxy)carbonyltetracyclo[4.4.0.12, 5.17, 10]-3-dodecene (9.01 g, 30.0 mmol) and 8-(tetrahydropyran-2'-yl)oxycarbonyltetracyclo-[4.4.0.1^{2.5}.1^{7.10}]-3-decene (8.65 g, 30.0 mmol) were dissolved, as cyclic olefin monomers, in 320 ml of THF, under a nitrogen atmosphere. To this was added 1,5-hexadiene (0.70 ml, 6.0 mmol) as a chain transfer agent and W(N-2,6-Me₂C₆H₃)(CHCHCMe₂)(OBu^{t})₂-(PMe₃) (356 mg, 0.60 mmol) as a ring-opening metathesis polymerization catalyst, and they were reacted for 5 hours at room temperature. Then, butylaldehyde (216 mg, 3.0 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 24.3 g of a ring-opening metathesis polymer powder.

Then, in a 500 ml autoclave, 20.0 g of this ring-opening metathesis polymer powder was dissolved in THF (300 ml), and to this was added a solution of chlorotris(triphenylphosphine) rhodium (91.0 mg, 0.10 mmol) as a hydrogenation catalyst in THF (30 ml), and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 17.1 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 9620 and Mw/Mn was 1.19. The composition ratio of the structural units [A]/[B]/[E] in the resulted polymer was 25/50/25.

### Example 15

8.0 g of the hydrogenated ring-opening metathesis polymer obtained in Example 14 was added to a solution of 3.0 ml of trifluoroacetic acid in 500 ml of toluene, in a 1000 ml eggplant form flask, and the mixture was stirred for 3 hours at 30°C, the solvent was distilled off, and the resulted mixture was further dissolved in THF and added into methanol to form a precipitate which was filtrated, and dried in vacuo to obtain 6.8 g of a white powder. As a result of NMR analysis, the product was a hydrogenated ring-opening metathesis polymer in which only a tetrahydropyranyl group had been ester-decomposed. The composition ratio of the structural units [A]/[B]/[D] in the resulted polymer was 25/50/25, and the number-average molecular weight Mn measured by GPC was 9060, and Mw/Mn was 1.21.

### Example 16

In a 500 ml three-necked eggplant form flask equipped with a 100 ml dropping funnel, stirred and three-way cock, 8.0 g of the hydrogenated ring-opening metathesis polymer partially ester-decomposed obtained in Example 8 was added under a nitrogen atmosphere flow to a solution of 80 mg of p-toluenesulfonic acid·pyridine salt in 200 ml of toluene, to this was added dropwise a solution of 5,6-dihydropyran (10 g) in 70 ml of toluene over about 1 hour while stirring at 25°C, and after completion of addition, the mixture was stirred for 2 hours at 25°C. After removal of the solvent, the resulted mixture was further dissolved in THF and added into methanol to give a precipitate which was filtrated and subjected to drying under reduced pressure to obtain 6.6 g of a hydrogenated ring-opening metathesis polymer partially esterified in the form of a while powder. The composition ratio of the structural units [A]/[B]/[D]/[E] in the resulted polymer was 30/50/5/15, and the number-average molecular weight Mn measured by GPC was 8200, and Mw/Mn was 1.33.

### Example 17

In a 500 ml autoclave equipped with a magnetic stirrer, 4-oxatricyclo[5.2.1.0^{2.6}]dec-8-en-3-one (4.51 g, 30.0 mmol), 8-(1'-ethylcyclopentoxy)carbonyltetracyclo[4.4.0.12, 5.17, 10]-3-dodecene (12.02 g, 40.0 mmol) and 5-(1'-ethylcyclopentoxy)carbonyl-6-methoxycarbonyl-7-oxabicyclo-[2.2.1]hept-2-ene (8.83 g, 30.0 mmol) were dissolved, as cyclic olefin monomers, in 350 ml of THF, under a nitrogen atmosphere. To this was added 1-hexene (0.42 ml, 3.5 mmol) as a chain transfer agent and W(N-2,6-iPr₂C₆H₃)(CHCMe₃)-(OBu^{t})₂ (288 mg, 0.50 mmol) as a ring-opening metathesis polymerization catalyst, and they were reacted for 5 hours at room temperature. Then, butylaldehyde (180 mg, 2.5 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 23.3 g of a ring-opening metathesis polymer powder.

Then, in a 1000 ml autoclave, 20.0 g of this ring-opening metathesis polymer powder was dissolved in THF (500 ml), and to this was added a previously prepared solution of triethylamine (4.86 mg, 0.048 mmol) and dichlorobis(tetrahydrofuran)bis(triphenylphosphine) ruthenium (4.0 mg, 0.0048 mmol) in THF (100 ml) as a hydrogenation catalyst, and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 18.1 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 12600 and Mw/Mn was 1.39. The B composition ratio of the structural units [A]/[A]'/[B] in the resulted polymer was 40/30/30.

### Example 18

In a 500 ml autoclave equipped with a magnetic stirrer, 5-oxapentacyclo-[7.4.0.0^{3.7}.1^{2.8}.1^{10.13}]-pentadec-11-en-4-one (10.81 g, 50.0 mmol) and 5-(1'-ethylcyclopentoxy)-carbonyl-7-oxabicyclo[2.2.1]hept-2-ene (11.82 g, 50.0 mmol) were dissolved, as cyclic olefin monomers, in 250 ml of THF, under a nitrogen atmosphere. To this was added 1-heptene (0.64 ml, 6.5 mmol) as a chain transfer agent and W(N-2,6-Me₂C₆H₃)(CHCHCMePh)(OBu^{t})₂(PMe₃) (328 mg, 0.50 mmol) as a ring-opening metathesis polymerization catalyst, and they were reacted for 5 hours at room temperature. Then, butylaldehyde (258 mg, 3.0 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 20.8 g of a ring-opening metathesis polymer powder.

Then, in a 500 ml autoclave, 15.0 g of this ring-opening metathesis polymer powder was dissolved in THF (300 ml), and to this was added a previously prepared solution of triethylamine (4.9 mg, 0.02 mmol) and chlorohydride-carbonyltris(triphenylphosphine) ruthenium (9.5 mg, 0.01 mmol) in THF (30 ml) as a hydrogenation catalyst, and a hydrogenation reaction was conducted for 42 hours at a hydrogen pressure of 10.0 MPa and a temperature of 80°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 12.3 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 8450 and Mw/Mn was 1.29. The composition ratio of the structural units [A]/[B] in the resulted polymer was 50/50.

### Example 19

In a 500 ml autoclave equipped with a magnetic stirrer, 3,6-epoxy-1,2,3,6-tetrahydrophthalide (11.41 g, 75.0 mmol), 8-(1'-ethylcyclopentoxy)carbonyltetracyclo[4.4.0.12, 5.17, 10]-3-dodecene (7.51 g, 25.0 mmol) and 8-(2'-ethyl-2'-norbornyloxy)carbonyltetracyclo[4.4.0.12, 5.17, 10]-3-decene (8.16 g, 25.0 mmol) were dissolved, as cyclic olefin monomers, in 300 ml of THF, under a nitrogen atmosphere. To this was added 1,5-hexadiene (1.04 ml, 9.0 mmol) as a chain transfer agent and W(N-2,6-iPr₂C₆H₃)(CHCMe₃)(OBu^{t})₂(PMe₃) (652 mg, 1.00 mmol) as a ring-opening metathesis polymerization catalyst, and they were reacted for 5 hours at room temperature. Then, butylaldehyde (432 mg, 6.0 mmol) was added and the mixture was stirred for 30 minutes to terminate the reaction.

This ring-opening metathesis polymer solution was added into methanol to precipitate a ring-opening metathesis polymer which was filtrated, washed with methanol, and dried in vacuo, to give 25.1 g of a ring-opening metathesis polymer powder.

Then, in a 1000 ml autoclave, 10.0 g of this ring-opening metathesis polymer powder was dissolved in toluene (350 ml), and to this was added a previously prepared solution of triethylamine (15.2 mg, 0.15 mmol) and dichlorotris(trimethylphosphite) ruthenium (44.8 mg, 0.10 mmol) in THF (200 ml) as a hydrogenation catalyst, and a hydrogenation reaction was conducted for 20 hours at a hydrogen pressure of 10.0 MPa and a temperature of 70°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 8.8 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 8330 and Mw/Mn was 1.44. The composition ratio of the structural units [A]/[A']/[B] in the resulted polymer was 20/20/60.

### Example 20

In a 500 ml Schlenk flask, 3,6-epoxy-1,2,3,6-tetrahydrophthalide (2.43 g, 16 mmol) and 8-(1'-ethylcyclopentoxy)carbonyl-8-methyltetracyclo[4.4.0.12, 5.17, 10]-3-dodecene (7.55 g, 24 mmol) and were dissolved, as cyclic olefin monomers, in 200 ml of tetrahydrofuran, under a nitrogen atmosphere. To this was added W(N-2,6-iPr₂C₆H₃)-(CHCHCMe₂)(OC(CF₃)₂Me)₂(PMe₃) (606 mg, 0.70 mmol) as a ring-opening metathesis polymerization catalyst, and they were reacted at room temperature for 30 minutes. Then, butylaldehyde (202 mg, 2.80 mmol) was added and the mixture was stirred for 1 hour to terminate the reaction.

This ring-opening metathesis polymer solution was added into methanol to precipitate a ring-opening metathesis polymer which was filtrated, washed with methanol, and dried in vacuo, to give 9.13 g of a ring-opening metathesis polymer powder.

Then, in a 500 ml autoclave, 9.0 g of this ring-opening metathesis polymer powder was dissolved in toluene (250 ml), and to this was added a previously prepared solution of triethylamine (11.3 mg, 0.108 mmol) and dichlorotetrakis(triphenylphosphine) ruthenium (27 mg, 0.022 mmol) in THF (50 ml) as a hydrogenation catalyst, and a hydrogenation reaction was conducted for 16 hours at a hydrogen pressure of 9.0 MPa and a temperature of 120°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 7.4 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 28,600 and Mw/Mn was 1.07. The composition ratio of the structural units [A]/[B] in the resulted polymer was 60/40.

### Example 21

In a 500 ml Schlenk flask, 3,6-epoxy-1,2,3,6-tetrahydrophthalide (4.56 g, 30.0 mmol) and 8-[(1'-ethylcyclopentoxy)carbonylmethyleneltetracyclo[4.4.0.12, 5.17, 10]-3-dodecene (6.29 g, 20.0 mmol) were dissolved, as cyclic olefin monomers, in 200 ml of tetrahydrofuran, under a nitrogen atmosphere. To this was added W(N-2,6-iPr₂C₆H₃)-(CHCHCMe₂)(OC(CF₃)₂Me)₂(PMe₃) (606 mg, 0.70 mmol) as a ring-opening metathesis polymerization catalyst, and they were reacted at room temperature for 30 minutes. Then, butylaldehyde (202 mg, 2.80 mmol) was added and the mixture was stirred for 1 hour to terminate the reaction.

This ring-opening metathesis polymer solution was added into methanol to precipitate a ring-opening metathesis polymer which was filtrated, washed with methanol, and dried in vacuo, to give 9.98 g of a ring-opening metathesis polymer powder.

Then, in a 500 ml autoclave, 9.0 g of this ring-opening metathesis polymer powder was dissolved in toluene (250 ml), and to this was added a previously prepared solution of triethylamine (10.1 mg, 0.10 mmol) and dichlorotetrakis(triphenylphosphine) ruthenium (61 mg, 0.05 mmol) in THF (250 ml) as a hydrogenation catalyst, and a hydrogenation reaction was conducted for 16 hours at a hydrogen pressure of 9.0 MPa and a temperature of 90°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 8.0 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 34,100 and Mw/Mn was 1.09. The composition ratio of the structural units [A]/[B] in the resulted polymer was 40/60.

### Example 22

In a 500 ml Schlenk flask, 3,6-epoxy-1,2,3,6-tetrahydrophthalide (1.08 g, 6.0 mmol) and 8,9-di[(1'-ethylcyclopentoxy)carbonyl]tetracyclo[4.4.0.12, 5.17, 10]-3-dodecene (6.17 g, 14.0 mmol) were dissolved, as cyclic olefin monomers, in 200 ml of tetrahydrofuran, under a nitrogen atmosphere. To this was added Mo(N-2,6-iPr₂C₆H₃)-(CHCHCMe₂)(OC(CF₃)₂Me)₂ (206 mg, 0.35 mmol) as a ring-opening metathesis polymerization catalyst, and they were reacted at room temperature for 30 minutes. Then, butylaldehyde (108 mg, 1.50 mmol) was added and the mixture was stirred for 1 hour to terminate the reaction.

This ring-opening metathesis polymer solution was added into methanol to precipitate a ring-opening metathesis polymer which was filtrated, washed with methanol, and dried in vacuo, to give 6.66 g of a ring-opening metathesis polymer powder.

Then, in a 500 ml autoclave, 6.0 g of this ring-opening metathesis polymer powder was dissolved in THF (250 ml), and to this was added a previously prepared solution of triethylamine (10.1 mg, 0.10 mmol) and dichlorotetrakis-(triphenylphosphine) ruthenium (36.6 mg, 0.03 mmol) in THF (250 ml) as a hydrogenation catalyst, and a hydrogenation reaction was conducted for 16 hours at a hydrogen pressure of 9.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 5.4 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 26,900 and Mw/Mn was 1.06. The composition ratio of the structural units [A]/[B] in the resulted polymer was 30/70.

### Example 23 (Reference)

In a 1000 ml autoclave equipped with a magnetic stirrer, 3,6-epoxy-1,2,3,6-tetrahydrophthalide (18.26 g, 120.0 mmol) and 8-tert-butoxycarbonyltetracyclo[4.4.0.1^{2,5}.1^{7,10}]-3-dodecene (31.24 g, 120.0 mmol) were dissolved, as cyclic olefin monomers, in tetrahydrofuran (550 ml), under a nitrogen atmosphere. To this was added 1,5-hexadiene (1.6 ml, 14.0 mmol) as a chain transfer agent and Mo(N-2,6-iPr₂-C₆H₃)(CHCMe₃)(OC(CF₃)₂Me)₂ (950 mg, 1.20 mmol) as a ring-opening metathesis polymerization catalyst, and they were reacted at room temperature for 2 hours. Then, butylaldehyde (433 mg, 6.0 mmol) was added and the mixture was stirred for 30 hours to terminate the reaction.

This ring-opening metathesis polymer solution was added into methanol to precipitate a ring-opening metathesis polymer which was filtrated, washed with methanol, and dried in vacuo, to give 44.4 g of a ring-opening metathesis polymer powder.

Then, in a 1000 ml autoclave, 40.0 g of this ring-opening metathesis polymer powder was dissolved in THF (400 ml), and to this was added a previously prepared solution of chlorohydridecarbonyltris(triphenylphosphine) ruthenium (20 mg, 0.02 mmol) in THF (40 ml) as a hydrogenation catalyst, and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 37.9 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 8090 and Mw/Mn was 1.36. The composition ratio of the structural units [B]/[E] in the resulted polymer was 50/50.

### Example 24 (Reference)

20.0 g of the hydrogenated ring-opening metathesis polymer obtained in Example 23 was added to a solution of 5.0 ml of trifluoroacetic acid in 1000 ml of toluene, in a 2000 ml eggplant form flask, and the mixture was stirred for 3 hours at 70°C, the solvent was distilled off, and the resulted mixture was further dissolved in THF and added into methanol to form a precipitate which was filtrated, and dried in vacuo to obtain 18.4 g of a hydrogenated ring-opening metathesis polymer partially ester-decomposed in the form of a white powder. The composition ratio of the structural units [B]/[D]/[E] in the resulted polymer was 50/13/37, and the number-average molecular weight Mn measured by GPC was 8040, and Mw/Mn was 1.36.

### Example 25 (Reference)

In a 1000 ml autoclave equipped with a magnetic stirrer, 3,6-epoxy-1,2,3,6-tetrahydrodimethylphthalide (21.62 g, 120.0 mmol) and 6,6-dimethyl-5-oxapentacyclo-[7.4.0.0^{3.7}.1^{2.8},1^{10.13}]-pentadec-11-en-4-one (29.32 g, 120.0 mmol) were dissolved, as cyclic olefin monomers, in tetrahydrofuran (550 ml), under a nitrogen atmosphere. To this was added 1,5-hexadiene (1.6 ml, 14.0 mmol) as a chain transfer agent and Mo(N-2,6-iPr₂C₆H₃)(CHCMe₃)(OC(CF₃)₂Me)₂ (950 mg, 1.20 mmol) as a ring-opening metathesis polymerization catalyst, and they were reacted at room temperature for 2 hours. Then, butylaldehyde (433 mg, 6.0 mmol) was added and the mixture was stirred for 30 hours to terminate the reaction.

This ring-opening metathesis polymer solution was added into methanol to precipitate a ring-opening metathesis polymer which was filtrated, washed with methanol, and dried in vacuo, to give 47.7 g of a ring-opening metathesis polymer powder.

Then, in a 1000 ml autoclave, 40.0 g of this ring-opening metathesis polymer powder was dissolved in THF (400 ml), and to this was added a previously prepared solution of chlorohydridecarbonyltris(triphenylphosphine) ruthenium (20 mg, 0.02 mmol) in THF (40 ml) as a hydrogenation catalyst, and a hydrogenation reaction was conducted for 20 hours at a hydrogen pressure of 6.0 MPa and a temperature of 100°C, then, the temperature was returned to room temperature, and a hydrogen gas was discharged. This hydrogenated ring-opening metathesis polymer solution was added into methanol to precipitate a hydrogenated ring-opening metathesis polymer which was separated by filtration and subjected to vacuum drying to provide 36.4 g of a hydrogenated ring-opening metathesis polymer in the form of a white powder. The hydrogenating rate calculated from ¹H-NMR of the resulted hydrogenated ring-opening metathesis polymer was 100%, and the number-average molecular weight Mn as polystyrene standard measured by GPC was 7940 and Mw/Mn was 1.31. The composition ratio of the structural units [B]/[B'] in the resulted polymer was 50/50.

Next, effects when the hydrogenated ring-opening metathesis polymers of the present invention (Polymers 1 to 22) were used as a resist material are shown by Reference Examples.

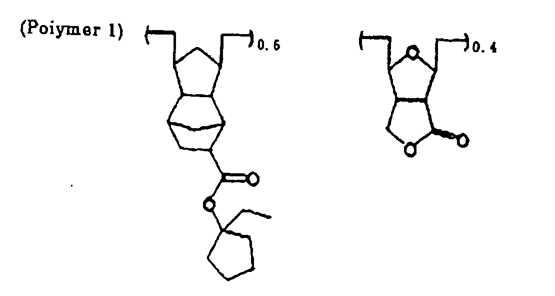

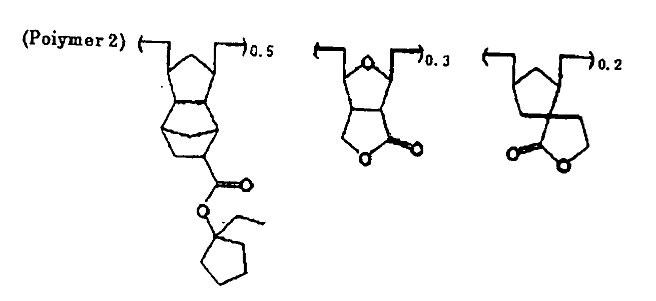

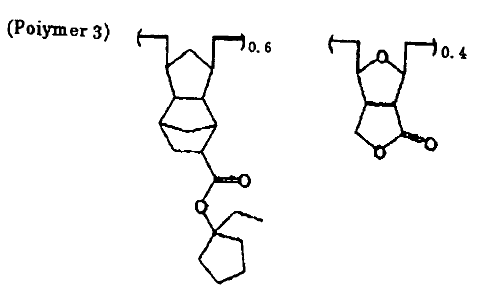

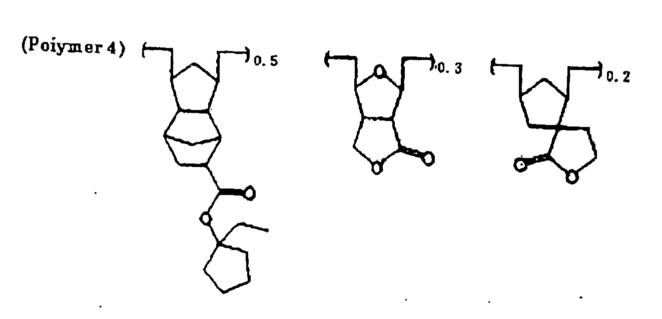

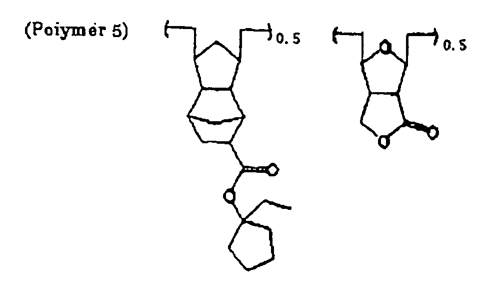

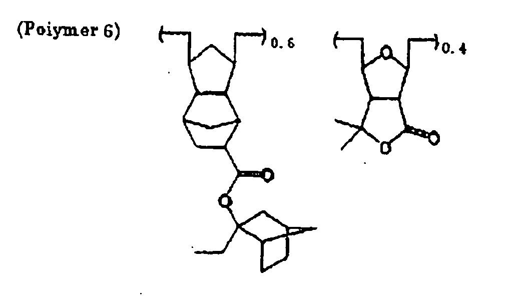

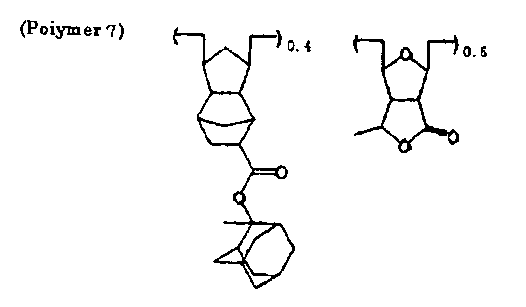

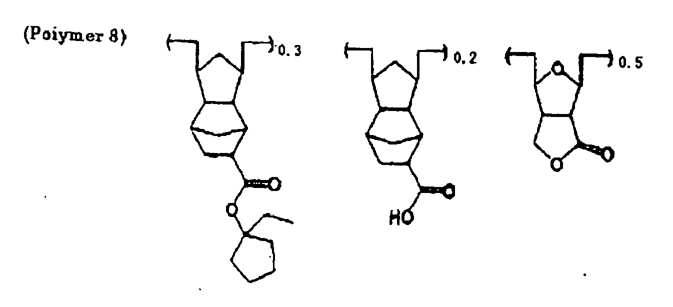

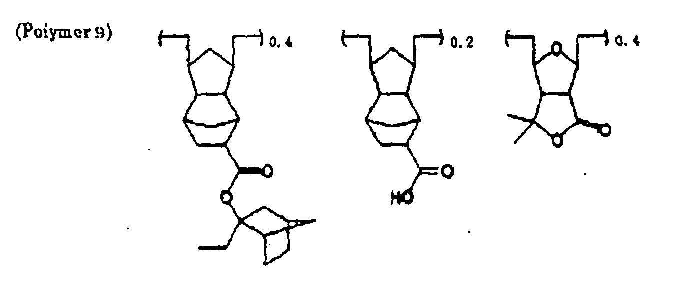

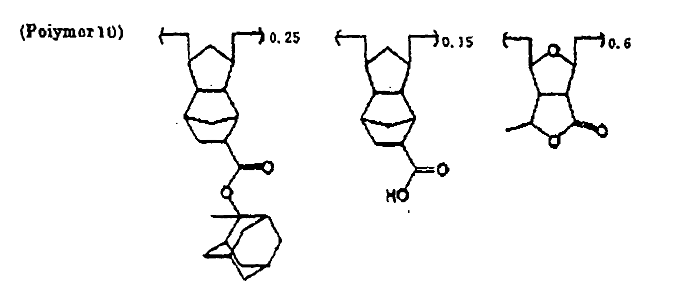

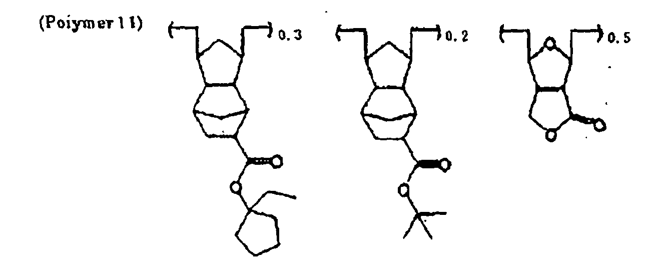

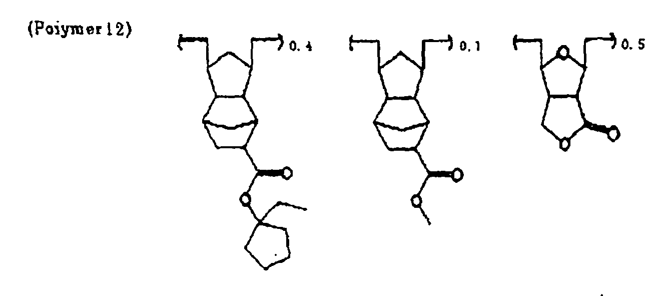

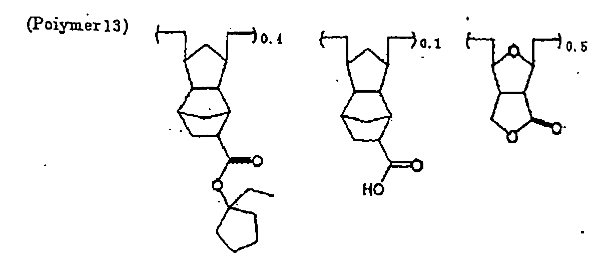

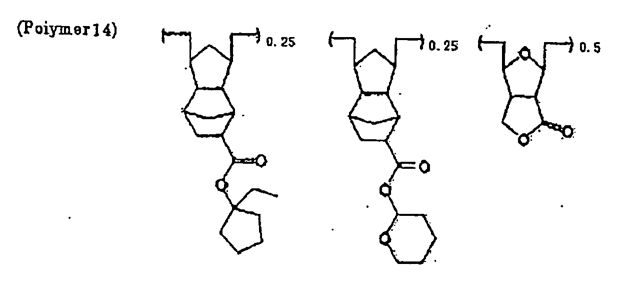

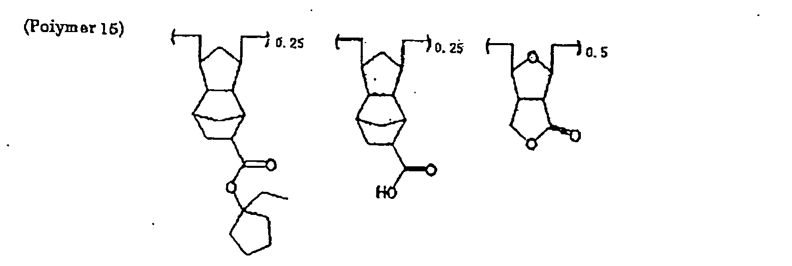

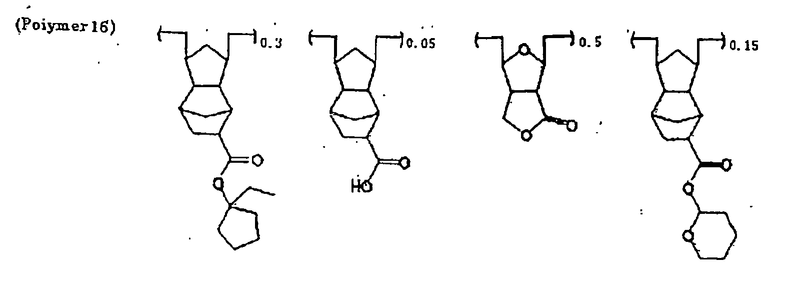

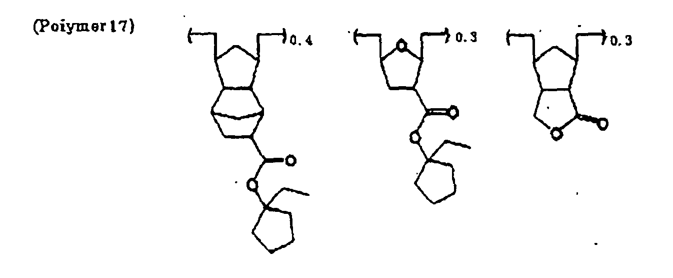

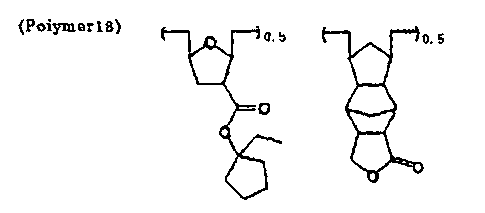

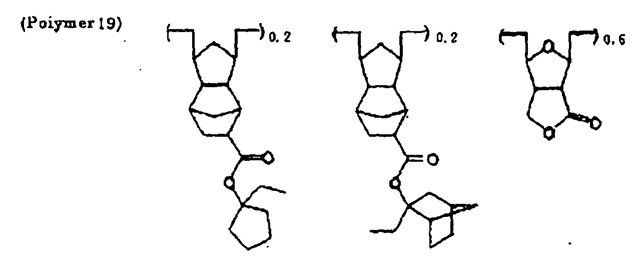

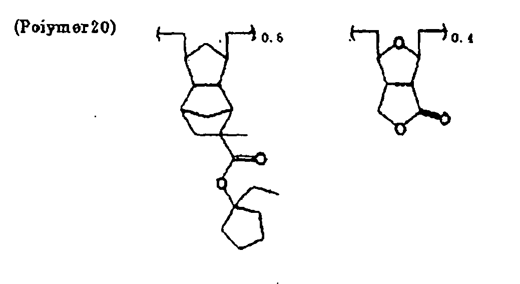

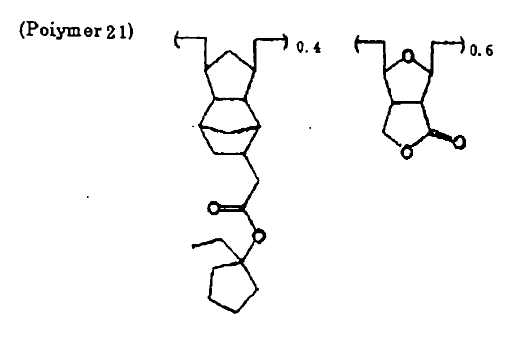

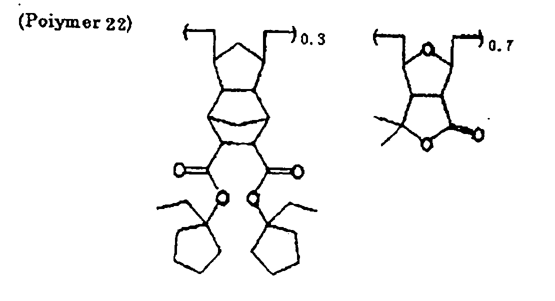

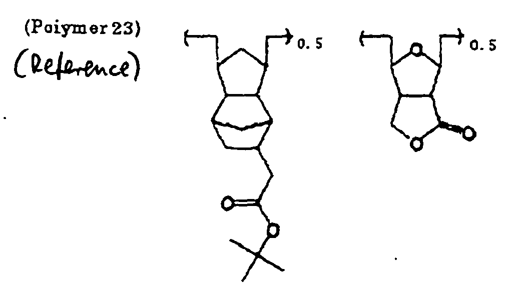

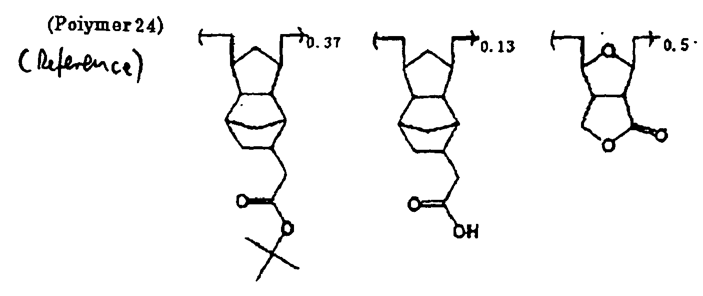

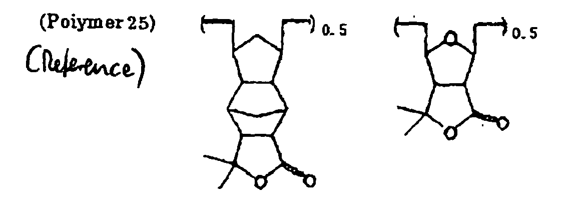

### [Reference Example I]

The resolutions of resist materials of the present invention in exposure to KrF excimer laser were evaluated. [Reference Examples I-1 to 12] Evaluation of resolution of resist

Polymers of the above-described formulae (Polymer 1, 2) were used as a base resin, and acid generators of the following formulae (PAG 1, 2), solution suppressing agents of the following formulae (DRR 1 to 4), basic compound, compounds having a group of ≡C-COOH in the molecule of the following formulae (ACC 1, 2) and solvent were mixed in ratios shown in Table 1. Then, these were filtrated through a Teflon filter (pore diameter: 0.2 µm) to give resist materials.

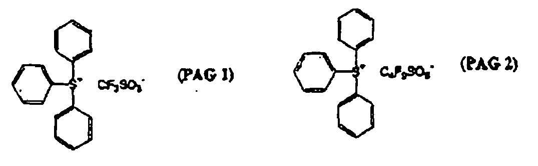

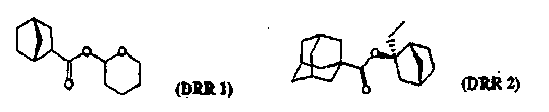

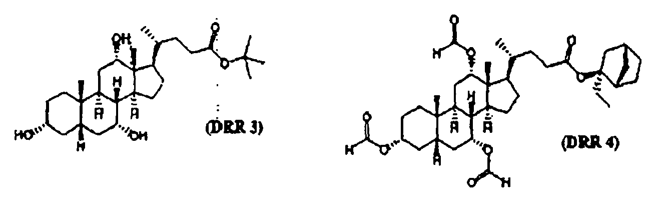

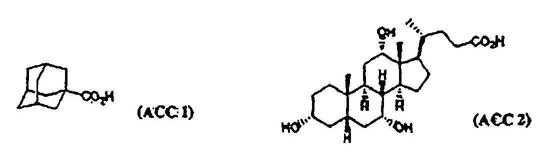

The resist solution was applied by rotation mode on a silicon wafer on which a reflection reducing film (DUV 30 manufactured by Nissan Kagaku K.K., 55 nm) had been applied, and thermal treatment at 130°C for 90 seconds was performed to form a resist film having a thickness of 485 nm. This was exposed by using a KrF excimer laser stepper (manufactured by Nikon Corp., NA=0.5), and thermal treatment at 110°C for 90 seconds was performed, then, paddle development was effected for 60 seconds using an aqueous 2.38% tetramethylammonium hydroxide solution, to form a line and space pattern of 1:1. The developed wafer was cut and the cut section was observed by SEM (scanning electron microscope), and the minimum line width (µm) of line and space separated at the exposure amount (optimum exposure amount = Eop, mJ/cm²) which resolves line and space of 0.30 µm at 1:1 was utilized as the resolution of a resist to be evaluated. Pattern forms in this process were classified into any of rectangle, rounded head, T-top, ordinary taper, and reverse taper.

Compositions and evaluation results of resists are shown in Table 1. In Table 1, solvents and basic compounds are as described below. And, all solvents used contained FC-430 (manufactured by Sumitomo 3-M K.K.) in an amount of 0.05% by weight.

**Table 1**

| Reference Example | Resin | Acid Generator | Solvent Suppressing Agent | Basic Compound | Solvent | Optimum exposure amount | Resolution | Form |
|---|---|---|---|---|---|---|---|---|
| | (part) | (part) | (part) | (part) | (part) | (mJ/cm²) | (µm) | |
| I-1 | Polymer 1 | PAG 1(1) | | TBA | CyHO | 17.0 | 0.24 | Rectangle |
| | (80) | | | (0.078) | (640) | | | |
| I-2 | Polymer 2 | PAG 1(1) | | TBA | CyHO | 18.5 | 0.24 | Rectangle |
| | (80) | | | (0.078) | (640) | | | |
| I-3 | Polymer 1 | PAG 2(1) | | TBA | CyHO | 17.5 | 0.24 | Rectangle |
| | (80) | | | (0.078) | (640) | | | |
| I-4 | Polymer 1 | PAG 2(1) | | TEA | CyHO | 18.0 | 0.22 | Rectangle |
| | (80) | | | (0.063) | (640) | | | |
| I-5 | Polymer 1 | PAG 2(1) | | TMMEA | CyHO | 18.0 | 0.22 | Rectangle |
| | (80) | | | (0.118) | (640) | | | |
| I-6 | Polymer 1 | PAG 2(1) | | TMEMEA | CyHO | 18.5 | 0.22 | Rectangle |
| | (80) | | | (0.173) | (640) | | | |
| I-7 | Polymer 1 | PAG 2(1) | DRR1 | TEA | CyHO | 15.5 | 0.24 | Rectangle |
| | (70) | | (10) | (0.063) | (640) | | | |
| I-8 | Polymer 1 | PAG 2(1) | DRR2 | TEA | CyHO | 16.0 | 0.24 | Rectangle |
| | (70) | | (10) | (0.063) | (640) | | | |
| I-9 | Polymer 1 | PAG 2(1) | DRR3 | TEA | CyHO | 18.5 | 0.24 | Rectangle |
| | (70) | | (10) | (0.063) | (640) | | | |
| I-10 | Polymer 1 | PAG 2(1) | DRR4 | TEA | CyHO | 17.0 | 0.22 | Rectangle |
| | (70) | | (10) | (0.063) | (640) | | | |
| I-11 | Polymer 1 | PAG 2(1) | ACC1 | TEA | CyHO | 16.5 | 0.24 | Rectangle |
| | (80) | | (4) | (0.063) | (640) | | | |
| I-12 | Polymer 1 | PAG 2(1) | ACC2 | TEA | CyHO | 17.0 | 0.24 | Rectangle |
| | (80) | | (4) | (0.063) | (640) | | | |

| | | | | | | | | |
|---|---|---|---|---|---|---|---|---|
| CyHO: cyclohexanone TBA: tributylamine TEA: triethanolamine TMMEA: trismethoxymethoxyethylamine TMEMEA: trismethoxyethoxymethoxyethylamine | | | | | | | | |

From the results in Table 1, it was confirmed that resist materials of the present invention show high sensitivity and high resolution in exposure to KrF excimer laser.

### [Reference Example II]

The resolutions of resist materials of the present invention in exposure to ArF excimer laser were evaluated. [Reference Examples II-1 to 22] Evaluation of resolution of resist

Resist materials having compositions shown in Table 2 were prepared in the same manner as described above.

The resist solution was applied by rotation mode on a silicon wafer on which a reflection reducing film (ARC 25 manufactured by Nissan Kagaku K.K., 77 nm) had been applied, and thermal treatment at 130°C for 90 seconds was performed to form a resist film having a thickness of 375 nm. This was exposed by using a ArF excimer laser stepper (manufactured by Nikon Corp., NA=0.55), and thermal treatment at 110°C for 90 seconds was performed, then, paddle development was effected for 60 seconds using an aqueous 2.38% tetramethylammonium hydroxide solution, to form a line and space pattern of 1:1. The developed wafer was cut and the cut section was observed by SEM (scanning electron microscope), and the minimum line width (µm) of line and space separated at the exposure amount (optimum exposure amount = Eop, mJ/cm²) which resolves line and space of 0.30 µm at 1:1 was utilized as the resolution of a resist to be evaluated. Pattern forms in this process were classified into any of rectangle, rounded head, T-top, ordinary taper, and reverse taper.

Compositions and evaluation results of resists are shown in Table 2. In Table 2, solvents and basic compounds are as described below. And, all solvents used contained FC-430 (manufactured by Sumitomo 3-M K.K.) in an amount of 0.01% by weight.

**Table 2**

| Reference Example | Resin | Acid Generator | Basic Compound | Solvent | Optimum exposure amount | Resolution | Form |
|---|---|---|---|---|---|---|---|
| | (part) | (part) | (part) | (part) | (mJ/cm²) | (µm) | |
| II-1 | Polymer 1 | PAG 2(1) | TMMEA | CyHO | 19.0 | 0.19 | Rectangle |
| | (80) | | (0.236) | (640) | | | |
| II-2 | Polymer 2 | PAG 2(1) | TMMEA | CyHO | 20.0 | 0.18 | Rectangle |
| | (80) | | (0.236) | (640) | | | |
| II-3 | Polymer 3 | PAG 2(1) | TMMEA | CyHO | 24.0 | 0.21 | Rectangle |
| | (80) | | (0.236) | (640) | | | |
| II-4 | Polymer 4 | PAG 2(1) | TMMEA | CyHO | 18.0 | 0.18 | Rectangle |
| | (80) | | (0.236) | (640) | | | |
| II-5 | Polymer 5 | PAG 2(1) | TMMEA | CyHO | 17.0 | 0.18 | Rectangle |
| | (80) | | (0.236) | (640) | | | |
| II-6 | Polymer 6 | PAG 2(1) | TMMEA | CyHO | 15.0 | 0.17 | Rectangle |
| | (80) | | (0.236) | (640) | | | |
| II-7 | Polymer 7 | PAG 2(1) | TMMEA | CyHO | 19.0 | 0.18 | Slightly T-top |
| | (80) | | (0.236) | (640) | | | |
| II-8 | Polymer 8 | PAG 2(1) | TMMEA | CyHO | 16.0 | 0.17 | Rectangle |
| | (80) | | (0.236) | (640) | | | |
| II-9 | Polymer 9 | PAG 2(1) | TMMEA | CyHO | 15.0 | 0.17 | Rectangle |
| | (80) | | (0.236) | (640) | | | |
| II-10 | Polymer 10 | PAG 2(1) | TMMEA | CyHO | 18.0 | 0.17 | Rectangle |
| | (80) | | (0.236) | (640) | | | |
| II-11 | Polymer 11 | PAG 2(1) | TMMEA | CyHO | 20.0 | 0.19 | Rectangle |
| | (80) | | (0.236) | (640) | | | |
| II-12 | Polymer 12 | PAG 2(1) | TMMEA | CyHO | 18.0 | 0.18 | Rectangle |
| | (80) | | (0.236) | (640) | | | |
| II-13 | Polymer 13 | PAG 2(1) | TMMEA | CyHO | 16.0 | 0.17 | Rectangle |
| | (80) | | (0.236) | (640) | | | |
| II-14 | Polymer 14 | PAG 2(1) | TMMEA | CyHO | 14.0 | 0.18 | Slightly Rounded head |
| | (80) | | (0.236) | (640) | | | |
| II-15 | Polymer 15 | PAG 2(1) | TMMEA | CyHO | 13.0 | 0.18 | Slightly Rounded head |
| | (80) | | (0.236) | (640) | | | |
| II-16 | Polymer 16 | PAG 2(1) | TMMEA | CyHO | 14.0 | 0.18 | Rectangle |
| | (80) | | (0.236) | (640) | | | |
| II-17 | Polymer 17 | PAG 2(1) | TMMEA | CyHO | 17.0 | 0.19 | Rectangle |
| | (80) | | (0.236) | (640) | | | |
| II-18 | Polymer 18 | | TMMEA | CyHO | 19.0 | 0.18 | Rectangle |
| | (80) | PAG 2(1) | (0.236) | (640) | | | |
| II-19 | Polymer 19 | PAG 2(1) | TMMEA | CyHO | 17.0 | 0.18 | Rectangle |
| | (80) | | (0.236) | (640) | | | |
| II-20 | Polymer 20 | PAG 2(1) | TMMEA | CyHO | 18.0 | 0.20 | Rectangle |
| | (80) | | (0.236) | (640) | | | |
| II-21 | Polymer 21 | PAG 2(1) | TMMEA | CyHO | 18.0 | 0.20 | Rectangle |
| | (80) | | (0.236) | (640) | | | |
| II-22 | Polymer 22 | PAG 2(1) | TMMEA | CyHO | 17.0 | 0.19 | Rectangle |
| | (80) | | (0.236) | (640) | | | |
| II-23 | Polymer 23 | PAG 2(1) | TMMEA | CyHO | 24.0 | 0.21 | Slightly T-top |
| | (80) | | (0.236) | (640) | | | |
| II-24 | Polymer 24 | PAG 2(1) | TMMEA | CyHO | 23.0 | 0.21 | Sightly T-top |
| | (80) | | (0.236) | (640) | | | |

| | | | | | | | |
|---|---|---|---|---|---|---|---|
| CyHO: cyclohexanone TMMEA: trismethoxymethoxyethylamine | | | | | | | |

From the results in Table 2, it was confirmed that resist materials of the present invention show high sensitivity and high resolution in exposure to ArF excimer laser.

As described above, the hydrogenated ring-opening metathesis polymer and the method of producing the same of the present invention are extremely valuable from the industrial standpoint since they are suitable for a photoresist for fine processing of a semiconductor using ultraviolet ray and far ultraviolet ray, excellent in heat resistance, thermal decomposition resistance and light transmittance.

## Claims

1. A hydrogenated ring-opening metathesis polymer which comprises a structural unit [A] represented by the following general formula [1]: 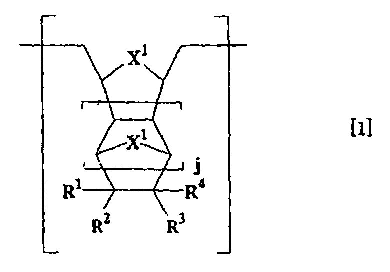 (wherein at least one of R¹ to R⁴ is a functional group having a tertiary ester group of a cyclic alkyl represented by the following general formula [2]: 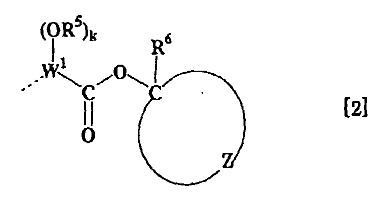 (wherein the dotted line is a bond, R⁵ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; R⁶ is a linear, branched or cyclic alkyl group having 1 to 10 carbon atoms; W¹ is a single bond or a (k+2)-valent hydrocarbon group having 1 to 10 carbon atoms; Z is a divalent hydrocarbon group having 2 to 15 carbon atoms and forms a single ring or a cross-linked ring together with the bonded carbon atoms;
k is 0 or 1; and k is 0 in case W¹ is a single bond);
and the others of R¹ to R⁴ are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms; X¹ is -O- or -CR⁷₂- (R⁷ represents a hydrogen atom or a linear or branched alkyl group having 1 to 10 carbon atoms) and may be the same or different each other; and j is 0 or an integer of 1 to 3);
and at least one member selected from a structural unit [B] represented by the following general formula [3]: 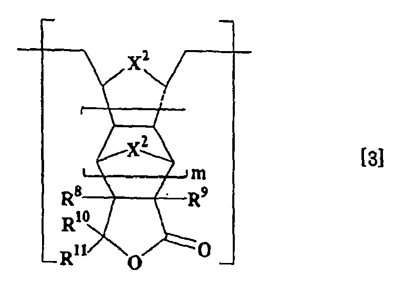 (wherein, R⁸ to R¹¹ are independently a hydrogen atom or a linear, branched or cyclic alkyl group having 1 to 10 carbon atoms; X² is -O- or -CR¹²₂- (R¹² represents a hydrogen atom or a linear or branched alkyl group having 1 to 10 carbon atoms) and may be the same or different each other; and m is 0 or an integer of 1 to 3),
and a structural unit [C] represented by the following general formula [4]: 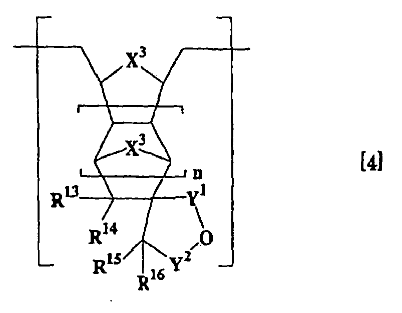 (wherein, R¹³ to R¹⁶ are independently a hydrogen atom or a linear, branched or cyclic alkyl group having 1 to 10 carbon atoms; X³ is -O- or -CR¹⁷₂- (R¹⁷ represents a hydrogen atom or a linear or branched alkyl group having 1 to 10 carbon atoms) and may be the same or different each other; one of Y¹ and Y² is -(C=O)-, and the other of Y¹ and Y² is -CR¹⁸₂- (R¹⁸ represents a hydrogen atom or a linear or branched alkyl group having 1 to 10 carbon atoms); and n is 0 or an integer of 1 to 3);
wherein at least one of X¹ in the structural unit [A] represented by the general formula [1], X² in the structural unit [B] represented by the general formula [3] and X³ in the structural unit [C] represented by the general formula [4] is -O-; and
wherein a constituent molar ratio of [A]/([B] and [C]) is from 20/80 to 99/1 and a ratio of a weight-average molecular weight Mw to a number-average molecular weight Mn, that is Mw/Mn is from 1.0 to 2.0.

2. The hydrogenated ring-opening metathesis polymer according to claim 1, wherein the constituent molar ratio of the structural unit [A] represented by the general formula [1] to the structural unit [B] represented by the general formula [3] and the structural unit [C] represented by the general formula [4], that is [A]/([B] and [C]) is from 25/75 to 90/10.

3. The hydrogenated ring-opening metathesis polymer according to claim 1, wherein the constituent molar ratio of the structural unit [A] represented by the general formula [1] to the structural unit [B] represented by the general formula [3] and the structural unit [C] represented by the general formula [4], that is [A]/([B] and [C]) is from 30/70 to 85/15.

4. The hydrogenated ring-opening metathesis polymer according to claim 1, wherein at least one of X¹ in the structural unit [A] represented by the general formula [1], X² in the structural unit [B] represented by the general formula [3] and X³ in the structural unit [C] represented by the general formula [4] is -O-, and the others represent -CH₂-.

5. The hydrogenated ring-opening metathesis polymer according to claim 1, wherein the functional group having a tertiary ester group of a cyclic alkyl represented by the general formula [2], that is selected as at least one of R¹ to R⁴ in the general formula [1], is a 1-alkylcyclopentyl ester, 1-alkylnorbornyl ester or 2-alkyl-2-adamantyl ester.

6. The hydrogenated ring-opening metathesis polymer according to claim 1, wherein W¹ in the general formula [2] is a single bond.

7. The hydrogenated ring-opening metathesis polymer according to claim 1, which comprises a structural unit [D] represented by the following general formula [5]: 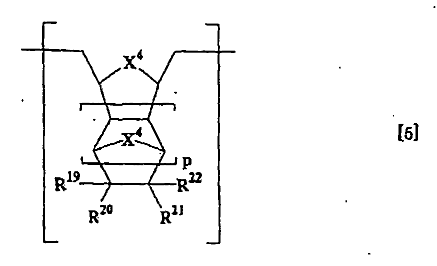 (wherein at least one of R¹⁹ to R²² is a functional group having a carboxyl group represented by the following general formula [6]: 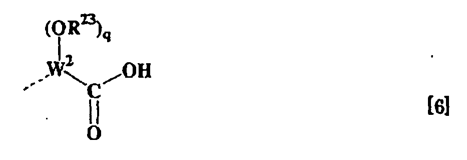 (wherein the dotted line is a bond; R²³ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; W² is a single bond or a (q+2)-valent hydrocarbon group having 1 to 10 carbon atoms; q is 0 or 1; and q is 0 in case W² is a single bond);
and the others of R¹⁹ to R²² are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms; X⁴ is -O- or -CR²⁴₂- (R²⁴ represents a hydrogen atom or a linear or branched alkyl group having 1 to 10 carbon atoms) and may be the same or different each other; p is 0 or an integer of 1 to 3).

8. The hydrogenated ring-opening metathesis polymer according to claim 7, wherein the constituent molar ratio of the structural unit [A] represented by the general formula [1], the structural unit [B] represented by the general formula [3] and the structural unit [C] represented by the general formula [4] to the structural unit [D] represented by the general formula [5], that is ([A]+[B]+[C])/[D] is from 100/0 to 20/80.

9. The hydrogenated ring-opening metathesis polymer according to claim 7, wherein X⁴ in the general formula [5] is -O- or -CH₂-.

10. The hydrogenated ring-opening metathesis polymer according to claim 7, wherein W² in the general formula [6] is a single bond.

11. The hydrogenated ring-opening metathesis polymer according to claim 1, which optionally comprises a structural unit [E] represented by the following general formula [7]: 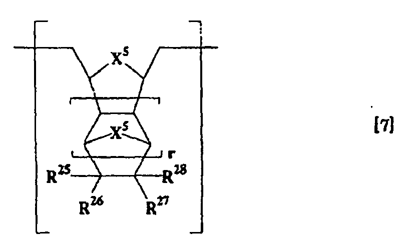 (wherein, at least one of R²⁵ to R²⁸ is a functional group having a carboxylate group represented by the following general formula [8]: 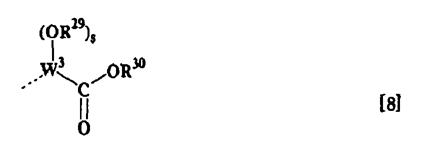 (wherein the dotted line is a bond; R²⁹ is a hydrogen atom, a linear, branched or cyclic alkyl group having 1 to 10 carbon atoms, a linear, branched or cyclic alkoxyalkyl group having 2 to 10 carbon atoms, or a linear, branched or cyclic acyl group having 1 to 10 carbon atoms; R³⁰ is a linear or branched alkyl group having 1 to 10 carbon atoms, a linear, branched or cyclic alkoxyalkyl group having 2 to 10 carbon atoms, or a linear, branched or cyclic halogenated alkyl group having 1 to 20 carbon atoms; W³ is a single bond or a (s+2)-valent hydrocarbon group having 1 to 10 carbon atoms; s is 0 or 1; and s is 0 in case W³ is a single bond);
and the others of R²⁵ to R²⁸ are independently selected from a hydrogen atom, a linear, branched or cyclic alkyl group having 1 to 20 carbon atoms, a halogen, a linear, branched or cyclic halogenated alkyl group having 1 to 20 carbon atoms, a linear, branched or cyclic alkoxy group having 1 to 20 carbon atoms, a linear, branched or cyclic alkoxyalkyl group having 2 to 20 carbon atoms, a linear, branched or cyclic alkylcarbonyloxy group having 2 to 20 carbon atoms, an arylcarbonyloxy group having 6 to 20 carbon atoms, a linear, branched or cyclic alkylsulfonyloxy group having 1 to 20 carbon atoms, an arylsulfonyloxy group having 6 to 20 carbon atoms, a linear, branched or cyclic alkoxycarbonyl group having 2 to 20 carbon atoms, or a linear, branched or cyclic alkoxycarbonylalkyl group having 3 to 20 carbon atoms, X⁵ is -O- or -CR³¹₂- (R³¹ represents a hydrogen atom or a linear or branched alkyl group having 1 to 10 carbon atoms) and may be the same or different each other; and r is 0 or an integer of 1 to 3).

12. The hydrogenated ring-opening metathesis polymer according to claim 11, wherein the constituent molar ratio of the structural unit [A] represented by the general formula [1], the structural unit [B] represented by the general formula [3] and the structural unit [C] represented by the general formula [4] to the structural unit [E] represented by the general formula [7], that is ([A]+[B]+[C])/[E] is from 100/0 to 40/60.

13. The hydrogenated ring-opening metathesis polymer according to claim 11, wherein X⁵ in the general formula [7] is -O- or -CH₂-.

14. The hydrogenated ring-opening metathesis polymer according to claim 11, wherein W³ in the general formula [7] is a single bond.

15. A method of producing the hydrogenated ring-opening metathesis polymer of claim 1, which comprises
using a cyclic olefin monomer represented by the following general formula [9]: 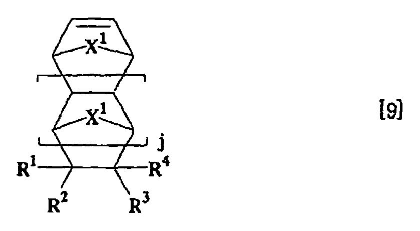 (wherein R¹ to R⁴, X¹ and j are as defined in claim 1), and using at least one member selected from a cyclic olefin monomer represented by the following general formula [10]: 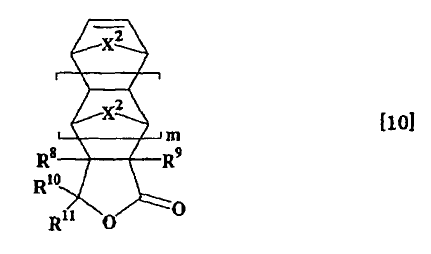 (wherein R⁸ to R¹¹, X² and m are as defined in the general formula [3] in claim 1),
and a cyclic olefin monomer represented by the following general formula [11]: 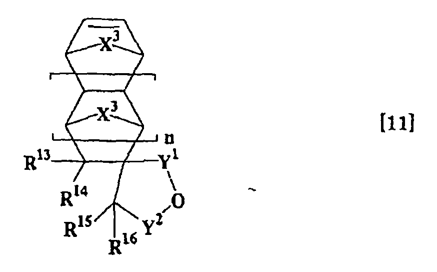 (wherein R¹³ to R¹⁶, X³ , Y¹, Y² and n are as defined in the general formula [4] in claim 1.),
wherein at least one of X¹ in the general formula [9], X² in the general formula [10] and X³ in the general formula [11] is -O-; and
polymerizing these monomers by using a ring-opening metathesis catalyst, and hydrogenating the polymer in the presence of a hydrogenation catalyst,
wherein the charging molar ratio of the cyclic olefin monomer represented by the general formula [9] to the cyclic olefin monomer represented by the general formula [10] and the cyclic olefin monomer represented by the general formula [11] is from 20/80 to 99/1.

16. The method according to claim 15, wherein the charging molar ratio of the cyclic olefin monomer represented by the general formula [9] to the cyclic olefin monomer represented by the general formula [10] and the cyclic olefin monomer represented by the general formula [11] is from 25/75 to 90/10.

17. The method according to claim 15, wherein at least one of X¹ in the cyclic olefin monomer represented by the general formula [9], X² in the cyclic olefin monomer represented by the general formula [10] and X³ in the cyclic olefin monomer represented by the general formula [11] is -O-, and the others represent -CH₂-.

18. The method according to claim 15, wherein the functional group having a tertiary ester group of a cyclic alkyl represented by the general formula [2], that is selected as at least one of R¹ to R⁴ in the general formula [9] is a 1-alkylcyclopentyl ester, 1-alkylnorbornyl ester or 2-alkyl-2-adamantyl ester.

19. The method according to claim 15, wherein after hydrogenation, at least part of the tertiary ester group of the cyclic alkyl in the general formula [2] is decomposed to be a carboxyl group.

20. The method according to claim 15, which comprises further using a cyclic olefin monomer represented by the following general formula [12]: 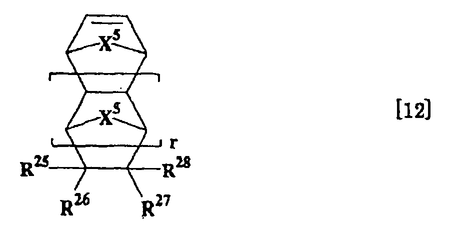 (wherein R²⁵ to R²⁸, X⁵ and r are as defined in the general formula [7] in claim 11).

21. The method according to claim 20, wherein after hydrogenation, at least part of the ester group is decomposed to be a carboxyl group.

22. The method according to claim 15, wherein the ring-opening metathesis catalyst is a living ring-opening metathesis catalyst.

23. The method according to claim 15, wherein polymerization is conducted by using a living ring-opening metathesis catalyst in the presence of an olefin or a diene.

## Patentansprüche

1. Hydriertes Ringöffnungs-Methathese-Polymer, umfassend eine Struktureinheit [A] der folgenden allgemeinen Formel [1]: 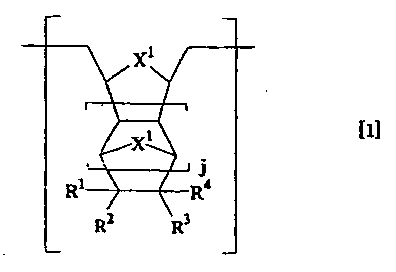 (worin mindestens eines von R¹ bis R⁴ eine funktionale Gruppe mit einer tertiären Estergruppe eines zyklischen Alkyls der folgenden allgemeinen Formel [2] ist: 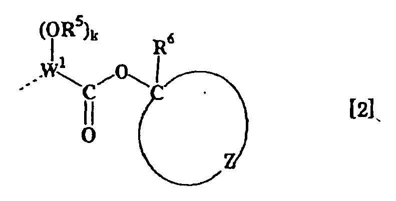 (worin die gestrichelte Linie eine Bindung ist, R⁵ ein Wasserstoffatom, eine lineare, verzweigte oder zyklische Alkylgruppe mit 1 bis 10 Kohlenstoffatomen, eine lineare, verzweigte oder zyklische Alkoxyalkylgruppe mit 2 bis 10 Kohlenstoffatomen oder eine lineare, verzweigte oder zyklische Acylgruppe mit 1 bis 10 Kohlenstoffatomen ist; R⁶ eine lineare, verzweigte oder zyklische Alkylgruppe mit 1 bis 10 Kohlenstoffatomen ist; W¹ eine Einfachbindung oder eine (k+2)-wertige Kohlenwasserstoffgruppe mit 1 bis 10 Kohlenstoffatomen ist; Z eine zweiwertige Kohlenwasserstoffgruppe mit 2 bis 15 Kohlenstoffatomen ist und einen einfachen Ring oder zusammen mit dem gebundenen Kohlenstoffatom einen vernetzten Ring bildet; k 0 oder 1 ist; und k 0 ist, wenn W¹ eine Einfachbindung ist);
und die anderen der R¹ bis R⁴ unabhängig aus einem Wasserstoffatom, einer linearen, verzweigten oder zyklischen Alkylgruppe mit 1 bis 20 Kohlenstoffatomen, einem Halogen, einer linearen, verzweigten oder zyklischen halogenierten Alkylgruppe mit 1 bis 20 Kohlenstoffatomen, einer linearen, verzweigten oder zyklischen Alkoxygruppe mit 1 bis 20 Kohlenstoffatomen, einer linearen, verzweigten oder zyklischen Alkoxyalkylgruppe mit 2 bis 20 Kohlenstoffatomen, einer linearen, verzweigten oder zyklischen Alkylcarbonyloxygruppe mit 2 bis 20 Kohlenstoffatomen, einer Arylcarbonyloxygruppe mit 6 bis 20 Kohlenstoffatomen, einer linearen, verzweigten oder zyklischen Alkylsufonyloxygruppe mit 1 bis 20 Kohlenstoffatomen, einer Arylsulfonyloxygruppe mit 6 bis 20 Kohlenstoffatomen, einer linearen, verzweigten oder zyklischen Alkoxycarbonylgruppe mit 2 bis 20 Kohlenstoffatomen, oder einer linearen, verzweigten oder zyklischen Alkoxcycarbonylalkylgruppe mit 3 bis 20 Kohlenstoffatomen ausgewählt sind; X¹ -O- oder -CR⁷₂- darstellen (R⁷ stellt ein Wasserstoffatom oder eine lineare oder verzweigte Alkylgruppe mit 1 bis 10 Kohlenstoffatomen dar) und gleich oder voneinander verschieden sein können; und j oder eine ganze Zahl von 1 bis 3 ist);
und wenigstens ein Element, ausgewählt aus einer Struktureinheit [B] der folgenden Formel [3]: 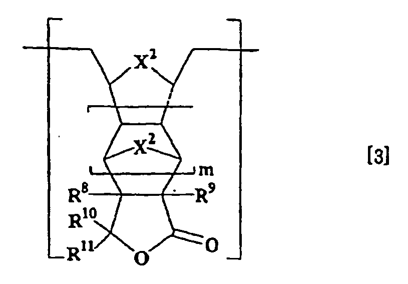 (worin R⁸ bis R¹¹ unabhängig ein Wasserstoffatom oder eine lineare, verzweigte oder zyklische Alkylgruppe mit 1 bis 10 Kohlenstoffatomen sind; X² -O- oder -CR¹²₂- sind (R¹² stellt ein Wasserstoffatom oder eine lineare oder verzweigte Alkylgruppe mit 1 bis 10 Kohlenstoffatomen dar) und gleich oder voneinander verschieden sein können; und m 0 oder eine ganze Zahl von 1 bis 3 ist),
und eine Struktureinheit [C] der folgenden allgemeinen Formel [4]: 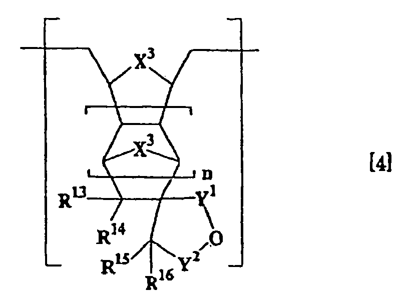 (worin R¹³ bis R¹⁶ unabhängig ein Wasserstoffatom oder eine lineare, verzweigte oder zyklische Alkylgruppe mit 1 bis 10 Kohlenstoffatomen sind; X³ -O- oder -CR¹⁷₂- sind (R¹⁷ stellt ein Wasserstoffatom oder eine lineare oder verzweigte Alkylgruppe mit 1 bis 10 Kohlenstoffatomen dar) und gleich oder voneinander verschieden sein können; eines von Y¹ und Y² -(C=O)- ist und das andere von Y¹ und Y² -CR¹⁸₂- ist (R¹⁸ stellt ein Wasserstoffatom oder eine lineare oder verzweigte Alkylgruppe mit 1 bis 10 Kohlenstoffatomen dar); und n 0 oder eine ganze Zahl von 1 bis 3 ist);
worin mindestens eines von X¹ in der Struktureinheit [A] der allgemeinen Formel [1], X² in der Struktureinheit [B] der allgemeinen Formel [3] sowie X³ in der Struktureinheit [C] der allgemeinen Formel [4] -O- ist; und
worin ein konstituierendes Molverhältnis von [A]/([B] und [C]) von 20/80 bis 99/1 ist, und ein Verhältnis des Gewichtsmittels des Molekulargewichts Mw zu einem Zahlenmittel des Molekulargewichts Mn, d.h. Mw/Mn, von 1,0 bis 2,0 ist.

2. Hydriertes Ringöffnungs-Methathese-Polymer nach Anspruch 1, worin das konstituierende Molverhältnis der Struktureinheit [A] der allgemeinen Formel [1] zur Struktureinheit [B] der allgemeinen Formel [3] und der Struktureinheit [C] der allgemeinen Formel [4], d.h. [A]/([B] und [C]), von 25/75 bis 90/10 ist.

3. Hydriertes Ringöffnungs-Methathese-Polymer nach Anspruch 1, worin das konstituierende Molverhältnis der Struktureinheit [A] der allgemeinen Formel [1] zur Struktureinheit [B] der allgemeinen Formel [3] und der Struktureinheit [C] der allgemeinen Formel [4], d.h. [A]/([B] und [C]), von 30/70 bis 85/15 ist.

4. Hydriertes Ringöffnungs-Methathese-Polymer nach Anspruch 1, worin mindestens eines von X¹ in der Struktureinheit [A] der allgemeinen Formel [1], X² in der Struktureinheit [B] der allgemeinen Formel [3] und X³ in der Struktureinheit [C] der allgemeinen Formel [4] -O- ist, und die anderen -CH₂- darstellen.

5. Hydriertes Ringöffnungs-Methathese-Polymer nach Anspruch 1, worin die funktionale Gruppe mit einer tertiären Estergruppe eines zyklischen Alkyls der allgemeinen Formel [2], die aus mindestens einem von R¹ bis R⁴ in der allgemeinen Formel [1] ausgewählt ist, ein 1-Alkylcyclopentylester, 1-Alkylnorbornylester oder 2-Alkyl-2-adamantylester ist.

6. Hydriertes Ringöffnungs-Methathese-Polymer nach Anspruch 1, worin W¹ in der allgemeinen Formel [2] eine Einfachbindung ist.

7. Hydriertes Ringöffnungs-Methathese-Polymer nach Anspruch 1, welches eine Struktureinheit [D] der folgenden allgemeinen Formel [5] enthält: 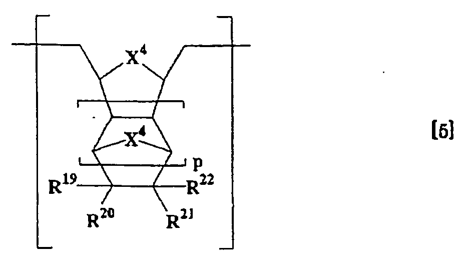 (worin mindestens eines der R¹⁹ bis R²² eine funktionale Gruppe mit einer Carboxylgruppe der folgenden allgemeinen Formel [6] ist: 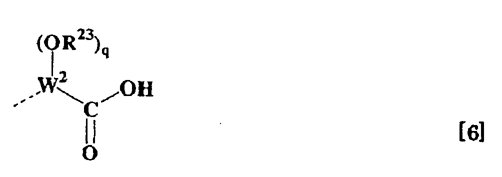 (worin die gestrichelte Linie eine Bindung ist; R²³ ein Wasserstoffatom, eine lineare, verzweigte oder zyklische Alkylgruppe mit 1 bis 10 Kohlenstoffatomen, eine lineare, verzweigte oder zyklische Alkoxyalkylgruppe mit 2 bis 10 Kohlenstoffatomen oder eine lineare, verzweigte oder zyklische Acylgruppe mit 1 bis 10 Kohlenstoffatomen ist; W² eine Einfachbindung oder eine (q+2)-wertige Kohlenwasserstoffgruppe mit 1 bis 10 Kohlenstoffatomen ist; q 0 oder 1 ist; und q 0 ist, wenn W² eine Einfachbindung ist);
und die anderen der R¹⁹ bis R²² unabhängig aus einem Wasserstoffatom, einer linearen, verzweigten oder zyklischen Alkylgruppe mit 1 bis 20 Kohlenstoffatomen, einem Halogen, einer linearen, verzweigten oder zyklischen halogenierten Alkylgruppe mit 1 bis 20 Kohlenstoffatomen, einer linearen, verzweigten oder zyklischen Alkoxygruppe mit 1 bis 20 Kohlenstoffatomen, einer linearen, verzweigten oder zyklischen Alkoxyalkylgruppe mit 2 bis 20 Kohlenstoffatomen, einer linearen, verzweigten oder zyklischen Alkylcarbonyloxygruppe mit 2 bis 20 Kohlenstoffatomen, einer Arylcarbonyloxygruppe mit 6 bis 20 Kohlenstoffatomen, einer linearen, verzweigten oder zyklischen Alkylsulfonyloxygruppe mit 1 bis 20 Kohlenstoffatomen, einer Arylsulfonyloxygruppe mit 6 bis 20 Kohlenstoffatomen, einer linearen, verzweigten oder zyklischen Alkoxycarbonylgruppe mit 2 bis 20 Kohlenstoffatomen oder einer linearen, verzweigten oder zyklischen Alkoxycarbonylalkylgruppe mit 3 bis 20 Kohlenstoffatomen ausgewählt sind; X⁴ -O- oder -CR²⁴₂- darstellen (R²⁴ stellt ein Wasserstoffatom oder eine lineare oder verzweigte Alkylgruppe mit 1 bis 10 Kohlenstoffatomen dar) und gleich oder voneinander verschieden sein können; und p 0 oder eine ganze Zahl von 1 bis 3 ist).

8. Hydriertes Ringöffnungs-Methathese-Polymer nach Anspruch 7, worin das konstituierende Molverhältnis der Struktureinheit [A] der allgemeinen Formel [1], der Struktureinheit [B] der allgemeinen Formel [3] und der Struktureinheit [C] der allgemeinen Formel [4] zur Struktureinheit [D] der allgemeinen Formel [5], d.h. ([A]+[B]+[C])/[D], von 100/0 bis 20/80 ist.

9. Hydriertes Ringöffnungs-Methathese-Polymer nach Anspruch 7, worin X⁴ in der allgemeinen Formel [5] -O- oder -CH₂- ist.

10. Hydriertes Ringöffnungs-Methathese-Polymer nach Anspruch 7, worin W² in der allgemeinen Formel [6] eine Einfachbindung ist.

11. Hydriertes Ringöffnungs-Methathese-Polymer nach Anspruch 1, wahlweise umfassend eine Struktureinheit [E] der folgenden allgemeinen Formel [7]: 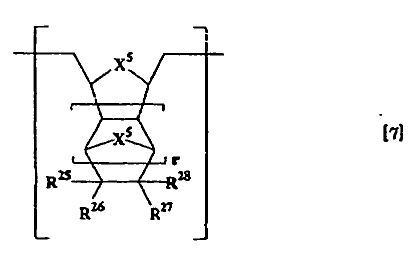 (worin mindestens eines der R²⁵ bis R²⁸ eine funktionale Gruppe mit einer Carboxylatgruppe der folgenden allgemeinen Formel [8] ist: 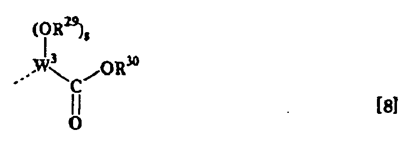 (worin die gestrichelte Linie eine Bindung ist; R²⁹ ein Wasserstoffatom, eine lineare, verzweigte oder zyklische Alkylgruppe mit 1 bis 10 Kohlenstoffatomen, eine lineare, verzweigte oder zyklischen Alkoxyalkylgruppe mit 2 bis 10 Kohlenstoffatomen oder eine lineare, verzweigte oder zyklische Acylgruppe mit 1 bis 10 Kohlenstoffatomen ist; R³⁰ eine lineare oder verzweigte Alkylgruppe mit 1 bis 10 Kohlenstoffatomen, eine lineare, verzweigte oder zyklische Alkoxyalkylgruppe mit 2 bis 10 Kohlenstoffatomen oder eine lineare, verzweigte oder zyklische halogenierte Alkylgruppe mit 1 bis 20 Kohlenstoffatomen ist; W³ eine Einfachbindung oder eine (s+2)-wertige Kohlenwasserstoffgruppe mit 1 bis 10 Kohlenstoffatomen ist; s 0 oder 1 ist; und s 0 ist, wenn W³ eine Einfachbindung ist);
und die anderen der R²⁵ bis R²⁸ unabhängig aus einem Wasserstoffatom, einer linearen, verzweigten oder zyklischen Alkylgruppe mit 1 bis 20 Kohlenstoffatomen, einem Halogen, einer linearen, verzweigten oder zyklischen halogenierten Alkylgruppe mit 1 bis 20 Kohlenstoffatomen, einer linearen, verzweigten oder zyklischen Alkoxygruppe mit 1 bis 20 Kohlenstoffatomen, einer linearen, verzweigten oder zyklischen Alkoxyalkylgruppe mit 2 bis 20 Kohlenstoffatomen, einer linearen, verzweigten oder zyklischen Alkylcarbonyloxygruppe mit 2 bis 20 Kohlenstoffatomen, einer Arylcarbonyloxygruppe mit 6 bis 20 Kohlenstoffatomen, einer linearen, verzweigten oder zyklischen Alkylsulfonyloxygruppe mit 1 bis 20 Kohlenstoffatomen, einer Arylsulfonyloxygruppe mit 6 bis 20 Kohlenstoffatomen, einer linearen, verzweigten oder zyklischen Alkoxycarbonylgruppe mit 2 bis 20 Kohlenstoffatomen, oder einer linearen, verzweigten oder zyklischen Alkoxycarbonylalkylgruppe mit 3 bis 20 Kohlenstoffatomen ausgewählt sind; X⁵ -O- oder -CR³¹₂- darstellen (R³¹ stellt ein Wasserstoffatom oder eine lineare oder verzweigte Alkylgruppe mit 1 bis 10 Kohlenstoffatomen dar) und gleich oder voneinander verschieden sein können; und r 0 oder eine ganze Zahl von 1 bis 3 ist).

12. Hydriertes Ringöffnungs-Methathese-Polymer nach Anspruch 11, worin das konstituierende Molverhältnis der Struktureinheit [A] der allgemeinen Formel [1], der Struktureinheit [B] der allgemeinen Formel [3] und der Struktureinheit [C] der allgemeinen Formel [4] zur Struktureinheit [E] der allgemeinen Formel [7], d.h. ([A]+[B]+[C])/[E], von 100/0 bis 40/60 ist.

13. Hydriertes Ringöffnungs-Methathese-Polymer nach Anspruch 11, worin X⁵ in der allgemeinen Formel [7] -O- oder -CH₂- ist.

14. Hydriertes Ringöffnungs-Methathese-Polymer nach Anspruch 11, worin W³ in der allgemeinen Formel [7] eine Einfachbindung ist.

15. Verfahren zur Herstellung eines hydrierten Ringöffnungs-Methathese-Polymers nach Anspruch 1, umfassend:
Verwenden eines zyklischen Olefinmonomers der folgenden allgemeinen Formel [9]: 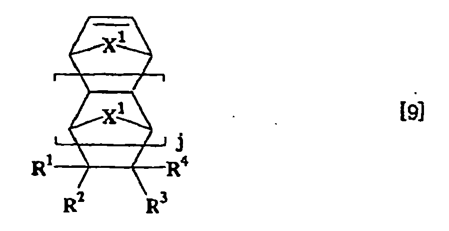 (worin R¹ bis R⁴, X¹ und j wie in Anspruch 1 definiert sind),
und Verwenden mindestens eines Elements, ausgewählt aus einem zyklischen Olefinmonomer der folgenden allgemeinen Formel [10]: 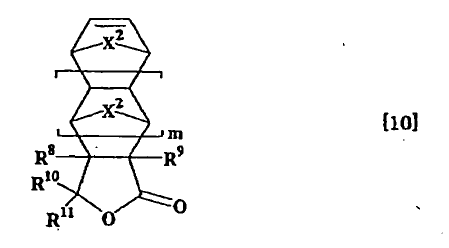 (worin R⁸ bis R¹¹, X² und m wie in der allgemeinen Formel [3] in Anspruch 1 definiert sind),
und einem zyklischen Olefinmonomer der folgenden allgemeinen Formel [11]: 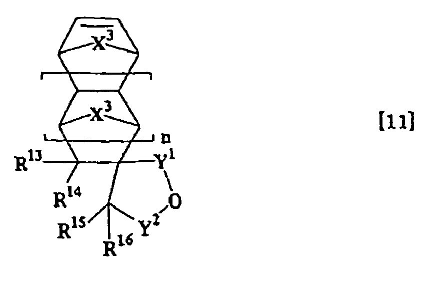 (worin R¹³ bis R¹⁶, X³, Y¹, Y² und n wie in der allgemeinen Formel [4] in Anspruch 1 definiert sind),
worin mindestens eines von X¹ in der allgemeinen Formel [9], X² in der allgemeinen Formel [10] und X³ in der allgemeinen Formel [11] -O- ist; und
Polymerisieren dieser Monomere unter Verwendung eines Ringöffnungs-Methathese-Katalysators und Hydrieren des Polymers in Gegenwart eines Hydrierungskatalysators,
worin das Beschickungsmolverhältnis des zyklischen Olefinmonomers der allgemeinen Formel [9] zum zyklischen Olefinmonomer der allgemeinen Formel [10] und dem zyklischen Olefinmonomer der allgemeinen Formel [11] von 20/80 bis 99/1 ist.

16. Verfahren nach Anspruch 15, worin das Beschickungsmolverhältnis des zyklischen Olefinmonomers der allgemeinen Formel [9] zum zyklischen Olefinmonomer der allgemeinen Formel [10] und dem zyklischen Olefinmonomer der allgemeinen Formel [11] von 25/75 bis 90/10 ist.

17. Verfahren nach Anspruch 15, worin mindestens eines von X¹ in dem zyklischen Olefinmonomer der allgemeinen Formel [9], X² in dem zyklischen Olefinmonomer der allgemeinen Formel [10] und X³ in dem zyklischen Olefinmonomer der allgemeinen Formel [11] -O- ist, und die anderen -CH₂- darstellen.

18. Verfahren nach Anspruch 15, worin die funktionale Gruppe mit einer tertiären Estergruppe eines zyklischen Alkyls der allgemeinen Formel [2], die aus mindestens einem von R¹ bis R⁴ in der allgemeinen Formel [9] ausgewählt ist, ein 1-Alkylcyclopentylester, 1-Alkylnorbornylester oder 2-Alkyl-2-adamantylester ist.

19. Verfahren nach Anspruch 15, worin nach dem Hydrieren zumindest ein Teil der tertiären Estergruppe des zyklischen Alkyls in der allgemeinen Formel [2] zu einer Carboxylgruppe zersetzt wird.

20. Verfahren nach Anspruch 15, umfassend weiterhin die Verwendung eines zyklischen Olefinmonomers der folgenden allgemeinen Formel [12]: 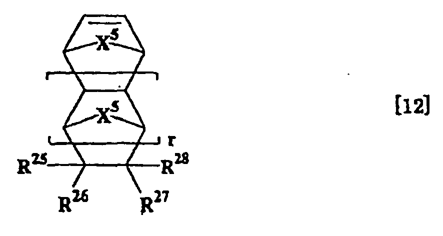 (worin R²⁵ bis R²⁸, X⁵ und r wie in der allgemeinen Formel [7] in Anspruch 11 definiert sind).

21. Verfahren nach Anspruch 20, worin nach dem Hydrieren zumindest ein Teil der Estergruppe zu einer Carboxylgruppe zersetzt wird.

22. Verfahren nach Anspruch 15, worin der Ringöffnungs-Methathese-Katalysator ein lebender Ringöffnungs-Methathese-Katalysator ist.

23. Verfahren nach Anspruch 15, worin die Polymerisation unter Verwendung eines lebenden Ringöffnungs-Methathese-Katalysators in Gegenwart eines Olefins oder eines Diens durchgeführt wird.

## Revendications

1. Polymère hydrogéné préparé par ouverture de cycle par métathèse comprenant un élément structurel [A] représenté par la formule générale suivante [1] : 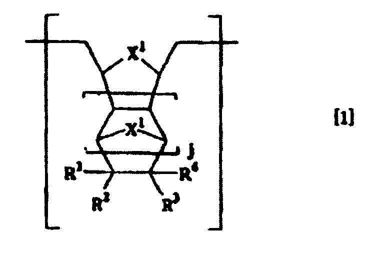 (dans laquelle au moins un parmi R¹ à R⁴ est un groupe fonctionnel ayant un groupe ester tertiaire d'un alkyle cyclique représenté par la formule générale suivante [2] : 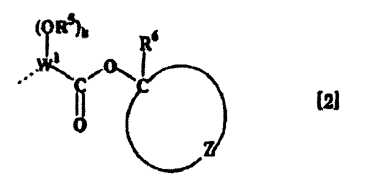 (dans laquelle la ligne pointillée est une liaison, R⁵ est un atome d'hydrogène, un groupe alkyle linéaire, ramifié ou cyclique ayant de 1 à 10 atomes de carbone, un group alkoxyalkyle linéaire, ramifié ou cyclique ayant de 2 à 10 atomes de carbone, ou un groupe acyle linéaire, ramifié ou cyclique ayant de 1 à 10 atomes de carbone ; R⁶ est un groupe alkyle linéaire, ramifié ou cyclique ayant de 1 à 10 atomes de carbone ; W¹ est une liaison simple ou un groupe hydrocarbure (k+2)-valent ayant de 1 à 10 atomes de carbone ; Z est un groupe hydrocarbure divalent ayant de 2 à 15 atomes de carbone et constitue un cycle simple ou un cycle réticulé avec les atomes de carbone liés ;
k est 0 ou 1 ; et k est 0 dans le cas dans lequel W¹ est une liaison simple) ;
et les autres parmi R¹ à R⁴ sont indépendamment choisis parmi un atome d'hydrogène, un groupe alkyle linéaire, ramifié ou cyclique ayant de 1 à 20 atomes de carbone, un groupe halogène, un groupe alkyle halogéné linéaire, ramifié ou cyclique ayant de 1 à 20 atomes de carbone, un groupe alkoxy linéaire, ramifié ou cyclique ayant de 1 à 20 atomes de carbone, un groupe alkoxyalkyle linéaire, ramifié ou cyclique ayant de 2 à 20 atomes de carbone, un groupe alkylcarbonyloxy linéaire, ramifié ou cyclique ayant de 2 à 20 atomes de carbone, un groupe arylcarbonyloxy ayant de 6 à 20 atomes de carbone, un groupe alkylsulfonyloxy linéaire, ramifié ou cyclique ayant de 1 à 20 atomes de carbone, un groupe arylsulfonyloxy ayant de 6 à 20 atomes de carbone, un groupe alkoxycarbonyle linéaire, ramifié ou cyclique ayant de 2 à 20 atomes de carbone, ou un groupe alkoxycarbonylalkyle linéaire, ramifié ou cyclique ayant de 3 à 20 atomes de carbone ; X¹ est -O- ou -CR⁷₂- (R⁷ représente un atome d'hydrogène ou un groupe alkyle linéaire ou ramifié ayant de 1 à 10 atomes de carbone) et peuvent être différents l'un de l'autre ; et j est 0 ou un nombre entier de 1 à 3);
et au moins un élément choisi parmi un élément structurel [B] représenté par la formule générale suivante [3] : 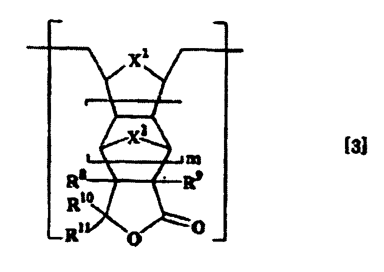 (dans laquelle, R⁸ à R¹¹ sont indépendamment un atome d'hydrogène ou un groupe alkyle linéaire, ramifié ou cyclique ayant de 1 à 10 atomes de carbone ; X² est -O- ou -CR¹²₂- (R¹² représente un atome d'hydrogène ou un groupe alkyle linéaire ou ramifié ayant de 1 à 10 atomes de carbone) et peuvent être différents l'un de l'autre ; et m est 0 ou un nombre entier de 1 à 3),
et un élément structurel [C] représentée par la formule générale suivante [4] : 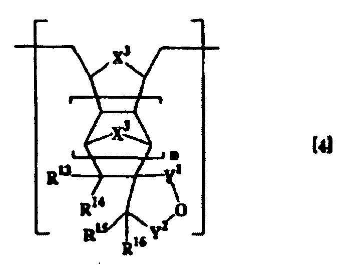 (dans laquelle, R¹³ à R¹⁶ sont indépendamment un atome d'hydrogène ou un groupe alkyle linéaire, ramifié ou cyclique ayant de 1 à 10 atomes de carbone ; X³ est -O- ou -CR¹⁷₂- (R¹⁷ représente un atome d'hydrogène ou un groupe alkyle linéaire ou ramifié ayant de 1 à 10 atomes de carbone) et peuvent être différents l'un de l'autre ; un parmi Y¹ et Y² est -(C=O)-, et l'autre parmi Y¹ et Y² est -CR¹⁸₂- (R¹⁸ représente un atome d'hydrogène ou un groupe alkyle linéaire ou ramifié ayant de 1 à 10 atomes de carbone) ; et n est 0 ou un nombre entier de 1 à 3) ;
dans laquelle au moins un parmi X¹ dans l'élément structurel [A] représenté par la formule générale [1], X² dans l'élément structurel [B] représenté par la formule générale [3] et X³ dans l'élément structurel [C] représenté par la formule générale [4] est. -O- ; et
dans lequel un rapport molaire constitutif de [A]/([B] et [C]) va de 20/80 à 99/1 et un rapport d'une masse moléculaire moyenne en poids Mw par rapport à une masse moléculaire moyenne en nombre Mn, qui est Mw/Mn va de 1,0 à 2,0.

2. Polymère hydrogéné préparé par ouverture de cycle par métathèse selon la revendication 1, dans lequel le rapport molaire constitutif de l'élément structurel [A] représenté par la formule générale [1] par rapport à l'élément structurel [B] représenté par la formule générale [3] et l'élément structurel [C] représenté par la formule générale [4], qui est [A]/([B] et [C]) va de 25/75 à 90/10.

3. Polymère hydrogéné préparé par ouverture de cycle par métathèse selon la revendication 1, dans lequel le rapport molaire constitutif de l'élément structurel [A] représenté par la formule générale [1] par rapport à l'élément structurel [B] représenté par la formule générale [3] et l'élément structurel [C] représenté par la formule générale [4], qui est [A]/([B] et [C]) va de 30/70 à 85/15.

4. Polymère hydrogéné préparé par ouverture de cycle par métathèse selon la revendication 1, dans lequel au moins un parmi X¹ dans l'élément structurel [A] représenté par la formule générale [1] ; X² dans l'élément structurel [B] représenté par la formule générale [3] et X³ dans l'élément structurel [C] représenté par la formule générale [4] est -O-, et les autres représentent -CH₂-.

5. Polymère hydrogéné préparé par ouverture de cycle par métathèse selon la revendication 1, dans lequel le groupe fonctionnel ayant un groupe ester tertiaire d'un alkyle cyclique représenté par la formule générale [2], qui est choisi en tant qu'au moins un parmi R¹ à R⁴ dans la formule générale [1], est un ester 1-alkylcyclopentyle, un ester 1- alkylnorbomyle ou un ester 2-alkyl-2-adamantyle.

6. Polymère hydrogéné préparé par ouverture de cycle par métathèse selon la revendication 1, dans lequel W¹ dans la formule générale [2] est une liaison simple.

7. Polymère hydrogéné préparé par ouverture de cycle par métathèse selon la revendication 1, comprenant un élément structurel [D] représenté par la formule générale suivante [5] : 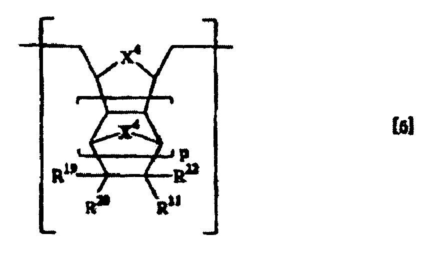 (dans laquelle au moins un parmi R¹⁹ à R²² est un groupe fonctionnel ayant un groupe carboxyle représenté par la formule générale suivante (6) : 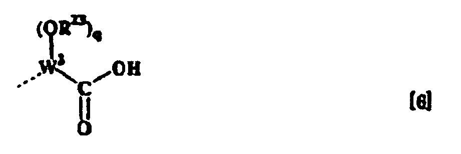 (dans laquelle la ligne pointillée est une liaison ; R²³ est un atome d'hydrogène, un groupe alkyle linéaire, ramifié ou cyclique ayant de 1 à 10 atomes de carbone, un groupe alkoxyalkyle linéaire, ramifié ou cyclique ayant de 2 à 10 atomes de carbone, ou un groupe acyle linéaire, ramifié ou cyclique ayant de 1 à 10 atomes de carbone ; W² est une liaison simple ou un groupe hydrocarbure (q+2)-valent ayant de 1 à 10 atomes de carbone ; q est 0 ou 1 ; et q est 0 dans le cas dans lequel W² est une liaison simple) ;
et les autres parmi R¹⁹ à R²² sont indépendamment choisis parmi un atome d'hydrogène, un groupe alkyle linéaire, ramifié ou cyclique ayant de 1 à 20 atomes de carbone, un groupe halogène, un groupe alkyle halogéné linéaire, ramifié ou cyclique ayant de 1 à 20 atomes de carbone, un groupe alkoxy linéaire, ramifié ou cyclique ayant de 1 à 20 atomes de carbone, un groupe alkoxyalkyle linéaire, ramifié ou cyclique ayant de 2 à 20 atomes de carbone, un groupe alkylcarbonyloxy linéaire, ramifié ou cyclique ayant de 2 à 20 atomes de carbone, un groupe arylcarbonyloxy ayant de 6 à 20 atomes de carbone, un groupe alkylsulfonyloxy linéaire, ramifié ou cyclique ayant de 1 à 20 atomes de carbone, un groupe arylsulfonyloxy ayant de 6 à 20 atomes de carbone, un groupe alkoxycarbonyle linéaire, ramifié ou cyclique ayant de 2 à 20 atomes de carbone, ou un groupe alkoxycarbonylalkyle linéaire, ramifié ou cyclique ayant de 3 à 20 atomes de carbone ; X⁴ est -O- ou -CR²⁴₂- (R²⁴ représente un atome d'hydrogène ou un groupe alkyle linéaire ou ramifié ayant de 1 à 10 atomes de carbone) et peuvent être différents l'un de l'autre ; p est 0 ou un nombre entier de 1 à 3).

8. Polymère hydrogéné préparé par ouverture de cycle par métathèse selon la revendication 7, dans lequel le rapport molaire constitutif de l'élément structurel [A] représenté par la formule générale [1], l'élément structurel [B] représenté par la formule générale [3] et l'élément structurel [C] représenté par la formule générale [4] par rapport à l'élément structurel [D] représenté par la formule générale [5], qui est ([A]+[B]+[C])/[D] va de 100/0 à 20/80.

9. Polymère hydrogéné préparé par ouverture de cycle par métathèse selon la revendication 7, dans lequel X⁴ dans la formule générale [5] est -O- ou -CH₂-.

10. Polymère hydrogéné préparé par ouverture de cycle par métathèse selon la revendication 7, dans lequel W² dans la formule générale [6] est une liaison simple.

11. Polymère hydrogéné préparé par ouverture de cycle par métathèse selon la revendication 1, comprenant facultativement un élément structurel [E] représenté par la formule générale suivante [7] : 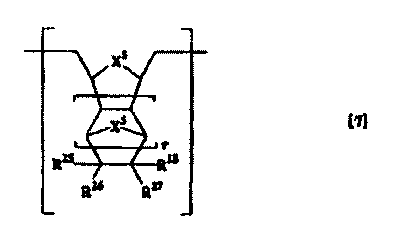 (dans laquelle au moins un parmi R²⁵ à R²⁸ est un groupe fonctionnel ayant un groupe carboxylate représenté par la formule générale suivante [8] : 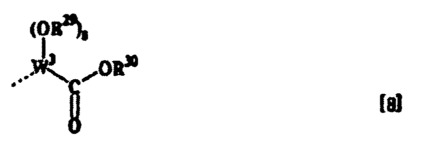 (dans laquelle la ligne pointillée est une liaison ; R²⁹ est un atome d'hydrogène, un groupe alkyle linéaire, ramifié ou cyclique ayant de 1 à 10 atomes de carbone, un groupe alkoxyalkyle linéaire, ramifié ou cyclique ayant de 2 à 10 atomes de carbone, ou un groupe acyle linéaire, ramifié ou cyclique ayant de 1 à 10 atomes de carbone ; R³⁰ est un groupe alkyle linéaire ou ramifié ayant de 1 à 10 atomes de carbone, un groupe alkoxyalkyle linéaire, ramifié ou cyclique ayant de 2 à 10 atomes de carbone, ou un groupe alkyle halogéné linéaire, ramifié ou cyclique ayant de 1 à 20 atomes de carbone ; W³ est une liaison simple ou un groupe hydrocarbure (s+2)-valent ayant de 1 à 10 atomes de carbone ; s est 0 ou 1 ; et s est 0 dans le cas dans lequel W³ est une liaison simple) ;
et les autres parmi R²⁵ à R²⁸ sont indépendamment choisis parmi un atome d'hydrogène, un groupe alkyle linéaire, ramifié ou cyclique ayant de 1 à 20 atomes de carbone, un groupe halogène, un groupe alkyle halogéné linéaire, ramifié ou cyclique ayant de 1 à 20 atomes de carbone, un groupe alkoxy linéaire, ramifié ou cyclique ayant de 1 à 20 atomes de carbone, un groupe alkoxyalkyle linéaire, ramifié ou cyclique ayant de 2 à 20 atomes de carbone, un groupe alkylcarbonyloxy linéaire, ramifié ou cyclique ayant de 2 à 20 atomes de carbone, un groupe arylcarbonyloxy ayant de 6 à 20 atomes de carbone, un groupe alkylsulfonyloxy linéaire, ramifié ou cyclique ayant de 1 à 20 atomes de carbone, un groupe arylsulfonyloxy ayant de 6 à 20 atomes de carbone, un groupe alkoxycarbonyle linéaire, ramifié ou cyclique ayant de 2 à 20 atomes de carbone, ou un groupe alkoxycarbonylalkyle linéaire, ramifié ou cyclique ayant de 3 à 20 atomes de carbone, X⁵ est -O- ou -CR³¹₂- (R³¹ représente un atome d'hydrogène ou un groupe alkyle linéaire ou ramifié ayant de 1 à 10 atomes de carbone) et peuvent être différents l'un de l'autre ; et r est 0 ou un nombre entier de 1 à 3).

12. Polymère hydrogéné préparé par ouverture de cycle par métathèse selon la revendication 11, dans lequel le rapport molaire constitutif de l'élément structurel [A] représenté par la formule générale [1], l'élément structurel [B] représenté par la formule générale [3] et l'élément structurel [C] représenté par la formule générale [4] par rapport à l'élément structurel [E] représenté par la formule générale [7], qui est ([A]+[B]+[C])/[E] va de 100/0 à 40/60.

13. Polymère hydrogéné préparé par ouverture de cycle par métathèse selon la revendication 11, dans lequel X⁵ dans la formule générale [7] est -O- ou -CH₂-.

14. Polymère hydrogéné préparé par ouverture de cycle par métathèse selon la revendication 11, dans lequel W³ dans la formule générale [7] est une liaison simple.

15. Procédé de production du polymère hydrogéné préparé par ouverture de cycle par métathèse de la revendication 1, qui comprend
l'utilisation d'un monomère d'oléfine cyclique représenté par la formule générale suivante [9] : 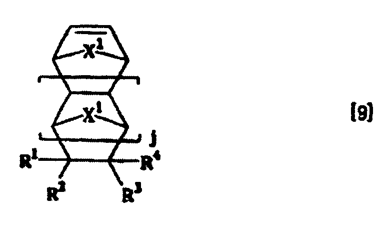 (dans laquelle R¹ à R⁴, X¹ et j sont tels que définis dans la revendication 1),
et l'utilisation d'au moins un élément choisi parmi un monomère d'oléfine cyclique représenté par la formule générale suivante [10] : 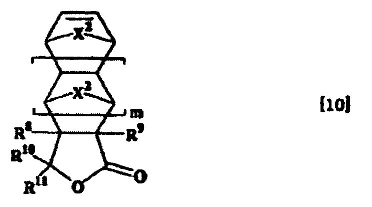 (dans laquelle R⁸ à R¹¹, X² et m sont tels que définis dans la formule générale [3] dans la revendication 1),
et un monomère d'oléfine cyclique représenté par la formule générale suivante [11] : 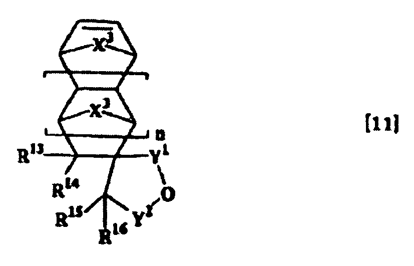 (dans laquelle R¹³ à R¹⁶, X³, Y¹, Y² et n sont tels que définis dans la formule générale [4] dans la revendication 1),
dans lequel au moins un parmi X¹ dans la formule générale [9], X² dans la formule générale [10] et X³ dans la formule générale [11] est -O- ; et
la polymérisation de ces monomères en employant un catalyseur d'ouverture de cycle par métathèse, et l'hydrogénation du polymère en présence d'un catalyseur d'hydrogénation,
dans lequel le rapport molaire de charge du monomère d'oléfine cyclique représenté par la formule générale [9] par rapport au monomère d'oléfine cyclique représenté par la formule générale [10] et au monomère d'oléfine cyclique représenté par la formule générale [11] va de 20/80 à 99/1.

16. Procédé selon la revendication 15, dans lequel le rapport molaire initial du monomère d'oléfine cyclique représenté par la formule générale [9] par rapport au monomère d'oléfine cyclique représenté par la formule générale [10] et au monomère d'oléfine cyclique représenté par la formule générale [11] va de 25/75 à 90/10.

17. Procédé selon la revendication 15, dans lequel au moins un parmi X¹ dans le monomère d'oléfine cyclique représenté par la formule générale [9], X² dans le monomère d'oléfine cyclique représenté par la formule générale [10] et X³ dans le monomère d'oléfine cyclique représenté par la formule générale [11] est -O-, et les autres représentent -CH₂-.

18. Procédé selon la revendication 15, dans lequel le groupe fonctionnel ayant un groupe ester tertiaire d'un alkyle cyclique représenté par la formule générale [2], qui est choisi en tant qu'au moins un parmi R¹ à R⁴ dans la formule générale [9] est un ester de 1-alkylcyclopentyle, un ester de 1-alkylnorbornyle ou un ester de 2-alkyl-2-adamantyle.

19. Procédé selon la revendication 15, dans lequel après l'hydrogénation, au moins une partie du groupe ester tertiaire de l'alkyle cyclique dans la formule générale [2] se décompose en un groupe carboxyle.

20. Procédé selon la revendication 15, comprenant en outre l'utilisation d'un monomère d'oléfine cyclique représenté par la formule générale suivante [12] : 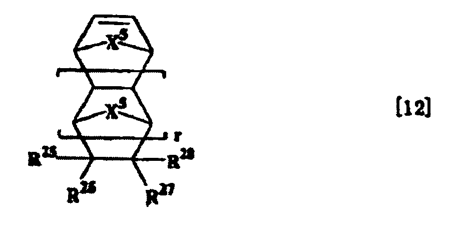 (dans laquelle R²⁵ à R²⁸, X⁵ et r sont tels que définis dans la formule générale [7] dans la revendication 11).

21. Procédé selon la revendication 20, dans lequel après l'hydrogénation, au moins une partie du groupe ester se décompose en un groupe carboxyle.

22. Procédé selon la revendication 15, dans lequel le catalyseur d'ouverture de cycle par métathèse est un catalyseur vivant d'ouverture de cycle par métathèse.

23. Procédé selon la revendication 15, dans lequel la polymérisation est mise en oeuvre en employant un catalyseur de métathèse à ouverture de cycle vivant en présence d'une oléfine ou d'un diène.
